# EUROPÄISCHE PATENTSCHRIFT

(11) **EP 3 859 795 B1**
(45) Veröffentlichungstag und Bekanntmachung des Hinweises auf die Patenterteilung: **18.03.2026**
(21) Anmeldenummer: 20153986.3
(22) Anmeldetag: 28.01.2020
(51) Int. Cl.: H02S 20/26, H10F 19/80, H10F 77/00, H10F 77/42, H10F 77/70

(54) **FARBIGES PLATTENFÖRMIGES BAUTEIL MIT STRUKTURIERTER DECKPLATTE UND FARBFILTERSCHICHT**
COLOURED PLATE-SHAPED COMPONENT WITH STRUCTURED COVER PLATE AND COLOUR FILTER LAYER
COMPOSANT COLORÉ TABULAIRE POURVU DE PLAQUE DE RECOUVREMENT STRUCTURÉE ET COUCHE DE FILTRE CHROMATIQUE

(43) Veröffentlichungstag der Anmeldung: 04.08.2021
(73) Patentinhaber: CNBM RESEARCH INSTITUTE FOR ADVANCED GLASS MATERIALS GROUP CO., LTD., Bengbu, Anhui 233010 (CN)
(72) Erfinder: Palm, Jörg, 80797 München (DE); Ring, Sven, 10247 Berlin (DE); Kegel, Jan, 04425 Taucha (DE); Kalio, René, 04357 Leipzig (DE); Dias, Manuel, 65183 Wiesbaden (DE)
(74) Vertreter: Santarelli

(56) Entgegenhaltungen:
- EP-A1- 3 599 318
- EP-A1- 3 599 647
- EP-A1- 3 599 649
- US-A1- 2017 033 250
- US-A1- 2018 337 629
- US-A1- 2019 081 588
- US-A1- 2019 386 607
- BENEDIKT BL�SI ET AL: "Morpho Butterfly Inspired Coloured BIPV Modules", PROCEEDINGS OF THE 33RD EUROPEAN PHOTOVOLTAIC SOLAR ENERGY CONFERENCE, 25 September 2017 (2017-09-25) - 29 September 2017 (2017-09-29), pages 2630 - 2634, XP040698570, ISBN: 978-3-936338-47-8
- S PELISSET ET AL: "EFFICIENCY OF SILICON THIN-FILM PHOTOVOLTAIC MODULES WITH A FRONT COLOURED GLASS", PROCEEDINGS CISBAT 2011, 2011, pages 37 - 42, XP055049695
- INGENITO ANDREA ET AL: "Phosphorous-Doped Silicon Carbide as Front-Side Full-Area Passivating Contact for Double-Side Contacted c-Si Solar Cells", IEEE JOURNAL OF PHOTOVOLTAICS, I E E E, US, vol. 9, no. 2, 18 February 2019 (2019-02-18), pages 346 - 354, XP011710465, ISSN: 2156-3381, [retrieved on 20190216], DOI: 10.1109/JPHOTOV.2018.2886234
- HICHAM CHARIFI ET AL: "Opto-Structural Properties of Silicon Nitride Thin Films Deposited by ECR-PECVD", WORLD JOURNAL OF CONDENSED MATTER PHYSICS, vol. 06, no. 01, 30 December 2015 (2015-12-30), pages 7 - 16, XP055723459, ISSN: 2160-6919, DOI: 10.4236/wjcmp.2016.61002
- VILLA SIMONA: "Colored PV modules based on Interference Filters", MASTER THESIS, 16 November 2018 (2018-11-16), pages 1 - 87, XP055788980, Retrieved from the Internet <URL:http://resolver.tudelft.nl/uuid:3a1c078d-f9e0-4817-8758-a0b56a14bf18> [retrieved on 20210323]

## Beschreibung

Die vorliegende Erfindung liegt auf den technischen Gebieten der Fassadenfertigung und Solarmodulherstellung und betrifft ein farbiges plattenförmiges Bauteil mit einer strukturierten Deckplatte und mindestens einer Farbfilterschicht. Das plattenförmige Bauteil ist insbesondere in Form eines Solarmoduls oder eines Fassadenelements ausgebildet.

Die Verwendung von Solarmodulen als Wand- bzw. Fassadenelemente ist derzeit ein wirtschaftlich noch relativ geringer, jedoch ökologisch sehr interessanter Markt. Insbesondere angesichts verstärkter Bemühungen für dezentrale Energielösungen und energieneutrale Gebäude wächst der Bedarf für die Anwendung von Solarmodulen als integrierte Bestandteile von Gebäudehüllen. Dazu zählt die Anwendung für Dächer (integriert oder aufgesetzt) und Fassaden. Weitere interessante Anwendungsbereiche für Solarmodule sind Lärmschutzwände (Straße, Schiene), Sichtschutzwände im Außenbereich oder Wände für Gewächshäuser oder Abdeckungen zur architetkonsichen Gestaltung von Brücken oder Türmen. Denkbar wäre sogar die Anwendung von farbigen Solarmodulen in Freiflächenanlagen, wenn aus Gründen des Landschaftsschutzes oder spzieller Kundenanforderungen normale blau-schwarze Solarmodule nicht erwünscht sind. Diese neuen Anwendungen stellen völlig neue Anforderungen an Solarmodule, insbesondere im Hinblick auf Ästhetik, Lebensdauer und weitere Funktionalitäten wie Abdichtung und Wärmeisolation. Insbesondere müssen die hierfür eingesetzten Solarmodule in verschiedenen Formen, Größen und Farben zur Verfügung stehen und einen möglichst homogenen Farbeindruck vermitteln. Je nach Ursprung der Farbe (Absorption/Remission, Interferenz, Brechung) kann die Farbe einer an sich homogenen Oberfläche des Solarmoduls vom Betrachtungs- und/oder Einstrahlwinkel abhängen. Darüber hinaus bestimmen auch das Spektrum und die räumliche Verteilung (diffus, gerichtet) des Lichts den Farbeindruck.

Ein ideales Solarmodul wäre hinsichtlich Wirkungsgradoptimierung ein schwarzer Körper, der das auftreffende Sonnenlicht vollständig absorbiert, um die Strahlungsenergie optimal in elektrische Energie umzuwandeln. Jedoch wird von jedem realen Körper auftreffende Strahlung reflektiert und absorbierte Strahlung remittiert, wobei der Farbeindruck im menschlichen Auge grundsätzlich aus der spektral selektierten Reflexion und der Remission von Licht entsteht. Das Sonnenspektrum hat im sichtbaren Spektralbereich die höchste Energieintensität und das menschliche Auge die größte Empfindlichkeit. Wird ein Solarmodul farbig gestaltet, d.h. soll im menschlichen Auge ein Farbeindruck des Solarmoduls erzeugt werden, der vom idealen schwarzen Körper verschieden ist, reduziert man zwingend die Intensität des im fotovoltaisch aktiven Halbleiter absorbierten Lichts und damit auch die elektrische Leistung bzw. den Wirkungsgrad des Solarmoduls. Ein optimaler Wirkungsgrad kann grundsätzlich nur mit einem schwarzen Solarmodul erzielt werden. Andererseits kann, je nach Ursprung der Farbe (Absorption/Remission, Interferenz, Brechung), die Farbe einer an sich homogenen Oberfläche des Solarmoduls vom Betrachtungs- und/oder Einstrahlwinkel abhängen. Darüber hinaus bestimmen auch das Spektrum und die räumliche Verteilung (diffus, gerichtet) des Lichtes den Farbeindruck.

In den europäischen Patentanmeldungen EP18186153 und EP18186161 sind Solarmodule gezeigt, bei denen eine Farbgebung durch mindestens eine optische Interferenzschicht erfolgt. Durch Strukturieren des Frontglases wird ein farbiges Solarmodul erhalten, das auch aus verschiedenen Blickrichtungen und bei unterschiedlichen Lichtverhältnissen eine für das menschliche Auge weitgehend stabile Farbwirkung hat und dabei immer noch eine akzeptable Energieausbeute, insbesondere einen guten Wirkungsgrad, erreicht.

Die konkrete Dimensionierung einer Fassade kann erfordern, dass farbige Solarmodule in verschiedenen Größen und Formen benötigt werden, um der Fassade eine möglichst homogene Farbe zu geben. Generell führen kleinere und nicht rechteckförmige Solarmodule zu erheblichen Mehrkosten, wenn der eigentliche Halbleiterstapel auf großer Fläche hergestellt wird und kleinere Modulgrößen durch Teilen erzeugt werden müssen, da bei kleineren Solarmodulen ein deutlich höherer Materialeinsatz pro Einheit Ausgangsleistung erforderlich ist. Zudem wird bei kleineren Solarmodulen das Verhältnis von Modulfläche zu Modulrand ungünstiger, so dass auch der Gesamtmodulwirkungsgrad kleiner ist. Ferner haben die Kosten von bestimmten Materialien und Fixkosten für Anbauteile und Randversiegelung bei kleinen Solarmodulen einen höheren Anteil an den Gesamtkosten. Des Weiteren können bestimmte Schritte des Herstellungsprozesses bei verschiedenen Substratgrößen nur mit stark modifizierten Anlagenkonzepten umgesetzt werden.

Aus vorstehend genannten Gründen ist die industrielle Serienfertigung von Solarmodulen auf einige wenige Standard-Modulgrößen und in aller Regel Rechteckform der Solarmodule ausgerichtet, so dass eine vollflächige Belegung einer Fassade mit Solarmodulen meist nicht möglich oder wirtschaftlich inakzeptabel ist. Hinzu kommt, dass die fotovoltaische Auslegung der Solarzellen und diverse Anbauteile wie Kontaktbänder, Anschlussdosen und Kabel für die Standard-Modulgrößen optimiert sind. Darüber hinaus kann es durch eine ungünstige Ausrichtung zur Sonne oder durch Verschattung durch Teile desselben Gebäudes oder durch benachbarte Gebäude unwirtschaftlich sein, bestimmte Bereiche einer Fassade mit Solarmodulen zu belegen, da deren Energieertrag nicht die Mehrkosten erwirtschaftet.

Um das Problem fehlender geeigneter Größen und/oder Formen von farbigen Solarmodulen zu beheben, ist denkbar, fotovoltaisch passive Fassadenelemente aus Blech oder anderen herkömmlichen Baumaterialien zu verwenden, wobei es sich versteht, dass deren Farbe möglichst ähnlich zu jener der farbigen Solarmodule sein sollte. Hier gibt es aber ein technisches und gestalterisches Problem, das in der Natur der Farberzeugung liegt. Tatsächlich kann sich die Farbe der Solarmodule, je nach Ursprung der Farbe (Absorption/Remission, Interferenz, Brechung) bei unterschiedlichen Beleuchtungsverhältnissen, insbesondere abhängig von der Art des Lichtes (diffus, direkt, Lichtfarbe), sowie durch eine Änderung des Einstrahl- und/oder Beobachtungswinkels verändern. Wenn die fotovoltaisch passiven Fassadenelemente aus anderen Materialien als die farbigen Solarmodule bestehen, entstehen hierdurch typischerweise Farbkontraste, die aus gestalterischen Gesichtspunkten unerwünscht sind.

Eine Lösung dieses Problems geht aus der europäischen Patentanmeldung EP 18186175 hervor. Darin gezeigt sind fotovoltaisch passive Fassadenelemente, bei denen analog zu den europäischen Patentanmeldungen EP18186153 und EP18186161 das Frontglas eine Strukturierung aufweist und mindestens eine optische Interferenzschicht vorgesehen ist.

Mit den farbigen fotovoltaisch aktiven Solarmodulen oder farbigen passiven Fassadenelementen, welche in den europäischen Patentanmeldungen EP18186153, EP18186161 und EP 18186175 gezeigt sind, lassen sich sehr gut verschiedene Farben wie Grün, Blau, Türkis oder Gelb und auch verschiedene Grautöne herstellen. Die dort eingesetzten Interferenzschichten basieren auf transparenten dielektrischen Schichten wie Si₃N₄, SiO₂, TiO₂ und ZrO₂. Jedoch sind weiße oder rote Solarmodule oder Fassadenelemente sehr schwierig zu realisieren, so dass deren Herstellung mit akzeptablem Wirkungsgradverlust weiterhin eine große technische Herausforderung darstellt. Besonders bei den Farben Weiß und Rot entstehen hohe Wirkungsgradverluste, da naturgemäß ein großer Teil des sichtbaren Spektrums reflektiert werden muss. Zudem ist der Brechungsindex für die genannten Materialsysteme im Sichtbaren (380 nm bis 780 nm) auf Werte unter 3 limitiert, so dass bestenfalls helle Grautöne erreicht werden können (L<60).

Als Weißtöne gelten im Allgemeinen Farben mit Werten von L über 80 oder noch besser 85. Im RAL-System ist das dunkelste Weiß das Papyrusweiß mit L=81: RAL 9018, Papyrusweiß, L = 81,34, a = -2,29, b = 2,96.

Um rote Solarmodule oder Fassadenelemente mit Interferenzschichten zu erzeugen benötigt man Vielfachschichten, da bei einer oder zwei Interferenzschichten die höheren Ordnungen Blauanteile in das Reflexionsspektrum hinzumischen, so dass in der Regel Violett- oder Purpurtöne entstehen. Die Vielfachschichten haben meist eine starke Winkelabhängigkeit.

Beispiele für verwandte Stand der Technik sind in BENEDIKT BLÄSI ET AL: "Morpho Butterfly Inspired Coloured BIPV Modules", PROC. OF THE 33RD EU-PVSEC, 25 - 29. September 2017, S. 2630-2634, in S PELISSET ET AL: "EFFICIENCY OF SILICON THIN-FILM PHOTOVOLTAIC MODULES WITH A FRONT COLOURED GLASS", PROC. CISBAT 2011, 2011, Seiten 37-42, in US 2017/033250 A1 und in US 2019/386607 A1 beschrieben.

Demgegenüber besteht die Aufgabe der vorliegenden Erfindung darin, ein farbiges Solarmodul oder fotovoltaisch passives Fassadenelement zur Verfügung zu stellen, bei denen auch eine rote und weiße Farbe in einfacher Weise realisierbar ist. Bei einem farbigen Solarmodul soll ein möglichst geringer Wirkungsgradverlust auftreten. Zudem soll die Farbe des Solarmoduls oder fotovoltaisch passiven Fassadenelements möglichst wenig von den Lichtverhältnissen sowie vom Betrachtungs- und Einstrahlwinkel abhängen und sie sollen in verschiedenen Größen und Formen zu akzeptablen Kosten und mit zufriedenstellender Homogenität herstellbar sein.

Diese und weitere Aufgaben werden nach dem Vorschlag der Erfindung durch ein plattenförmiges Bauteil mit den Merkmalen des unabhängigen Patentanspruchs gelöst. Vorteilhafte Ausgestaltungen der Erfindung sind durch die Merkmale der Unteransprüche angegeben.

Erfindungsgemäß ist ein farbiges plattenförmiges Bauteil, insbesondere mit Verbundscheibenstruktur, gezeigt.

Der Begriff "plattenförmiges Bauteil" bezieht sich generell auf ein Bauteil, das geeignet und bestimmt ist, als sichtbares Flächenelement verwendet zu werden. Vorzugsweise handelt es sich bei dem plattenförmigen Bauteil um ein Solarmodul, insbesondere Dünnschichtsolarmodul, das beispielsweise in Freiflächenanlagen oder in Aufdachmontage verwendbar ist. Gleichermaßen bevorzugt handelt es sich bei dem plattenförmigen Bauteil um ein fotovoltaisch aktives oder passives Fassadenelement, das dazu dient, in eine Fassade eingebaut zu werden. Ein fotovoltaisch aktives Fassadenelement ist auch ein Solarmodul. Generell weist die Fassade eine Vorder- bzw Außenseite und eine Rück- bzw. Innenseite auf, wobei die Vorderseite der Fassade von der äußeren Umgebung her betrachtet werden kann. Die Fassade ist beispielsweise eine Gebäudewand oder eine freistehende Wand, die beispielsweise als Sicht- oder Lärmschutzwand dient. Das Fassadenelement kann als eigenständiger Bestandteil in eine Fassade integriert werden, wobei die Vorderfläche des Fassadenelements Teil der Außenseite bzw. Vorderfläche der Fassade ist. Die Vorder- bzw. Außenseite des Fassadenelements dient dem Lichteinfall (z.B. Sonnenlicht) auf das Fassadenelement. Die Rück- bzw. Innenseite des Fassadenelements dient weder der Betrachtung von der äußeren Umgebung her, noch dient sie dem Lichteinfall.

Unter einem "farbigen" plattenförmigen Bauteil bzw. "plattenförmigen Bauteil mit Farbwirkung" ist zu verstehen, dass die Vorder- bzw. Außenseite des plattenförmigen Bauteils bei Lichteinfall (z.B. Sonnenlicht) eine bestimmte (wählbare) Farbe hat.

Unter "Verbundscheibenstruktur" ist zu verstehen, dass das plattenförmige Bauteil mindestens zwei Scheiben aufweist, die durch eine Zwischenschicht fest miteinander verbunden (z.B. laminiert) sind.

Erfindungsgemäß ist ein plattenförmiges Bauteil mit Farbwirkung gezeigt, das eine transparente Deckplatte und mindestens ein flächiges Rückseitenelement umfasst. Insbesondere können die Deckplatte und das flächige Rückseitenelement durch eine Zwischenschicht fest miteinander verbunden sein und eine Verbundscheibe bilden. Die Zwischenschicht ist vorzugsweise eine thermoplastische oder vernetzende Polymer-Zwischenschicht (z.B. PVB oder EVA). Eine Verklebung ist auch durch ein transparentes Silikon oder Gießharz möglich.

Im Sinne vorliegender Erfindung bezieht sich der Begriff "Transparenz" bzw. "transparent" auf eine Durchlässigkeit für sichtbares Licht von wenigstens 85%, insbesondere wenigstens 90%, vorzugsweise wenigstens 95%, insbesondere 100%. Typischer Weise liegt sichtbares Licht im Wellenlängenbereich von 380 nm bis 780 nm vor. Der Begriff "Opazität" bzw. "opak" bezieht sich auf eine Durchlässigkeit für sichtbares Licht von weniger als 5%, insbesondere 0%. Der Begriff "Semi-Transparenz" bzw. "semi-transparent" bezieht sich auf eine Durchlässigkeit für sichtbares Licht von weniger als 85% und midestens 5%. Die prozentualen Angaben beziehen sich auf die Intensität des Lichts, jeweils gemessen auf der einen Seite der zu untersuchenden flächigen Struktur (z.B. Scheibe), bezogen auf die Intensität des auf der anderen Seite der flächigen Struktur auftreffenden Lichts. Für eine solche Messung kann beispielsweise eine Weißlichtquelle (Quelle für sichtbares Licht) auf der einen Seite der flächigen Struktur und ein Detektor für sichtbares Licht auf der anderen Seite der flächigen Struktur angeordnet werden. Die nachfolgend genannten Werte für den optischen Brechungsindex beziehen sich immer auf den optischen Brechungsindex im sichtbaren Wellenlängenbereich von 380 nm bis 780 nm.

Im erfindungsgemäßen plattenförmigen Bauteil dient die Deckplatte zur Farbgebung, wie im Weiteren näher erläutert wird. Die farbgebende Deckplatte weist eine lichteinfallseitig angeordnete Vorderfläche und eine gegenüberliegende Rückfläche auf. Die Vorderfläche der Deckplatte ist somit der äußeren Umgebung zugewandt, von der aus die Vorder- bzw. Außenseite des plattenförmigen Bauteils betrachtet werden kann. Die Rückfläche der Deckplatte ist dementsprechend von der äußeren Umgebung abgewandt.

Gemäß einer Ausgestaltung des erfindungsgemäßen plattenförmigen Bauteils besteht die Deckplatte aus Glas oder Kunststoff, vorzugsweise Kalknatronglas. Vorzugsweise ist die Deckplatte als eine starre Glas- oder Kunststoffplatte ausgebildet. Die Vorderfläche bzw. Rückfläche der Deckplatte wird in diesem Fall vom jeweiligen Material der Deckplatte gebildet. Gemäß einer alternativen Ausgestaltung der Deckplatte kann diese aus mindestens zwei verschiedenen Materialien bestehen, wobei die Vorderfläche und/oder Rückfläche aus einem von einem Kern der Deckplatte verschiedenen Material gebildet wird. Der Kern der Deckplatte besteht vorzugsweise aus einem gleichen Material, beispielsweise Glas oder Kunststoff, vorzugsweise Kalknatronglas. Auf den Kern der Deckplatte ist außen- und/oder innenseitig ein vom Kern der Deckplatte verschiedenes Material angebracht, welches transparent ist und einen selben optischen Brechungsindex wie das Material des Kerns der Deckplatte hat. Die Vorderfläche bzw. Rückfläche wird in diesem Fall vom jeweiligen Material gebildet, das auf den Kern der Deckplatte aufgebracht ist. Erfindungsgemäß umfasst der Begriff "Deckplatte" somit auch Verbundkörper, mit der Maßgabe, dass die Materialien, welche die Scheibe formen, transparent sind und einen gleichen optischen Brechungsindex haben. Vorzugsweise weist die Deckplatte keine Krümmung auf und ist somit plan (eben). Die Deckplatte kann jedoch auch gekrümmt sein. Die Deckplatte kann starr oder biegsam sein. Eine biegsame Deckplatte kann auch in ebener Form bereitgestellt werden. Bei einer ebenen (planen) Deckplatte wird durch die Deckplatte selbst eine Ebene definiert, welche im Sinne der Erfindung als "Ebene der Deckplatte" zu verstehen ist. Bei einer gekrümmten Deckplatte kann durch eine (gedachte) ebene Tangentialfläche an einem beliebigen Punkt der Ebene eine lokale Ebene definiert werden, welche ebenfalls unter den Begriff "Ebene der Deckplatte" fällt.

Das erfindungsgemäße plattenförmige Bauteil vermittelt dem Betrachter bei Beleuchtung von der Außenseite her mit weißem Licht, insbesondere bei Beleuchtung mit Sonnenlicht, in mindestens einem Abschnitt einen homogenen Farbeindruck, d.h. das plattenförmige Bauteil ist farbig. Vorzugsweise erstreckt sich der farbige Abschnitt über die komplette Vorderfläche des plattenförmigen Bauteils. Als besonders attraktiv gelten plattenförmige Bauteile mit einem homogenen Farbeindruck auf der gesamten Fläche.

Die Farbe des plattenförmigen Bauteils kann durch drei Farbkoordinaten L*, a*, b* beschrieben werden, wobei sich die Farbkoordinaten auf den dem Fachmann an sich bekannten (CIE)L*a*b*-Farbraum beziehen, in dem alle wahrnehmbaren Farben exakt definiert sind. Dieser Farbraum ist in der europäischen Norm EN ISO 11664-4 "Colorimetry - Part 4:CIE 1976 L*a*b* Colour space" spezifiziert, auf welche im Rahmen der vorliegenden Erfindungsbeschreibung vollumfänglich Bezug genommen wird. Im (CIE)L*a*b*-Farbraum ist jede Farbe durch einen Farb-Ort mit den drei kartesischen Koordinaten L*, a*, b* definiert. Auf der a*-Achse liegen sich Grün und Rot gegenüber, die b*-Achse verläuft zwischen Blau und Gelb, die L*-Achse beschreibt die Helligkeit (Luminanz) der Farbe. Für eine anschaulichere Darstellung können die Größen in den Lhc-Farbraum umgerechnet werden, wobei L gleich bleibt und die Sättigung der Radius und h der Winkel eine Farbpunktes in der a*b*-Ebene ist.

Die Farbe des plattenförmigen Bauteils bezieht sich auf eine Betrachtung von der äußeren Umgebung her, d.h. in Sicht auf die frontseitige Scheibe bzw. Deckplatte. Die Farbmessung bzw. die Bestimmung der Farbkoordinaten des plattenförmigen Bauteils kann in einfacher Weise durch ein im Handel verfügbares Farbmessgerät (Spektralphotometer) erfolgen. Das Farbmessgerät wird zu diesem Zweck auf die Vorderfläche der Deckplatte gerichtet, insbesondere auf die Vorderfläche aufgesetzt. Übliche Farbmessgeräte ermöglichen eine normgerechte Farbmessung, wobei deren Aufbau und Toleranzen typischer Weise internationalen Normen unterliegen, beispielsweise definiert durch DIN 5033, ISO/CIE 10527, ISO 7724 und ASTM E1347. Beispielsweise wird hinsichtlich der Farbmessung auf die Norm DIN 5033 vollumfänglich Bezug genommen. Ein Farbmessgerät weist als Lichtquelle beispielsweise eine Xenon-Blitzlampe, Wolfram-Halogenlampe oder ein oder mehrere LEDs auf, wobei die Vorderfläche eines Körpers mit dem erzeugten (z.B. Weiß-)Licht beleuchtet und das vom plattenförmigen Bauteil empfangene Licht gemessen wird. Wie eingangs erläutert, ergibt sich die vom Farbmessgerät gemessene Körperfarbe aus dem reflektierten und remittierten Licht des plattenförmigen Bauteils.

Um zu erreichen, dass das erfindungsgemäße plattenförmige Bauteil zumindest in einem Abschnitt eine homogene Farbe hat, weist zumindest eine Oberfläche (d.h. Vorderfläche und/oder Rückfläche) der Deckplatte mindestens einen strukturierten Bereich auf. Zudem ist mindestens eine farbgebende Farbfilterschicht an der Deckplatte angeordnet. Durch die mindestens eine Farbfilterschicht wird die Deckplatte zu einer farbgebenden Deckplatte. Die mindestens eine Farbfilterschicht dient zur Reflexion von Licht innerhalb eines vorgegebenen bzw. vorgebbaren Wellenlängenbereichs. Die mindestens eine Farbfilterschicht ist vorzugsweise unmittelbar (d.h. ohne weitere Zwischenschicht) auf einer Fläche der Deckplatte angeordnet. Da die mindesstens eine Farbfilterschicht eine farbige Reflexion erzeugt, ist sie nicht mehr vollständig transparent, Bei dunkleren und ungesättigten Farben kann die Durchlässigkeit für sichtbares Licht noch mehr als 85% betragen, bei helleren und stärker gesättigten Farben liegt sie in der Regel unter 85%.

Die Farbfilterschicht kann ein- oder mehrlagig ausgebildet sein, d.h. eine oder mehrere lichtbrechende Lagen (Brechungsschichten) aufweisen. Die Farbfilterschicht dient zur Erzeugung der Farbe der Deckplatte und somit des plattenförmigen Bauteils, wobei die Farbfilterschicht beispielsweise so ausgebildet ist, dass eine konstruktive bzw. destruktive Interferenz von Licht, das an den verschiedenen Grenzflächen der Farbfilterschicht reflektiert wird, möglich ist. Die Farbe des plattenförmigen Bauteils ergibt sich in diesem Fall aus der Interferenz des an den Grenzflächen der Farbfilterschicht reflektierten Lichts. Wie weiter unten gezeigt wird, können auch sehr dünne Schichten, die zu dünn für konstruktive oder destruktive Interferenz sind, alleine durch die Brechungsindexsprünge und die Dispersion (Abhängigkeit des Brechungsindex von der Wellenlänge) als Farbfilter verwendet werden. Darüberhinaus werden in dieser Erfindung auch Materialen für die Farbfilterschichten verwendet, die eine partielle Absorption für einen bestimmten Teilbereich des sichtbaren Lichtes aufweisen. Auch diese selektive partielle Absorption trägt zur Farbgebung bei. Daher sollen die farbgebenden Schichten im allgemeinen hier als Farbfilterschichten bezeichnet werden.

Bei Beleuchtung mit (Weiß-)Licht, insbesondere Sonnenlicht, wirkt die Farbfilterschicht als Farbfilter zur Erzeugung einer homogenen Farbe. Vorzugsweise erstreckt sich der strukturierte Bereich über die komplette Deckplatte, d.h. über die komplette Fläche (Vorderfläche und/oder Rückfläche) der Deckplatte, so dass das komplette plattenförmige Bauteil eine homogene Farbe hat. Das plattenförmige Bauteil kann auch mehrere plattenförmige Bauteilabschnitte mit jeweils homogener Farbe aufweisen. Die Farben der plattenförmigen Bauteilabschnitte können gleich oder voneinander verschieden sein.

Der mindestens eine strukturierte Bereich weist senkrecht zur Ebene der Deckplatte ein Höhenprofil mit Bergen (Erhebungen) und Tälern (Einsenkungen) auf, wobei ein mittlerer Höhenunterschied zwischen den Bergen und Tälern mindestens 2 µm und vorzugsweise, jedoch nicht zwingend, maximal 20%, bevorzugt maximal 10%, stärker bevorzugt maximal 5%, einer Dicke der Deckplatte beträgt. Ferner setzen sich mindestens 50%, bevorzugt mindestens 80%, stärker bevorzugt mindestens 90%, des strukturierten Bereichs der Fläche (Vorder- und/oder Rückfläche) aus unterschiedlich geneigten Segmenten bzw. Facetten zusammen. Die Segmente sind Abschnitte der zur äußeren Umgebung gerichteten Fläche der Deckplatte und jeweils als plane Flächen ausgebildet, die zur Ebene der Deckplatte geneigt sind. Hierbei haben, bezogen auf die Ebene der Deckplatte, mindestens 20% der Segmente einen Neigungswinkel im Bereich von größer als 0° bis maximal 15° und mindestens 30% der Segmente einen Neigungswinkel im Bereich von größer als 15° bis maximal 45°. Vorteilhaft, jedoch nicht zwingend, haben weniger als 30% der Segmente einen Neigungswinkel von größer als 45°. Die Strukturen sind bevorzugt nicht periodisch und anisotrop. Für spezielle optische Effekte können jedoch auch periodische Strukturen und aniostrope Strukturen zur Anwendung kommen.

Ferner sind die Segmente jeweils eben (plan) und haben eine Segmentfläche von mindestens 1 µm². Weiterhin gilt, dass in mindestens einer Zone (d.h. Teilbereich) des strukturierten Bereichs die Segmente jeweils eine mittlere Rauigkeit von weniger als 15%, bevorzugt weniger als 10%, stärker bevorzugt weniger als 5%, einer Schichtdicke der Farbfilterschicht, welche auf den strukturierten Bereich aufgebracht ist, haben. Falls die Farbfilterschicht aus mehreren Brechungsschichten besteht, haben die Segmente der mindestens einen Zone jeweils eine mittlere Rauigkeit von weniger als 15% einer Schichtdicke der Brechungsschicht mit geringster Schichtdicke. Die Zone, in der die Segmente jeweils eine mittlere Rauigkeit von weniger als 15% der Schichtdicke der Farbfilterschicht haben, kann dem strukturierten Bereich entsprechen, d.h. Zone und strukturierter Bereich sind dann identisch. Der strukturierte Bereich kann beispielsweise durch Ätzen, Sandstrahlen oder Walzen der Deckplatte hergestellt werden.

Demnach weist der mindestens eine strukturierte Bereich der Deckplatte eine Vielzahl von ebenen (planen) Segmenten auf. Im Sinne vorliegender Erfindung können ebene (plane) Segmente durch nicht-gekrümmte Flächen gebildet werden. Möglich ist aber auch, dass ebene (plane) Segmente durch geringfügig gekrümmte Flächen gebildet werden. Ein Segment ist im Sinne vorliegender Erfindung dann geringfügig gekrümmt, wenn für jeden Punkt des Segments gilt: wenn an einem Punkt des Segments eine (gedachte) Tangentialebene mit einer Fläche von 1 µm² konstruiert wird, beträgt der Abstand zwischen der Fläche des Segments und der Tangentialebene, bezogen auf die Normalenrichtung zur Tangentialebene, weniger als 50 nm.

Im Sinne vorliegender Erfindung bezeichnet der Begriff "Strukturierung" bzw. "strukturierter Bereich" im Zusammenhang mit dem plattenförmigen Bauteil einen Bereich der Vorderfläche oder Rückfläche der Deckplatte, in dem die vorstehend beschriebenen Merkmale in Kombination vorliegen.

Durch die Merkmale des strukturierten Bereichs kann in vorteilhafter Weise erreicht werden, dass bei Beleuchtung der Deckplatte mit Licht auch bei einer Beobachtung außerhalb des Glanzwinkels (Einfallswinkel des auftreffenden Lichts entspricht Ausfallswinkel des reflektierten Lichts, bezogen auf die Ebene der farbgebenden Deckplatte) Licht mit relativ hoher Intensität zurückgeworfen wird. Ursache hierfür sind die verschieden geneigten Segmente, die in ausreichender Anzahl, geeigneter Größe und geeigneten Neigungswinkeln vorhanden sind, um eine hohe Intensität des reflektierten Lichts auch bei einer Beobachtung außerhalb des Glanzwinkels zu ermöglichen. Es gibt stets hinreichend viele geneigte Segmente, die bei Strukturierung außen durch Brechung an den Segmenten und bei Strukturierung innen durch Reflexion an den Segmenten genügend Intensität in Richtungen außerhalb des Glanzwinkels der farbgebenden Deckplatte streuen.

Wie hier und im Weiteren verwendet, bezieht sich der Begriff "Glanzwinkel" auf die Normale zur Ebene der farbgebenden Deckplatte, im Unterschied zum "lokalen Glanzwinkel", der sich auf die Normale zur Ebene eines Segments bezieht. Glanzwinkel und lokaler Glanzwinkel können gleich sein (Segment ist parallel zur Ebene der farbgebenden ersten Scheibe), sind jedoch in aller Regel verschieden (Segment ist geneigt zur Ebene der farbgebenden Deckplatte).

Im Ergebnis kann erreicht werden, dass die Intensität des nicht im Glanzwinkel reflektierten (d.h. gestreuten) Lichts relativ hoch ist, welches im Vergleich zu einer reflektierenden Oberfläche ohne einen solchen strukturierten Bereich, eine nur geringe Winkelabhängigkeit in Bezug auf die Einstrahl- und Beobachtungsrichtung hat. Mittels der Farbfilterschicht kann das außerhalb des Glanzwinkels reflektierte Licht, abhängig von Brechungsindex und Schichtdicke der Farbfilterschicht, einer Farbselektion unterzogen werden, so dass die Oberfläche der farbgebenden Deckplatte eine homogene Farbe mit relativ geringer Winkelabhängigkeit hat. Die Farbfilterschicht wirkt als Filter mit möglichst schmalbandiger Reflexion und einer breitbandigen Transmission.

In dieser Hinsicht vorteilhaft weist der strukturierte Bereich ein Höhenprofil auf, bei dem ein mittlerer Höhenunterschied zwischen den Bergen und Tälern mindestens 2 µm, bevorzugt mindestens 10 µm und besonders bevorzugt mindestens 15 µm beträgt. Ein derart strukturierter Bereich kann durch Ätzen der Deckplatte (z.B. aus Glas) erzeugt werden. In dieser Hinsicht gleichermaßen vorteilhaft weist der strukturierte Bereich ein Höhenprofil auf, bei dem ein mittlerer Höhenunterschied zwischen den Bergen und Tälern mindestens 50 µm, bevorzugt mindestens 100 µm beträgt. Ein derart strukturierter Bereich kann durch Walzen der farbgebenden Deckplatte (z.B. aus Glas) erzeugt werden. Dementsprechend erstreckt sich die Erfindung vorteilhaft auf ein plattenförmiges Bauteil, dessen mindestens ein strukturierter Bereich der farbgebenden Deckplatte durch Ätzen oder Walzen hergestellt ist, wodurch die genannten Höhenprofile herstellbar sind.

Die Strukturen können aber auch durch das Aufbringen einer transparenten und strukturierten Schicht auf die farbgebende Deckplatte erzeugt werden. Die Schicht muss dabei einen gleichen (oder zumindest sehr ähnlichen) Brechungsindex haben wie die Deckplatte. Erfindungsgemäß soll das Strukturieren einer Oberfläche der farbgebenden Deckplatte auch das Aufbringen einer solchen transparenten und strukturierten Schicht umfassen.

Die genannten Eigenschaften des strukturierten Bereichs der farbgebenden Deckplatte können durch herkömmliche Messgeräte, wie ein Mikroskop, insbesondere ein Konfokalmikroskop oder ein Nadelprofilometer, gemessen werden.

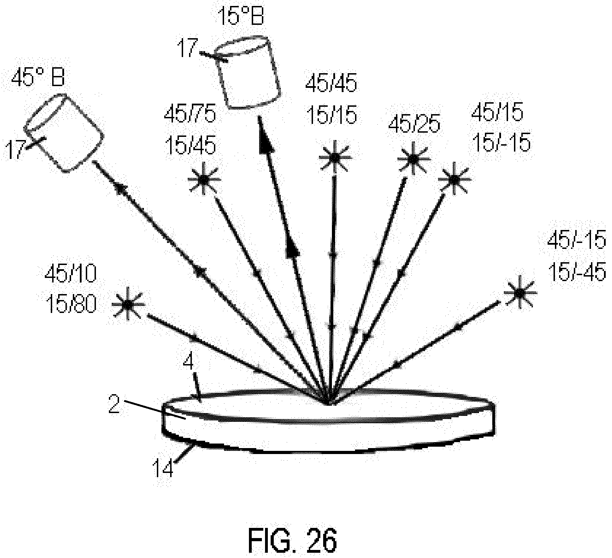

Vorzugsweise wird durch den mindestens einen strukturierten Bereich der (unbeschichteten) Deckplatte des erfindungsgemäßen plattenförmigen Elements erreicht, dass bei Beobachtungswinkeln von 45° und 15° (jeweils bezogen auf die Ebene der Deckplatte) und einem Einfallswinkel, der um 45° vom jeweiligen Glanzwinkel abweicht (in beiden Richtungen), eine Helligkeit L des reflektierten Lichts von mindestens 10 auftritt. Vorzugsweise tritt eine Helligkeit L des reflektierten Lichts von mindestens 15 und stärker bevorzugt mindestens 20 auf. Bei dieser Messung ist auf der von der zu charakterisierenden Seite abgewandten Seite (d.h. Rückfläche) der (unbeschichteten) Deckplatte eine schwarze Abdeckung angebracht. Für die Messung wird ein D65-Strahler verwendet und mit einem im Handel verfügbaren Mehrwinkel-Farbmessgerät die Helligkeit L gemessen (10° Öffnungswinkel). Der Messaufbau wird weiter unten in Verbindung mit Figur 26 näher erläutert. In diesem Zusammenhang wird auf die europäische Norm EN ISO 11664-4 in vollem Umfang Bezug genommen.

Die Farbe des plattenförmigen Bauteils ergibt sich durch die bei Beleuchtung mit Weißlicht (z.B. Sonnenlicht) von der mindestens eine Farbfilterschicht selektierten Farbe, wobei die selektierte Farbe mit der Hintergrundfarbe des Rückseitenelements kombiniert wird. Der Gesamteindruck ergibt sich somit aus selektierter Farbe und Hintergrundfarbe.

Das plattenförmige Bauteil weist an seiner Rückseite mindestens ein flächiges Rückseitenelement auf. Vorzugsweise ist das mindestens eine flächige Rückseitenelement opak oder semi-transparent. Das flächige Rückseitenelement ist an der Rückseite des plattenförmigen Bauteils angeordnet, d.h. in Richtung des Lichteinfalls hinter der Deckplatte.

Das mindestens eine Rückseitenelement trägt zur Farbgebung des plattenförmigen Bauteils bei. Zu diesem Zweck ist das Rückseitenelement beispielsweise unbunt, dunkel und matt ausgebildet. Möglich ist auch, dass das Rückseitenelement farbig ist, um in Kombination mit der mindestens einen farbgebenden Farbfilterschicht, welche an der Deckplatte angeordnet ist, dem plattenförmigen Bauteil einen bestimmten (vorgegebenen bzw. vorgebbaren) Farbeindruck zu vermitteln.

Wie bereits ausgeführt, verfügt die Deckplatte über eine der äußeren Umgebung zugewandte Vorderfläche und gegenüberliegend hierzu eine Rückfläche. Die Vorderfläche einer jeweiligen Scheibe ist im verbauten Zustand des plattenförmigen Bauteils in der Fassade der äußeren Umgebung zugewandt. Das mindestens eine flächige Rückseitenelement weist eine Kontaktfläche auf, die mit der Rückfläche der Deckplatte fest verbunden ist.

Das mindestens eine flächige Rückseitenelement bedeckt beispielsweise mindestens 70%, mindestens 90%, oder mindestens 99% der Rückfläche der Deckplatte. Insbesondere bedeckt das flächige Rückseitenelement die Rückfläche der Deckplatte vollflächig (zu 100%, d.h. vollständige Überdeckung). Möglich ist jedoch auch, dass das mindestens eine flächige Rückseitenelement weniger als 70%, insbesondere weniger als 50% der Rückfläche der Deckplatte bedeckt.

Gemäß einer bevorzugten Ausgestaltung des erfindungsgemäßen plattenförmigen Bauteils ist das mindestens eine flächige Rückseitenelement fotovoltaisch aktiv ausgebildet, d.h. zur Energieerzeugung aus Sonnenlicht geeignet und bestimmt. Das farbige plattenförmige Bauteil kann somit in vorteilhafter Weise zur fotovoltaischen Energieerzeugung eingesetzt werden.

Das mindestens eine flächige Rückseitenelement kann fotovoltaisch aktiv oder passiv sein. Ist das Rückseitenelement fotovoltaisch aktiv und weist beispielsweise CIGS-Dünnschichtsolarzellen auf, tragen diese zur Gesamtfarbe bei. Die CIGS-Dünnschichtsolarzellen weisen typischer Weise eine bläulich-schwarze Färbung auf.

Bevorzugt handelt es sich bei dem fotovoltaisch aktiven Rückseitenelement um ein Trägersubstrat (Scheibe) mit hierauf aufgebrachten serienverschalteten Solarzellen, wobei das Trägersubstrat vorzugsweise direkt, d.h. ohne zwischenliegende Scheibe, mit der Deckplatte durch eine Zwischenschicht fest verbunden ist (z.B. durch Lamination).

Grundsätzlich kann es sich um jede Art von Solarzellen handeln, insbesondere um Silizium-basierte Solarzellen auf Wafer-Basis (Solarzellen auf Trägersubstrat in Superstratkonfiguration) oder um Dünnschichtsolarzellen, die in monolithisch integrierter Form serienverschaltet sind (Solarzellen auf Trägersubstrat in Substrat- oder Superstratkonfiguration). Vorzugsweise handelt es sich um Dünnschichtsolarzellen, die in monolithisch integrierter Form serienverschaltet sind.

Durch Laminieren der Deckplatte mit dem Trägersubtrat und aufgebrachten Solarzellen wird ein (Dünnschicht-)Solarmodul mit Verbundscheibenstruktur erzeugt. Die Zwischenschicht ist vorzugsweise eine thermoplastische oder vernetzende Polymer-Zwischenschicht (z.B. PVB oder EVA). Eine Verklebung ist auch durch ein transparentes Silikon oder Gießharz möglich.

Das fotovoltaisch aktive Rückseitenelement weist vorzugsweise Dünnschichtsolarzellen in Substratkonfiguration auf, bei der der Schichtenaufbau zur Herstellung der Solarzellen auf einer der Lichteintrittsseite zugewandten Oberfläche des Trägersubstrats aufgebracht ist. In Einklang mit der üblichen Verwendung bezieht sich der Begriff "Dünnschichtsolarzellen" auf einen Schichtenaufbau mit einer geringen Dicke von beispielsweise einigen Mikrometern, so dass ein Trägersubstrat für eine ausreichende mechanische Festigkeit benötig wird. Das Trägersubstrat kann beispielsweise aus anorganischem Glas oder Kunststoff bestehen und kann in Abhängigkeit von der jeweiligen Schichtdicke und den spezifischen Materialeigenschaften als starre Platte oder biegsame Folie ausgestaltet sein. Vorzugsweise besteht das Trägersubstrat aus Glas.

Bei Dünnschichtsolarzellen umfasst der Schichtenaufbau in an sich bekannter Weise eine Rückelektrodenschicht, eine Frontelektrodenschicht, und eine zwischen Rück- und Frontelektrodenschicht angeordnete, fotovoltaisch aktive Absorberschicht. Die Frontelektrodenschicht ist optisch transparent, da ein Durchtritt von Licht zum Schichtenaufbau ermöglicht sein muss. Die optisch transparente Frontelektrodenschicht umfasst oder besteht typischer Weise aus einem dotierten Metalloxid (TCO = Transparent Conductive Oxide), beispielsweise n-leitendes, insbesondere Aluminium-dotiertes, Zinkoxid (AZO).

Vorzugsweise umfasst oder besteht die fotovoltaisch aktive Absorberschicht aus einem Chalkopyrit-Halbleiter, bei dem es sich vorteilhaft um einen ternären I-III-VI-Verbindungshalbleiter aus der Gruppe Kupfer-Indium/Gallium-Disulfid/Diselenid (Cu(In,Ga)(S,Se)₂) handelt. In vorstehender Formel können Indium und Gallium jeweils allein oder in Kombination vorliegen. Entsprechendes gilt für Schwefel und Selen, die jeweils allein oder in Kombination vorliegen können. Als Material für die Absorberschicht eignet sich in besonderer Weise CIS (Kupferindiumdiselenid/-disulfid) oder CIGS (Kupferindiumgalliumdiselenid, Kupferindiumgalliumdisulfid, Kupferindiumgalliumdisulfoselenid). Die Absorberschicht weist typischer Weise eine Dotierung von einem ersten Leitungstyp (Ladungsträgertyp) und die Frontelektrode eine Dotierung vom entgegengesetzten Leitungstyp auf. In aller Regel ist die Absorberschicht p-leitend (p-dotiert), verfügt also über einen Überschuss von Defektelektronen (Löcher) und die Frontelektrodenschicht ist n-leitend (n-dotiert), so dass freie Elektronen in Überschuss vorhanden sind. Zwischen Absorberschicht und Frontelektrodenschicht ist typischer Weise eine Pufferschicht angeordnet. Dies gilt insbesondere für Absorberschichten auf Basis von Cu(In,Ga)(S,Se)₂, bei denen in aller Regel eine Pufferschicht zwischen einer p-leitenden Cu(In,Ga)(S,Se)₂-Absorberschicht und einer n-leitenden Frontelektrode benötigt wird. Nach derzeitiger Erkenntnis ermöglicht die Pufferschicht eine elektronische Anpassung zwischen Absorber und Frontelektrode. Sie bietet außerdem einen Schutz vor Sputterschäden in einem nachfolgenden Prozeßschritt der Abscheidung der Frontelektrode beispielsweise durch DC-Magnetron-Sputtern. Durch die Abfolge aus n-leitender Frontelektrodenschicht, Pufferschicht und p-leitender Absorberschicht wird ein p-n-Heteroübergang gebildet, das heißt ein Übergang zwischen Schichten vom entgegengesetzten Leitungstyp. Die fotovoltaisch aktive Absorberschicht kann beispielsweise auch aus Cadmiumtellerid (CdTe) oder amorphem und/oder mikrokristallinem Silizium bestehen.

Im Schichtenaufbau sind durch Strukturierungszonen serienverschaltete Solarzellen ausgebildet. So ist mindestens die Rückelektrodenschicht durch erste Strukturierungslinien (P1-Linien) in vollständig voneinander getrennte Abschnitte unterteilt, welche die Rückelektroden der Solarzellen bilden. Ferner ist mindestens die Absorberschicht durch zweite Strukturierungslinien (P2-Linien) in vollständig voneinander getrennte Abschnitte unterteilt, welche die Absorber der Solarzellen bilden, und mindestens die Frontelektrodenschicht ist durch dritte Strukturierungslinien (P3-Linien) in vollständig voneinander getrennte Abschnitte unterteilt, welche die Frontelektroden der Solarzellen bilden. Benachbarte Solarzellen sind über elektrisch leitfähiges Material in den zweiten Strukturierungslinien in Serienverschaltung elektrisch miteinander verbunden, wobei die Frontelektrode einer Solarzelle mit der Rückelektrode der benachbarten Solarzelle elektrisch verbunden ist und mit dieser typischer Weise, jedoch nicht zwingend, direkten Berührungskontakt hat. Jede Strukturierungszone umfasst eine unmittelbare Abfolge der drei Strukturierungslinien P1-P2-P3, jeweils in dieser Reihenfolge.

Dünnschichtmodule auf Basis von amorphem und/oder mikrokristallinem Silizium und auf Basis von CdTe sind meist in Superstratkonfiguration aufgebaut. Die Dünnschichtsolarzellen sind also auf der lichteintrittsseitigen Oberfläche des Glases angeordnet. Auf der Rückseite befindet sich meist ein zweites Glas zur klimastabilen Verkapselung. Auch in dieser Konfiguration können sie in einer der hier dargestellten Ausführungsformen zu einem farbigen plattenförmigen Bauteil als farbiges Solarmodul oder fabiges Fassadenelement verbunden werden.

In Einklang mit der gängigen Verwendung bezieht sich der Begriff "Solarzelle" bei Dünnschichtsolarzellen auf einen Bereich des Schichtenaufbaus, der eine Frontelektrode, einen fotovoltaisch aktiven Absorber und eine Rückelektrode aufweist und von zwei einander unmittelbar benachbarten Strukturierungszonen begrenzt wird. Jede Solarzelle weist eine optisch aktive Zone auf, die, stapelförmig übereinander angeordnet, eine Rückelektrode, einen Absorber und eine Frontelektrode umfasst und zur fotoelektrischen Konversion von Licht in elektrischen Strom fähig ist.

Das flächige Rückseitenelement ist mit der Deckplatte fest verbunden. Das flächige Rückseitenelement kann selbst eine Farbe aufweisen, wobei die Farbe des Rückseitenelements die Gesamtfarbe des plattenförmigen Bauteils beeinflusst.

Gemäß einer Ausgestaltung des erfindungsgemäßen plattenförmigen Bauteils weist das Rückseitenelement eine mechanisch unterstützende Scheibe auf. Durch diese Maßnahme ist ermöglicht, dass das plattenförmige Bauteil auch höheren Windlasten standhalten kann. Vorzugsweise ist die mechanisch unterstützende Scheibe durch eine Zwischenschicht mit der Deckplatte fest verbunden.

Gemäß einer Ausgestaltung des erfindungsgemäßen plattenförmigen Bauteils ist das flächige Rückseitenelement fotovoltaisch passiv, d.h. nicht zur Energieerzeugung durch Sonnenlicht bestimmt und geeignet.

Das fotovoltaisch passive Rückseitenelement ist beispielsweise in Form einer Beschichtung, insbesondere einer opaken Beschichtung, der Rückfläche der Deckplatte ausgebildet. Gleichermaßen kann das Rückseitenelement beispielsweise in Form einer mit der Rückfläche der Deckplatte fest verbundenen Folie, insbesondere einer opaken Folie, oder eines starren Körpers (keine Beschichtung), insbesondere eines opaken starren Körpers, beispielsweise in Plattenform, ausgebildet sein. Der starre Körper kann ein tragender oder nicht-tragender Körper sein und kann als tragender Körper insbesondere eine Trägerplatte sein. Die Verbindung einer Folie oder eines Körpers mit der Deckplatte kann durch ein transparentes Klebemittel, insbesondere eine transparente Klebefolie, erfolgen.

Insbesondere kann die Farbe des fotovoltaisch passiven flächigen Rückseitenelements in Entsprechung zum opaken Hintergrund farbiger Solarmodule gewählt sein, d.h. das Rückseitenelement kann eine Farbe aufweisen, die den optisch aktiven Solarzellen entspricht. Vorzugsweise ist das fotovoltaisch passive flächige Rückseitenelement unbunt, dunkel und matt. Dann lassen sich der Farbeindruck und dessen Winkelabhängigkeit des plattenförmigen Bauteils besonders gut mit den entsprechend hergestellten farbigen Modulen auf Basis von Dünnschichtmodulen anpassen. Diese Eigenschaften lassen sich wie folgt beschreiben:
- ein L-Wert von maximal 50, bevorzugt kleiner 45 oder kleiner 40;
- ein Chroma c = (a²+b²)^{1/2} von maximal 5, bevorzugt kleiner 2 oder stärker bevorzugt kleiner 1,5.

Zur Vermeidung von Glanz kann zusätzlich folgende Anforderung hinzugenommen werden:
- ein Reflexions-Haze von mindestens 90%, wobei Reflexionshaze der Anteil des diffus reflektierten Lichts an dem insgesamt reflektierten Licht.

Im Weiteren werden verschiedene Ausgestaltungen der farbgebenden Deckplatte des erfindungsgemäßen plattenförmigen Bauteils beschrieben.

Gemäß einer Ausgestaltung (im Weiteren zur leichteren Bezugnahme als "Typ I" bezeichnet) des plattenförmigen Bauteils weist die Vorderfläche der farbgebenden Deckplatte mindestens einen strukturierten Bereich auf, auf dem eine farbgebende (transparente oder semi-transparente) Farbfilterschicht zur Reflexion von Licht innerhalb eines vorgegebenen bzw. vorgebbaren Wellenlängenbereichs angeordnet ist. Die Farbfilterschicht ist vorzugsweise unmittelbar (d.h. ohne weitere Zwischenschicht) auf der Vorderfläche der Deckplatte angeordnet.

Bei vorstehender Ausgestaltung gemäß Typ I kann es vorteilhaft sein, wenn die Rückfläche der farbgebenden Deckplatte keinen strukturierten Bereich und keine Farbfilterschicht aufweist. Die Rückfläche ist dann vorzugsweise glatt (im Rahmen von Produktionsungenauigkeiten).

Bei vorstehender Ausgestaltung gemäß Typ I kann es weiterhin vorteilhaft sein, wenn die Rückfläche der farbgebenden Deckplatte keinen strukturierten Bereich aufweist, wobei auf der Rückfläche der farbgebenden Deckplatte eine weitere Farbfilterschicht zur Reflexion von Licht innerhalb eines vorgegebenen Wellenlängenbereichs angeordnet ist. Die Rückfläche ist vorzugsweise glatt (im Rahmen von Produktionsungenauigkeiten). Die beiden Farbfilterschichten können gleich oder voneinander verschieden sein. Insbesondere können die beiden Farbfilterschichten zur Reflexion von Licht innerhalb eines selben Wellenlängenbereichs ausgebildet sein. Möglich ist jedoch auch, dass die beiden Farbfilterschichten zur Reflexion von Licht innerhalb verschiedener oder nur teilweise überlappender Wellenlängenbereiche ausgebildet sind. Die Schichtdicken und Brechungsindizes der beiden Farbfilterschichten können gleich oder voneinander verschieden sein. Durch diese Maßnahme kann die Farbe des plattenförmigen Bauteils noch besser definiert werden. Zudem können Mischfarben generiert werden.

Bei vorstehender Ausgestaltung vom Typ I kann es weiterhin vorteilhaft sein, wenn die Rückfläche mindestens einen strukturierten Bereich aufweist, auf dem eine Farbfilterschicht zur Reflexion von Licht innerhalb eines vorgegebenen Wellenlängenbereichs angeordnet ist. Der strukturierte Bereich der Rückfläche und der strukturierte Bereich der Vorderfläche können gleich oder voneinander verschieden sein. Die Schichtdicken und Brechungsindizes der beiden Farbfilterschichten können gleich oder voneinander verschieden sein. Auch durch diese Maßnahme kann die Farbe des plattenförmigen Bauteils noch besser definiert werden. Zudem können Mischfarben generiert werden.

Bei dem plattenförmigen Bauteil gemäß Typ I entsteht bereits beim Auftreffen des Lichts auf die strukturierte Vorderfläche der Deckplatte mit Interferenzschicht durch Reflexion, Transmission, partieller Absorption und Interferenz eine Farbe mit hoher Intensität und geringer Winkelabhängigkeit auch außerhalb des Glanzwinkels. Die zusätzliche Farbfilterschicht und/oder Strukturierung auf der Rückfläche der Deckplatte können diese Wirkung noch verstärken.

Gemäß einer weiteren Ausgestaltung (im Weiteren zur leichteren Bezugnahme als "Typ II" bezeichnet) des plattenförmigen Bauteils ist auf der Rückfläche der farbgebenden Deckplatte eine farbgebende (transparente oder semi-transparente) Farbfilterschicht zur Reflexion von Licht innerhalb eines vorgegebenen bzw. vorgebbaren Wellenlängenbereichs angeordnet. Die Farbfilterschicht ist vorzugsweise unmittelbar (ohne weitere Zwischenschicht) auf der Rückfläche der farbgebenden Deckplatte angeordnet. Zudem weist die Rückfläche und/oder die Vorderfläche der farbgebenden Deckplatte jeweils mindestens einen strukturierten Bereich auf, mit der Maßgabe, dass entweder die Vorderfläche mindestens einen strukturierten Bereich aufweist oder auf der Vorderfläche eine weitere Farbfilterschicht zur Reflexion von Licht innerhalb eines vorgegebenen bzw. vorgebbaren Wellenlängenbereichs angeordnet ist. Die Farbfilterschicht ist vorzugsweise unmittelbar (ohne weitere Zwischenschicht) auf der Vorderfläche der farbgebenden Deckplatte angeordnet. Dies bedeutet, dass keine Farbfilterschicht auf der Vorderfläche angeordnet ist, wenn die Vorderfläche mindestens einen strukturierten Bereich aufweist.

Das auftreffende Licht muss demnach mindestens einmal die Deckplatte passieren und an der innenliegenden Farbfilterschicht reflektiert werden, um die gewünschte Farbigkeit mit der verbesserten Winkelstabilität zu erreichen. Durch die innen und/oder außen strukturierte Oberfläche der farbgebenden Deckplatte wird Licht mit einer hohen Intensität und geringer Winkelabhängigkeit auch außerhalb des Glanzwinkels reflektiert, da die innen liegende Farbfilterschicht eine Grenzfläche mit höherem Brechungsindex darstellt. Bei außenliegender Strukturierung wird das Licht bereits an der Grenzfläche Luft und Scheibe gebrochen und trifft diffus gestreut aus verschiedensten Winkeln auf die innen liegende Farbfilterschicht. Bei nur innen liegender Strukturierung findet die diffuse Streuung an dieser inneren Grenzfläche statt, da erfindungsgemäß viele Oberflächensegmente mit unterschiedlichen Neigungswinkeln zur Verfügung stehen. Zudem wird durch die Farbfilterschicht ein guter homogener Farbeindruck erreicht. Die Farbfilterschicht wirkt somit als Filter mit möglichst schmalbandiger Reflexion und einer breitbandigen Transmission.

Bei vorstehender Ausgestaltung vom Typ II kann es vorteilhaft sein, wenn auf der Rückfläche der farbgebenden Deckplatte eine Farbfilterschicht angeordnet ist, wobei die Rückfläche der farbgebenden Deckplatte keinen strukturierten Bereich aufweist und die Vorderfläche der farbgebenden Deckplatte mindestens einen strukturierten Bereich aufweist, wobei keine weitere Farbfilterschicht auf der Vorderfläche der farbgebenden Deckplatte angeordnet ist. Die Rückfläche ist vorzugsweise glatt (im Rahmen der Produktionsungenauigkeiten). Für die Segmente des strukturierten Bereichs der Vorderfläche des plattenförmigen Bauteils gibt es keine Bedingung für die Rauigkeit. Die strukturierte Vorderfläche kann auch eine größere mikroskopische Rauigkeit aufweisen. An dieser Grenzfläche findet nur Transmission, Brechung und Streuung, jedoch keine Interferenz statt. Bei dieser Ausgestaltung des erfindungsgemäßen plattenförmigen Bauteils kann es vorteilhaft sein, wenn die Vorderfläche der farbgebenden Deckplatte mit einer (z.B. dünnen) Antireflexschicht beschichtet ist, deren optischer Brechungsindex kleiner ist als jener der farbgebenden Deckplatte. Hierdurch kann eine im Wesentlichen unbunte Reflexion der farbgebenden Deckplatte (z.B. Glas) unterdrückt werden und der Sättigungsgrad der Farben steigt. Eine zusätzliche Schicht auf der Vorderfläche der Deckplatte kann aber auch den gleichen Brechungsindex wie die Deckplatte aufweisen. In diesem Fall dient die Schicht nur dem Schutz der farbgebenden Deckplatte vor Feuchte und anderen korrosiven Bestandteilen der Luft. Es hat sich gezeigt, dass durch Ätzen hergestellte satinierte Gläser empfindlicher gegenüber feuchter Hitze sind als plane oder gewalzte Gläser. Im Falle von geätztem Kalknatronglas kann die zusätzliche Schicht zum Beispiel eine dünne gesputterte SiO₂-Schicht sein.

Bei vorstehender Ausgestaltung vom Typ II kann es weiterhin vorteilhaft sein, wenn auf der Rückfläche der farbgebenden Deckplatte eine Farbfilterschicht angeordnet ist, wobei die Rückfläche der farbgebenden Deckplatte mindestens einen strukturierten Bereich aufweist und die Vorderfläche mindestens einen strukturierten Bereich aufweist, wobei keine weitere Farbfilterschicht auf der Vorderfläche der farbgebenden Deckplatte angeordnet ist. Der strukturierte Bereich der Rückfläche und der strukturierte Bereich der Vorderfläche der farbgebenden Deckplatte können gleich oder voneinander verschieden sein. Für die Segmente des strukturierten Bereichs der Vorderfläche gibt es keine Bedingung für die Rauigkeit. Die strukturierte Vorderfläche kann auch größere mikroskopische Rauigkeit aufweisen. An dieser Grenzfläche findet nur Transmission, Brechung und Streuung, jedoch keine Interferenz statt. Für die Segmente des strukturierten Bereichs der Rückfläche gilt die oben genannten Bedingung für die Rauigkeit, da eine Farbfilterschicht auf dem strukturierten Bereich angeordnet ist. Wenn die Vorderfläche strukturiert ist und die Farbfilterschicht auf der Rückfläche liegt, entsteht die Winkelstabilität daraus, dass das Licht beim Eintritt durch die strukturierte Vorderfläche an den unterschiedlich geneigten Segmenten gebrochen wird, in verschiedenen Winkeln auf die Farbfilterschicht trifft und nach Interferenz, partieller Absorption und Reflexion ein weiteres Mal die strukturierte Vorderfläche beim Austritt aus der farbgebenden Deckplatte passiert und dabei wiederum durch Brechung seine Richtung ändert.

Bei vorstehender Ausgestaltung vom Typ II des plattenförmigen Bauteils kann es weiterhin vorteilhaft sein, wenn auf der Rückfläche der farbgebenden Deckplatte eine Farbfilterschicht angeordnet ist, wobei die Rückfläche der farbgebenden Deckplatte mindestens einen strukturierten Bereich aufweist und die Vorderfläche der farbgebenden Deckplatte keinen strukturierten Bereich aufweist, wobei keine weitere Farbfilterschicht auf der Vorderfläche der farbgebenden Deckplatte angeordnet ist. Die Vorderfläche ist vorzugsweise glatt (im Rahmen von Produktionsungenauigkeiten). Für die Segmente des strukturierten Bereichs der Rückfläche gilt die oben genannten Bedingung für die Rauigkeit, da eine Farbfilterschicht auf dem strukturierten Bereich angeordnet ist. Bei dieser Ausgestaltung des erfindungsgemäßen plattenförmigen Bauteils kann es vorteilhaft sein, wenn die Vorderfläche der farbgebenden Deckplatte mit einer (z.B. dünnen) Antireflexschicht beschichtet ist, deren Brechungsindex kleiner ist als jener der Deckplatte. Hierdurch kann eine im Wesentlichen weiße Reflexion einer gläsernen Deckplatte unterdrückt werden und der Sättigungsgrad der Farben steigt.

Bei vorstehender Ausgestaltung vom Typ II kann es weiterhin vorteilhaft sein, wenn die Rückfläche der farbgebenden Deckplatte mindestens einen strukturierten Bereich aufweist und die Vorderfläche keinen strukturierten Bereich aufweist, wobei eine weitere Farbfilterschicht auf der Vorderfläche der farbgebenden Deckplatte angeordnet ist. Die Vorderfläche ist vorzugsweise glatt (im Rahmen von Produktionsungenauigkeiten). Für die Segmente des strukturierten Bereichs der Rückfläche gilt die oben genannten Bedingung für die Rauigkeit, da eine Farbfilterschicht auf dem strukturierten Bereich angeordnet ist. Die beiden Farbfilterschichten können gleich oder voneinander verschieden sein. Insbesondere können die beiden Farbfilterschichten zur Reflexion von Licht innerhalb eines selben Wellenlängenbereichs ausgebildet sein. Möglich ist jedoch auch, dass die beiden Farbfilterschichten zur Reflexion von Licht innerhalb verschiedener oder nur teilweise überlappender Wellenlängenbereiche ausgebildet sind. Die Farbfilterschicht auf der glatten Außenseite kann auch eine farbneutrale Antireflexschicht sein, um den Weißanteil des insgesamt reflektierten Lichtes zu reduzieren. Die Farbe wird durch Reflexion an der strukturierten Innenseite mit der Farbfilterschicht erzeugt. Die Farbfilterschicht an der glatten Außenseite kann aber auch eine farbgebende Schicht sein, die die an der Innenseite generierte Farbe verstärkt oder eine weitere Farbkomponente in einem anderen Wellenlängenbereich dazu mischt.

Das einfallende Licht muss demnach mindestens einmal die farbgebende Deckplatte passieren und muss an der innenliegenden Farbfilterschicht reflektiert werden, um nach Austritt aus der Vorderfläche der farbgebenden Deckplatte die gewünschte Farbigkeit mit der verbesserten Winkelstabilität zu erreichen.

In dem erfindungsgemäßen plattenförmigen Bauteil wird durch die strukturierte Deckplatte Licht mit einer hohen Intensität und geringer Winkelabhängigkeit auch außerhalb des Glanzwinkels reflektiert. Durch die mindestens eine Farbfilterschicht, welche farbgebend wirkt, wird ein sehr homogener Farbeindruck erzeugt.

Bei einer vorteilhaften Ausgestaltung des erfindungsgemäßen plattenförmigen Bauteils setzen sich mindestens 80%, besonders bevorzugt mindestens 90%, eines strukturierten Bereichs der Vorderfläche oder der Rückfläche (je nachdem welche Fläche strukturiert ist) der farbgebenden Deckplatte aus den zur Ebene der farbgebenden Deckplatte geneigten Segmenten zusammen. Durch die Vergrößerung der Anzahl der Segmente kann die Intensität des vom strukturierten Bereich der Oberfläche der farbgebenden Deckplatte auch außerhalb des Glanzwinkels reflektierten Lichts und dessen Winkelstabilität noch weiter gesteigert werden.

Bei einer vorteilhaften Ausgestaltung des erfindungsgemäßen plattenförmigen Bauteils liegen die Neigungswinkel der (Oberflächen-)Segmente zwischen 0° und 45° zur Ebene der Deckplatte (Glasebene). Mindestens 50 %, besser 70 % der geneigten Segmente sollten einen Anstellwinkel von kleiner 25° haben. Die Verteilung der Anstellwinkel sollte im Winkelbereich von 0° - 35°, bevorzugt 0° - 25°, ein Häufigkeitsmaximum aufweisen, welches im Bereich von 5° - 25°, bevorzugt zwischen 10° und 20°, liegt. Weiterhin sollte der Anteil ungeneigter Flächen (Anstellwinkel = 0°) kleiner als 5 % an der gesamten Winkelverteilung sein.

Bei einer vorteilhaften Ausgestaltung des erfindungsgemäßen plattenförmigen Bauteils ist das Aspektverhältnis von Breite (B) zu Höhe (H) der Strukturen (Segmente) mindestens B:H > 2:1 und B:H < 50:1, besser B:H > 3:1 und B:H < 10:1.

Bei einer weiteren vorteilhaften Ausgestaltung des erfindungsgemäßen plattenförmigen Bauteils haben mindestens 30% der Segmente mindestens eines strukturierten Bereichs einen Neigungswinkel im Bereich von größer als 0° bis maximal 15°, mindestens 40% der Segmente einen Neigungswinkel im Bereich von größer als 15° bis maximal 45° und vorzugsweise, jedoch nicht zwingend, weniger als 10% der Segmente einen Neigungswinkel von größer als 45°. Falls relativ viele Facetten mit einem kleinen Neigungswinkel von weniger als 10° vorliegen, tritt (wie bei einer unstrukturierten Oberfläche) im Wesentlichen nur eine reflektierte Intensität bei einem Beobachtungswinkel nahe des Glanzwinkels auf, was erfindungsgemäß nicht erwünscht ist. Gemäß vorstehenden Bedingungen kann eine sehr hohe Intensität des reflektierten Lichts auch außerhalb des Glanzwinkels bei zugleich besonders geringer Winkelabhängigkeit der Intensität erreicht werden. Die Strukturen sind bevorzugt nicht-periodisch und anisotrop. Für spezielle optische Effekte können jedoch auch periodische Strukturen und/oder anisotrope Strukturen zur Anwendung kommen. Periodische und anisotrope Strukturen wie Pyramiden, tetragonale oder hexagonale Wabenstrukturen oder Halbkugeln lassen sich gut mit Walzen beim Glasziehen herstellen. Sie können zu attraktiven Glanz- und Farbeffekten verwendet werden. Wenn die Oberflächenstrukturen die oben genannten Bedingungen erfüllen, zeigen die plattenförmigen Bauteile wiederum eine deutlich verringerte Abnahme der Farbigkeit für Winkel außerhalb der Glanzwinkel, jedoch sind die Winkelabhängigkeiten dann anisotrop in Bezug auf die Orientierung in der Ebene der Deckplatte.

Die mindestens eine Farbfilterschicht kann eine oder mehrere Brechungsschichten enthalten und insbesondere aus diesen bestehen. Eine Brechungsschicht besteht aus einem selben Material (mit gleicher Zusammensetzung) und weist insbesondere über die Schichtdicke hinweg einen homogenen (gleichen) Brechungsindex auf. Enthält die Farbfilterschicht mehrere Brechungsschichten, bestehen mindestens zwei Brechungsschichten aus einem voneinander verschiedenen Material und haben einen unterschiedlichen Brechungsindex.

Die mindestens eine Farbfilterschicht enthält mindestens eine Brechungsschicht aus einem hochbrechenden und teiltransparenten Material, im Weiteren als "hochbrechende Brechungsschicht", abgekürzt "HTM", bezeichnet. Die hochbrechende Brechungsschicht (HTM) besteht aus einem Material mit einem Brechungsindex n von größer als 2,5 im Wellenlängenbereich von 400 nm bis mindestens 700 nm und einen Extinktionskoeffizienten von mindestens 0,2 unterhalb von 450 nm und kleiner als 0,2, vorzugsweise kleiner als 0,1, oberhalb von 700 nm. Dies ermöglicht in besonders vorteilhafter Weise die Herstellung von farbigen plattenförmigen Bauteilen mit einer weißen oder roten Farbe, wobei jedoch auch andere Farben möglich sind.

Gemäß einer vorteilhaften Ausgestaltung des erfindungsgemäßen plattenförmigen Bauteils hat die mindestens eine hochbrechende Brechungsschicht im Hinblick auf die Erzeugung einer weißen oder roten Farbe des plattenförmigen Bauteils einen Extinktionskoeffizienten von kleiner als 0,2, vorzugsweise kleiner als 0,1 oberhalb von 500 nm.

Gemäß einer weiteren vorteilhaften Ausgestaltung des erfindungsgemäßen plattenförmigen Bauteils hat die mindestens eine hochbrechende Brechungsschicht im Hinblick auf die Erzeugung einer weißen oder roten Farbe des plattenförmigen Bauteils einen Brechungsindex n von größer als 3,0, vorzugsweise größer als 3,5, im Wellenlängenbereich von 400 nm bis mindestens 700 nm.

Gemäß einer weiteren vorteilhaften Ausgestaltung des erfindungsgemäßen plattenförmigen Bauteils hat die mindestens eine hochbrechende Brechungsschicht im Hinblick auf die Erzeugung einer weißen oder roten Farbe des plattenförmigen Bauteils eine Schichtdicke im Bereich von 5 nm bis 300 nm, vorzugsweise im Bereich von 5 nm bis 40 nm.

Gemäß einer weiteren vorteilhaften Ausgestaltung des erfindungsgemäßen plattenförmigen Bauteils hat die mindestens eine hochbrechende Brechungsschicht im Hinblick auf die Erzeugung einer weißen Farbe des plattenförmigen Bauteils einen Brechungsindex n von größer als 3,0, vorzugsweise größer als 3,5, im Wellenlängenbereich von 400 nm bis mindestens 700 nm und eine Schichtdicke im Bereich von 5 nm bis 40 nm.

Beispielsweise enhält die hochbrechende Brechungsschicht mindestens ein Material, gewählt aus: kristallines oder mikrokristallines Si, amorphes a-Si:H (amorphes Wasserstoff-passiviertes Silizium), a-SiC:H (amorphes Wasserstoff-passiviertes siliziumreiches Siliziumcarbid), a-SiO:H (amorphes Wasserstoff-passiviertes siliziumreiches Siliziumoxid), a-SiGe:H, silziumreiches SiₓN_{y}, siliziumreiches SiₓN_{y}O_{z} (y>z), Cu₂O und Fe₂O₃. Die hochbrechende Brechungsschicht kann auch aus dem gewählten mindestens einen Material bestehen.

Gemäß einer weiteren vorteilhaften Ausgestaltung des erfindungsgemäßen plattenförmigen Bauteils weist die mindestens eine Farbfilterschicht mindestens eine Brechungsschicht aus einem transparenten dielektrischen Material mit einem Brechungsindex von kleiner als 2,5 auf, im Weiteren als "niedrigbrechende Brechungsschicht", abgekürzt "TD", bezeichnet.

Beispielsweise enthält die niedrigbrechende Brechungsschicht (TD) mindestens eine Verbindung, gewählt aus ZrOₓ, SiC, Si₃N₄, MgF₂, Al₂O₃, SiO₂ und Siliziumoxinitrid. Dies sind Verbindungen mit einem relativ niedrigen Brechungsindex. Die niedrigbrechende Brechungsschicht kann auch aus der gewählten mindestens einen Verbindung bestehen.

Gemäß einer vorteilhaften Ausgestaltung des erfindungsgemäßen plattenförmigen Bauteils hat die mindestens eine niedrigbrechende Brechungsschicht eine Schichtdicke von größer als 10 nm und kleiner als 250 nm.

Gemäß einer weiteren vorteilhaften Ausgestaltung des erfindungsgemäßen plattenförmigen Bauteils weist die mindestens eine Farbfilterschicht eine Doppelschicht aus einer hochbrechenden Brechungsschicht und einer niedrigbrechenden Brechungsschicht auf.

Gemäß einer weiteren vorteilhaften Ausgestaltung des erfindungsgemäßen plattenförmigen Bauteils weist die mindestens eine Farbfilterschicht eine Dreifachschicht auf, bei welche r eine hochbrechende Brechungsschicht zwischen zwei niedrigbrechenden Brechungsschichten angeordnet ist, oder eine niedrigbrechende Brechungsschicht zwischen zwei hochbrechenden Brechungsschichten angeordnet ist.

Gemäß einer weiteren vorteilhaften Ausgestaltung des erfindungsgemäßen plattenförmigen Bauteils weist die mindestens eine Farbfilterschicht eine Vierfachschicht auf, bei welcher zwei hochbrechende Brechungsschichten und zwei niedrigbrechende Brechungsschichten in alternierender Abfolge angeordnet sind, wobei eine hochbrechende Brechungsschicht zwischen zwei niedrigbrechenden Brechungsschichten angeordnet ist und eine niedrigbrechende Brechungsschicht zwischen zwei hochbrechenden Brechungsschichten angeordnet ist.

Gemäß einer weiteren vorteilhaften Ausgestaltung des erfindungsgemäßen plattenförmigen Bauteils ist die mindestens eine Farbfilterschicht so ausgebildet, dass
- ein elektrischer Widerstand bei einer Spannung von 1000 V und einem Messelektrodenabstand von 2 cm bei Tageslicht nicht unter 10 GOhm, vorzugsweise nicht unter 100 GOhm, liegt, und
- ein spezifischer Dunkelwiderstand über 10¹⁰ Ωcm, vorzugsweise über 10¹¹ Ωcm, liegt.

Im mindestens einen strukturierten Bereich der farbgebenden Deckplatte tritt eine Reflexion der einfallenden Lichtstrahlung auch außerhalb des Glanzwinkels mit relativ hoher Intensität auf. Der strukturierte Bereich ist zu diesem Zweck vorzugsweise so ausgebildet, dass ein Reflexions-Haze von mehr als 50%, besonders bevorzugt mehr als 90%, vorliegt. Der Reflexions-Haze lässt sich durch ein im Handel verfügbares Haze-Messgerät bestimmen. Nach ASTM D1003 ist Haze das Verhältnis aus diffusem Anteil des reflektierten Lichts zur Gesamtreflexion.

In dem erfindungsgemäßen plattenförmigen Bauteil ist mindestens eine Zone vorgesehen sein, in der die Segmente eine mittlere Rauigkeit von weniger als 15% der Schichtdicke der Farbfilterschicht auf der Vorderfläche haben, wodurch eine konstruktive bzw. destruktive Interferenz des reflektierten Lichts ermöglicht ist. Vorteilhaft erstreckt sich diese Zone über die gesamte farbgebende Deckplatte. Gemäß einer Ausgestaltung weist der strukturierte Bereich mindestens eine weitere Zone, d.h. (Teil-)Bereich, auf, in dem die Segmente jeweils eine solche mittlere Rauigkeit aufweisen, dass eine Interferenz an der Farbfilterschicht nicht auftritt. Beispielsweise haben die Segmente dort eine mittlere Rauigkeit von 50% bis 100% der Schichtdicke der Farbfilterschicht. In diesen Zonen weist das plattenförmige Bauteil keine durch die Farbfilterschicht erzeugte Farbe auf.

Die verschiedenen Ausgestaltungen der Erfindung können einzeln oder in beliebigen Kombinationen realisiert sein. Insbesondere sind die vorstehend genannten und nachstehend zu erläuternden Merkmale nicht nur in den angegebenen Kombinationen, sondern auch in anderen Kombinationen oder in Alleinstellung einsetzbar, ohne den Rahmen der vorliegenden Erfindung zu verlassen.

Die Erfindung wird im Weiteren näher erläutert, wobei Bezug auf die beigefügten Zeichnungen genommen wird. Es zeigen in vereinfachter, nicht maßstäblicher Darstellung:
- Fig. 1-4: verschiedene Ausgestaltungen des erfindungsgemäßen plattenförmigen Bauteils in schematischen Querschnittansichten;
- Fig. 5-6: verschiedene Diagramme zur Charakterisierung eines Frontglases;

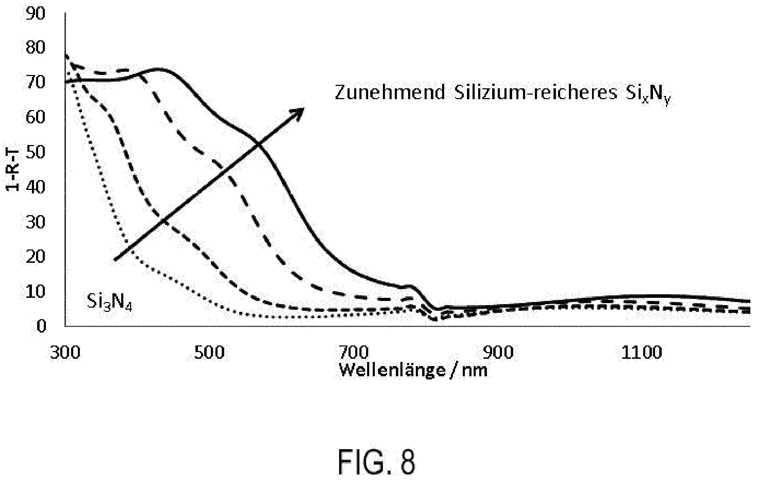

- Fig. 7-8: Reflexions- und Absorptionsspektren von zunehmend silzium-reicheren SiₓN_{y}-Schichten auf planem Floatglas;
- Fig. 9: eine schematische Querschnittansicht der farbgebenden Deckplatte gemäß einer Ausgestaltung des erfindungsgemäßen plattenförmigen Bauteils;
- Fig. 10: eine schematische Darstellung typischer Lichtverhältnisse an einem erfindungsgemäßen plattenförmigen Bauteil;
- Fig. 11-14: schematische Darstellungen beispielhafter Lichtwege bei Reflexion im strukturierten Bereich der farbgebenden Deckplatte von Figur 9;
- Fig. 15: eine schematische Darstellung der Interferenz von Lichtstrahlen in einer Farbfilterschicht;
- Fig. 16-17: weitere Ausgestaltungen der farbgebenden Deckplatte des erfindungsgemäßen plattenförmigen Bauteils in schematischen Querschnittansichten;
- Fig. 18: ein schematische Darstellung beispielhafter Lichtwege bei Reflexion an der farbgebenden Deckplatte;
- Fig. 19-20: weitere Ausgestaltungen der farbgebenden Deckplatte des erfindungsgemäßen plattenförmigen Bauteils in schematischen Querschnittansichten;
- Fig. 21: eine schematische Darstellung beispielhafter Lichtwege bei Reflexion im strukturierten Bereich des plattenförmigen Bauteils von Figur 20;
- Fig. 22: eine weitere Ausgestaltung der farbgebenden Deckplatte des erfindungsgemäßen plattenförmigen Bauteils in einer schematischen Querschnittansicht;
- Fig. 23: eine schematische Darstellung beispielhafter Lichtwege bei Reflexion an der farbgebenden Deckplatte des plattenförmigen Bauteils von Figur 22;
- Fig. 24-25: weitere Ausgestaltungen der farbgebenden Deckplatte des erfindungsgemäßen plattenförmigen Bauteils in schematischen Querschnittansichten;
- Fig. 26: eine schematische Darstellung des Messverfahrens zur Mehrwinkel-Farbmessung.

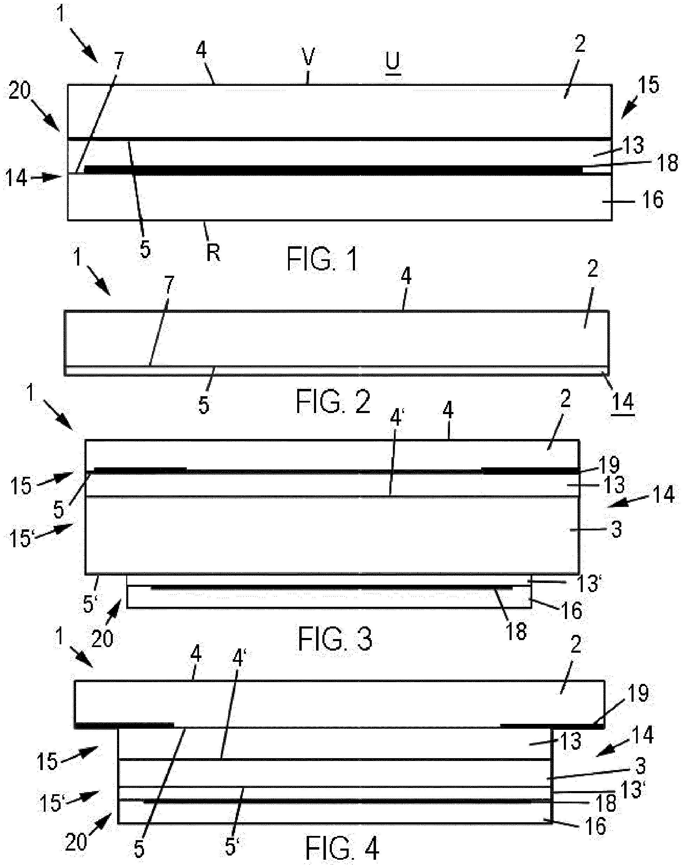

In den Figuren 1 bis 4 sind verschiedenen Ausgestaltungen eines insgesamt mit der Bezugszahl 1 bezeichneten plattenförmigen Bauteils in schematischer Weise anhand von Querschnittansichten (Schnitt senkrecht zur Oberfläche des plattenförmigen Bauteils) veranschaulicht. Das plattenförmige Bauteil 1 dient beispielsweise zum Einbau in eine Fassade. Die Fassade kann dabei die Außenhaut eines Gebäudes sein oder auch die Verkleidung anderer Bauwerke wie Lärmschutzwände, Sichtschutzwände, Brücken, oder Türme. Das plattenförmigen Bauteil kann auch als ein farbiges Solarmodul gestaltet werden, das auf Dächer oder Freiflächenanlagen montiert wird.

Das plattenförmige Bauteil 1 umfasst eine transparente farbgebende Deckplatte 2 und ein Rückseitenelement 14, das mit der Deckplatte 2 fest verbunden ist. Die Deckplatte 2 ist beispielsweise eine Glasscheibe und besteht aus einem Glas, das vorzugsweise eine geringe Absorption aufweist, wie zum Beispiel Kalknatronglas. Die Deckplatte 2 ist zur Farbgebung des plattenförmigen Bauteils 1 mit mindestens einem strukturierten Bereich und mindestens einer Farbfilterschicht versehen, wie weiter unten eingehend erläutert wird.

In der Ausgestaltung von Figur 1 ist das plattenförmige Bauteil 1 ein fotovoltaisch aktives plattenförmiges Bauteil 1, das zur Energieerzeugung aus Sonnenlicht geeignet und bestimmt ist. Das plattenförmige Bauteil 1 ist in Form eines Solarmoduls 20 ausgebildet. Das plattenförmige Bauteil 1 umfasst, neben der Deckplatte 2, ein hier beispielsweise gläsernes Trägersubstrat 16 (Glasscheibe), auf dem eine Mehrzahl seriell verschalteter Solarzellen 18 ausgebildet sind. Das Trägersubstrat 16 ist mit der Deckplatte 2 durch eine Zwischenschicht 13 fest verbunden (z.B. durch Lamination). Die Deckplatte 2 bildet mit dem Trägersubstrat 16 eine Verbundscheibe 15 aus. Die Zwischenschicht13 ist vorzugsweise eine thermoplastische oder vernetzende Polymer-Zwischenschicht (z.B. PVB oder EVA). Vorzugsweise handelt es sich bei den Solarzellen 18 um Dünnschicht-Solarzellen, bei denen die fotovoltaisch aktive Absorberschicht aus einem Chalkopyrit-Halbleiter, insbesondere aus einem ternären I-III-VI-Verbindungshalbleiter aus der Gruppe Kupfer-Indium/Gallium-Disulfid/Diselenid (Cu(In,Ga)(S,Se)₂) besteht.

Das plattenförmige Bauteil 1 hat eine Vorderseite V, welche von der äußeren Umgebung her betrachtet werden soll (Seite des Lichteinfalls), sowie eine Rückseite R. Als äußere Umgebung wird im Sinne der vorliegenden Erfindung der Umgebungsbereich U der Vorderseite V des plattenförmigen Bauteils 1 betrachtet (in den Figuren 1 bis 4 jeweils der Umgebungsbereich, der sich oberhalb des plattenförmigen Bauteils 1 befindet).

Die farbgebende Deckplatte 2 umfasst eine der äußeren Umgebung U zugewandte Vorderfläche 4 und gegenüberliegend eine von der äußeren Umgebung U abgewandte Rückfläche 5. Im Sinne vorliegender Erfindung werden Flächen als "Vorderflächen" bezeichnet, wenn sie der äußeren Umgebung U zugewandt sind. Entsprechend werden Flächen als "Rückflächen" bezeichnet, wenn sie von der äußeren Umgebung U abgewandt sind.

In Figur 2 ist eine Ausgestaltung gezeigt, bei der das plattenförmige Bauteil 1 ein fotovoltaisch passives plattenförmiges Bauteil 1 ist. Hierbei ist die Deckplatte 2 mit einem opaken Rückseitenelement 14 fest verbunden. Das Rückseitenelement 14 ist hier beispielsweise als vollflächige Beschichtung der Rückfläche 5 der Deckplatte 2 ausgebildet. Gleichermaßen kann das Rückseitenelement 2 beispielsweise in Form einer mit der Rückfläche 5 der Deckplatte 2 fest verbundenen Folie, insbesondere einer opaken Folie, oder eines starren Körpers, insbesondere eines opaken starren Körpers, beispielsweise in Plattenform, ausgebildet sein.

In Figur 3 ist eine Ausgestaltung gezeigt, bei der das plattenförmige Bauteil 1 ein fotovoltaisch aktives plattenförmiges Bauteil 1 ist. Das plattenförmige Bauteil 1 umfasst eine Deckplatte 2 und eine mechanisch unterstützende Scheibe 3, welche durch eine Zwischenschicht 13 fest miteinander verbunden sind (z.B. durch Lamination). Die Deckplatte 2 und die mechanisch unterstützende Scheibe 3 sind beispielsweise Glasscheiben und bestehen aus einem Glas, das vorzugsweise eine geringe Absorption aufweist, wie zum Beispiel Kalknatronglas. Hierdurch wird eine Verbundscheibe 15 gebildet. Die beiden Scheiben 2, 3 bestehen je nach baulichen Anforderungen vorzugsweise aus veredeltem Glas, wie beispielsweise thermisch gehärtetes Glas, so genanntes Einscheibensicherheitsglas (ESG), oder teilvorgespanntes Glas (TVG).

Die mechanisch unterstützende Scheibe 3 dient zum mechanischen Unterstützen (d.h. Verstärken) der farbgebenden Deckplatte 2 und trägt wesentlich zur mechanischen Stabilität des plattenförmigen Bauteils 1 bei, so dass es auch größeren Windlasten standhalten kann.

In der in Figur 3 gezeigten Ausgestaltung ist die farbgebende Deckplatte 2 dünner als die mechanisch unterstützende Scheibe 3. Beispielsweise weist die Deckplatte eine Scheibendicke im Bereich von 2 - 4 mm auf. Die mechanisch unterstützende Scheibe 3 ist dicker als die Deckplatte 2 und weist beispielsweise eine Scheibendicke von mehr als 4 mm auf.

Die mechanisch unterstützende Scheibe 3 weist eine Vorderfläche 4' und eine Rückfläche 5' auf. Die Rückfläche 5' ist mit einem Trägersubstrat 16 direkt, d.h. ohne zwischenliegende Scheibe, durch eine weitere Zwischenschicht 13' fest verbunden (z.B. durch Lamination). Die mechanisch unterstützende Scheibe 3 bildet mit dem Trägersubstrat 16 somit eine weitere Verbundscheibe 15'. Insgesamt ergibt sich eine Verbundscheibenstruktur, bei der drei Scheiben durch Lamination fest miteinander verbunden sind. Die weitere Zwischenschicht13' ist vorzugsweise eine thermoplastische oder vernetzende Polymer-Zwischenschicht (z.B. PVB oder EVA).

In Figur 4 ist eine Variante zu Figur 3 gezeigt, welche sich von der Ausgestaltung von Figur 3 dadurch unterscheidet, dass die mechanisch unterstützende Scheibe 3 dünner ist als die Deckplatte 2. Zudem ist die mechanisch unterstützende Scheibe 3 kleiner als die Deckplatte 2 und entspricht in ihren Dimensionen dem Trägersubstrat 16. Die mechanisch unterstützende Scheibe 3 ist hier in Form einer Deckplatte für das Trägersubstrat 16 mit Solarzellen 18 ausgebildet. Bei der Herstellung des plattenförmigen Bauteils 1 kann ein Solarmodul 20, welches die mechanisch unterstützende Scheibe 3 als Deckplatte und das Trägersubstrat 16 mit Solarzellen 18 umfasst, mit der Deckplatte 2 laminiert werden. Dies kann verfahrenstechnisch vorteilhaft sein, da das Solarmodul 20 vorfertigbar ist. Das Rückseitenelement 14 entspricht dann dem kompletten Solarmodul 20. Die Größe des Solarmoduls 20 in der Ebene des Trägersubstrats 16 ist kleiner als jene der Deckplatte 2, so dass das Solarmodul 20 gut gegen äußere Einflüsse geschützt ist. Möglich wäre auch, die Deckplatte 2 als Frontglas des Solarmoduls 20 auszubilden (mit entsprechend gleicher Größe wie das Trägersubstrat 16), und das Solarmodul 20 dann mit der frontseitig angeordneten, mechanisch unterstützenden zweiten Scheibe 3 fest zu verbinden.

In den Ausgestaltungen der Figuren 3 und 4 ist eine Maskierungsschicht 19 hinter der letzten Farbfilterschicht (siehe unten), d.h. hinter der farbgebenden Deckplatte 2 angeordnet. In Figur 3 und 4 ist die Maskierungsschicht 19 jeweils auf der Rückfläche 5 der Deckplatte 2 aufgebracht. Die Maskierungsschicht 19 bedeckt die Rückfläche 5 nur teilweise, wobei die fotovoltaisch inaktiven Bereiche überdeckt werden. Die fotovoltaisch aktiven Bereiche der Solarzellen 18 werden nicht überdeckt. Dies verbessert die äußere Erscheinung des plattenförmigen Bauteils 1.

Je nach Ausgestaltung des plattenförmigen Bauteils 1 ist die Vorderfläche 4 und/oder die Rückfläche 5 der farbgebenden Deckplatte 2 strukturiert (z.B. durch Ätzung, Sandstrahlen oder Walzen beim Ziehprozess) und weist mindestens eine Farbfilterschicht auf, was in den Figuren 1 bis 4 nicht dargestellt ist. Dies wird im Weiteren näher erläutert.

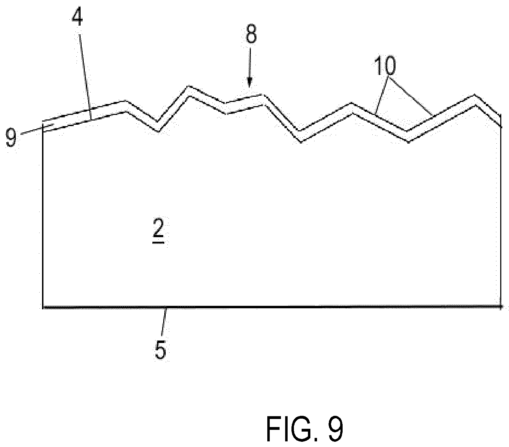

In Figur 9 ist eine Ausgestaltung des erfindungsgemäßen plattenförmigen Bauteils 1 veranschaulicht, wobei lediglich die farbgebende Deckplatte 2 mit einer beispielhaften Strukturierung gezeigt ist. Das plattenförmige Bauteil 1 kann insbesondere wie in den Figuren 1 bis 4 ausgebildet sein. Demnach ist die Vorderfläche 4 der farbgebenden Deckplatte 2 in einem Bereich 8 strukturiert, welcher sich im vorliegenden Beispiel über die komplette Vorderfläche 4 erstreckt, d.h. Vorderfläche 4 und strukturierter Bereich 8 sind identisch. Unmittelbar auf der Vorderfläche 4 ist eine Farbfilterschicht 9 angeordnet. Im strukturierten Bereich 8 ist die Vorderfläche 4 mit einem Höhenprofil versehen, das Berge und Täler aufweist. Hierbei bestehen mehr als 50% der Vorderfläche 4 aus ebenen Segmenten 10, deren Ebenen jeweils zur Ebene der farbgebenden Deckplatte 2 geneigt sind, d.h. einen von Null verschiedenen Winkel zur Ebene der farbgebenden Deckplatte 2 aufweisen. Die Segmente 10 haben jeweils eine Segmentfläche von mindestens 1 µm² und eine mittlere Rauigkeit von weniger als 15% der Schichtdicke d der Farbfilterschicht 9. Ein mittlerer Höhenunterschicht zwischen den höchsten Punkten (Berge) und niedrigsten Punkten (Täler) der Vorderfläche 4 beträgt mindestens 2 µm und beispielsweise maximal 20% der Dicke der farbgebenden Deckplatte 2. Bezogen auf die Ebene der farbgebenden Deckplatte 2 haben mindestens 20% der Segmente einen Neigungswinkel im Bereich von größer als 0° bis maximal 15°, mindestens 30% der Segmente einen Neigungswinkel im Bereich von größer als 15° bis maximal 45° und weniger als 30% der Segmente 10 einen Neigungswinkel von größer als 45°. Im Ausführungsbeispiel von Figur 9 haben alle Segmente einen Neigungswinkel von maximal 45°.

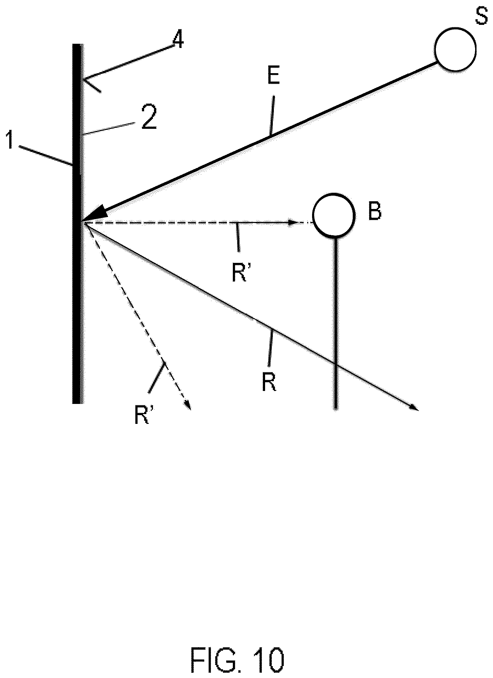

Im Weiteren wird die Funktionsweise der Strukturierung der Vorderfläche 4 der farbgebenden Deckplatte 2 näher beschrieben. Sei zunächst Figur 10 betrachtet, worin beispielhaft typische Lichtverhältnisse bei einem plattenförmigen Bauteil 1 veranschaulicht sind. Demnach trifft Licht von der Sonne S direkt auf die farbgebende Deckplatte 2 und wird im Glanzwinkel reflektiert. Der einfallende Lichtstrahl E und der im Glanzwinkel reflektierte Lichtstrahl R sind gezeigt. Neben dem reflektierten Lichtstrahl R wird das einfallende Licht auch außerhalb des Glanzwinkels diffus gestreut. Zwei diffus gestreute Lichtstrahlen R' sind beispielhaft gezeigt. Der Farbeffekt entsteht durch Reflexion, Streuung und Interferenz. Steht ein Beobachter B vor dem plattenförmigen Bauteil 1 (zum Beispiel eine Fassade) und blickt senkrecht auf die farbgebende Deckplatte 2 vor ihm, trifft sein Auge nur in den seltensten Fällen das direkt reflektierte Licht R (d.h. der Beobachter steht meist nicht im Glanzwinkel). Dies ist in Figur 10 veranschaulicht, wo sich der Beobachter B außerhalb des Glanzwinkels befindet und nur den diffus gestreuten Lichtstrahl R' sieht. Bei einer glatten Oberfläche ohne strukturierten Bereich 8 ist die Intensität des diffus gestreuten Lichts R' relativ gering und weist eine starke Winkelabhängigkeit auf. Erst wenn der diffus gestreute Anteil ausreichend groß ist, gibt es eine deutliche Farbe mit zufriedenstellender Intensität (Helligkeit, L-Wert).

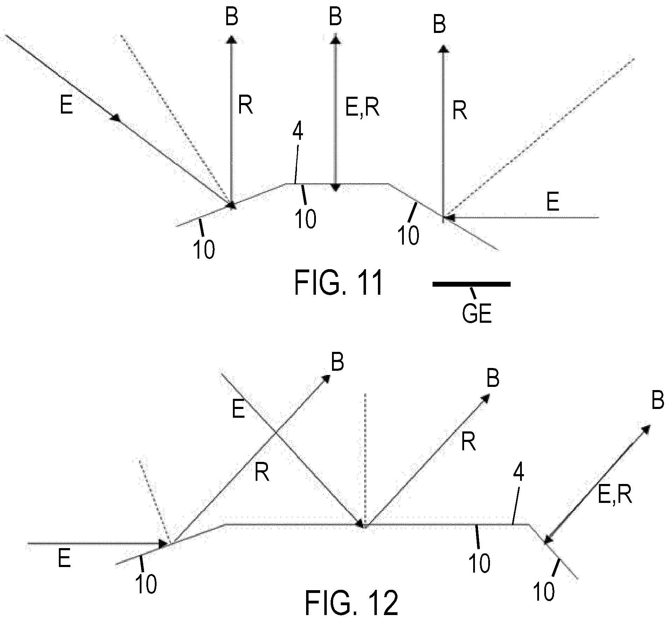

Das Grundprinzip der Wirkungsweise der geneigten Segmente 10 des strukturierten Bereichs 8 ist in Figur 11 veranschaulicht, worin beispielhaft die verschiedenen Lichtwege für einen Beobachter B gezeigt sind, der senkrecht auf die Glasoberfläche bzw. Vorderfläche 4 des plattenförmigen Bauteils 1 blickt. Gezeigt sind drei Segmente 10 mit verschiedenen Neigungen zur schematisch veranschaulichten Ebene GE der farbgebenden Deckplatte 2, sowie die auf die Segmente 10 treffenden Lichtstrahlen E, die von den Segmenten 10 jeweils im lokalen Glanzwinkel zum Beobachter B reflektiert werden (reflektierte Lichtstrahlen R). Das mittlere Segment 10 ist parallel zur Ebene GE angeordnet, wobei der einfallende Lichtstrahl E senkrecht auf das Segment 10 trifft und senkrecht zum Beobachter B reflektiert wird (reflektierter Strahl R). Für das mittlere Segment 10 sind Glanzwinkel und lokaler Glanzwinkel identisch. Bei den beiden angrenzenden Segmenten 10 haben die einfallenden Lichtstrahlen E jeweils einen von Null verschiedenen Winkel zur Oberflächennormalen auf die Ebene GE und treffen ebenfalls im lokalen Glanzwinkel auf den Beobachter B. Aufgrund der unterschiedlichen Neigungen der Segmente 10 wird Licht aus verschiedenen Richtungen jeweils im lokalen Glanzwinkel der Segmente 10 zu dem senkrecht auf die Modulfläche blickenden Beobachter B reflektiert. Im Ausführungsbeispiel von Figur 11 betragen Ein- und Ausfallswinkel maximal 45°.

In Figur 12 ist eine Situation gezeigt, bei der der Beobachter B in einem Winkel von 45° zur Oberflächennormalen auf die Ebene GE der farbgebenden Deckplatte 2 sieht. Wie in Figur 11 sind beispielhaft drei Segmente 10 mit verschiedenen Neigungen zur Ebene GE der farbgebenden Deckplatte 2 gezeigt, sowie die jeweils auf die Segmente 10 treffenden Lichtstrahlen E, die von den Segmenten 10 im lokalen Glanzwinkel zum Beobachter B reflektiert werden (reflektierte Lichtstrahlen R). Aufgrund der unterschiedlichen Neigungen der Segmente 10 wird Licht aus verschiedenen Richtungen jeweils im lokalen Glanzwinkel zu dem auf die Modulfläche blickenden Beobachter B reflektiert. Im Ausführungsbeispiel von Figur 12 betragen Ein- und Ausfallswinkel maximal 67,5°. Grundsätzlich gilt, dass bei relativ großen Werten des Glanzwinkels das reflektierte Licht blauverschoben ist. Diese Blauverschiebung kann durch einen höheren Brechungsindex der Farbfilterschicht reduziert werden. Bei relativ steilen Flächenneigungen kann es auch zur Mehrfach-Reflexion an benachbarten Facetten kommen.

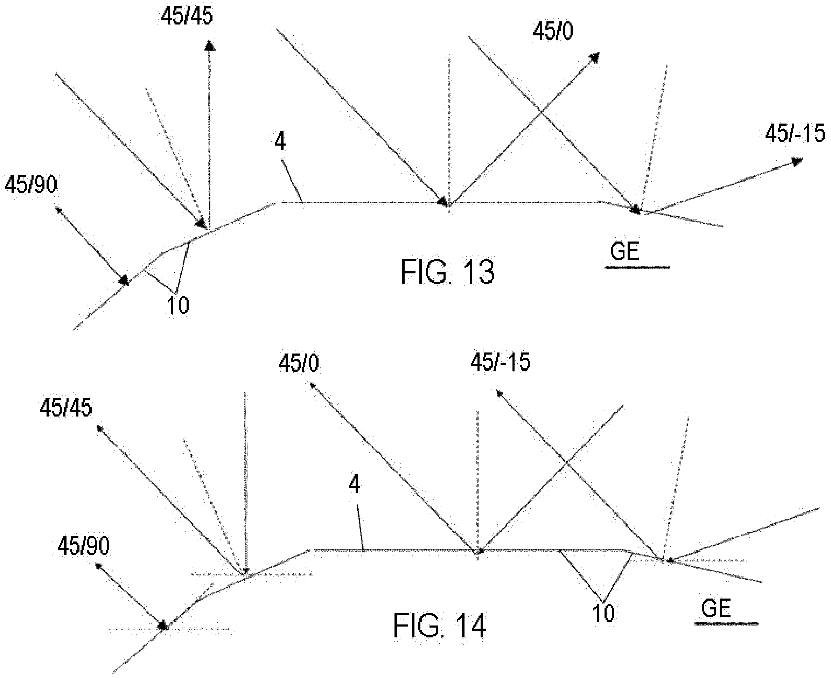

In Figur 13 ist eine Situation gezeigt, bei der die Lichtquelle und dementsprechend die einfallenden Lichtstrahlen stets in einem Winkel von 45° zur Ebene GE der farbgebenden Deckplatte 2 geneigt sind. Der Beobachter B betrachtet die Oberfläche des plattenförmigen Bauteils 1 unter verschiedenen Winkeln. Die Winkelangaben in Figur 13 sind wie folgt zu verstehen: Einfallswinkel (bezogen auf Ebene GE der farbgebenden Deckplatte 2) / Beobachtungs- bzw. Reflexionswinkel (Abweichung vom Glanzwinkel bezogen auf Oberflächennormale auf Ebene GE). Das Gradzeichen "°" ist nicht angegeben. In Figur 13 sind beispielhaft vier Segmente 10 mit verschiedenen Neigungen zur Ebene GE gezeigt. Lediglich in einem Segment 10, dessen Ebene parallel zur Ebene der farbgebenden Deckplatte 2 ist, befindet sich der Beobachter B im Glanzwinkel in Bezug auf die Ebene GE: 45/0. Dies bedeutet, dass der einfallende Lichtstrahl einen Winkel von 45° zur Ebene GE hat, der reflektierte Lichtstrahl eine Winkelabweichung Null vom Glanzwinkel. Bei den anderen Segmenten 10 befindet sich der Beobachter B außerhalb des Glanzwinkels. Bei den beiden linken Segmenten 10 (45/90, 45/45) betrachtet der Beobachter die Oberfläche des plattenförmigen Bauteils 1 in einem Winkel von 90° bzw. 45° zum Glanzwinkel, wobei das Licht in einem Winkel von 45° zur Ebene GE einfällt. Beim rechten Segment 17 (45/-15) befindet sich der Beobachter in einem Winkel von - 15° zum Glanzwinkel. Aufgrund der verschieden geneigten Segmente 10 und der hierdurch bedingten Reflexion im lokalen Glanzwinkel wird auch dann Licht mit hinreichender Intensität zum Beobachter B reflektiert, wenn sich der Beobachter nicht im Glanzwinkel, bezogen auf die Ebene GE der farbgebenden Deckplatte 10, befindet.

In Figur 14 ist eine Situation gezeigt, bei der der Beobachter B die Oberfläche des plattenförmigen Bauteils 1 stets in einem Winkel von 45° zur Moduloberfläche bzw. Ebene GE der farbgebenden Deckplatte 2 beobachtet. In Figur 14 sind beispielhaft vier Segmente 10 mit verschiedenen Neigungen zur Ebene GE gezeigt. Lediglich in einem Segment 10, dessen Ebene parallel zur Ebene GE ist, befindet sich der Beobachter B im Glanzwinkel: 45/0. Bei den anderen Segmenten 10 befindet sich der Beobachter B außerhalb des Glanzwinkels. Bei den beiden linken Segmenten 10 (45/90, 45/45) betrachtet der Beobachter B die Oberfläche des plattenförmigen Bauteils 1 in einem Winkel von 45°, wobei das Licht in einer Abweichung von 90° bzw. 45° relativ zum Glanzwinkel einfällt. Beim rechten Segment 10 (45/-15) fällt das Licht in einem Winkel von -15° zum Glanzwinkel ein. Aufgrund der verschieden geneigten Segmente 10 und der hierdurch bedingten Reflexion im lokalen Glanzwinkel wird auch dann Licht mit hinreichender Intensität zum Beobachter B reflektiert, wenn Licht außerhalb des Glanzwinkels einfällt.

In dem erfindungsgemäßen plattenförmigen Bauteil 1 kann durch die Strukturierung der Vorderfläche 4 der farbgebenden Deckplatte 2 in Kombination mit der farbgebenden Farbfilterschicht 9 ein homogener Farbeeindruck in einem vorgebbaren Wellenlängenbereich erreicht werden, wobei der Farbeindruck im Vergleich zu einer nichtstrukturierten Oberfläche weitaus weniger winkelabhängig ist.

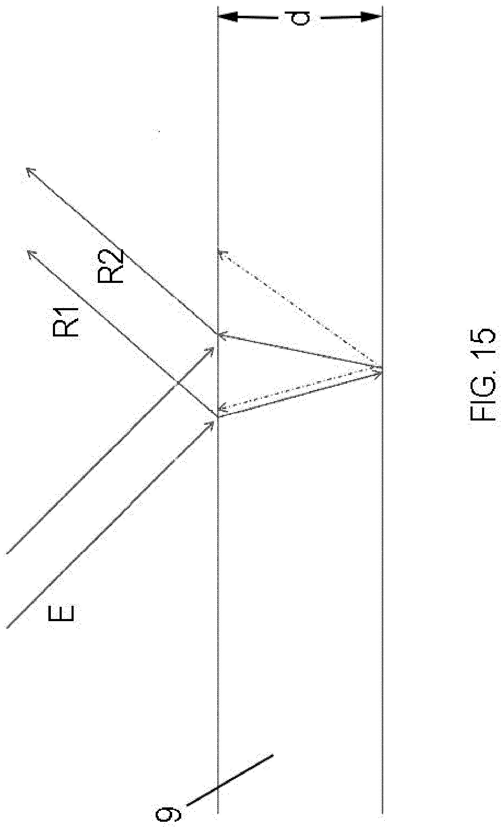

In Figur 15 ist die Reflexion an der Farbfilterschicht 9 mit Schichtdicke d veranschaulicht. Der einfallende Lichtstrahl E wird sowohl an der Grenzfläche Atmosphäre-Farbfilterschicht (R1) als auch an der Grenzfläche Farbfilterschicht-Scheibe (R2) reflektiert. Falls der Gangunterschied der beiden Lichtstrahlen R1, R2 einem Vielfachen der Wellenlänge des einfallenden Lichtstrahls entspricht, tritt konstruktive Interferenz auf, bei einem Gangunterschied von einem Vielfachen der halben Wellenlänge destruktive Interferenz. Bei Beleuchtung mit weißem Licht wirkt die Farbfilterschicht 9 somit als Farbfilter, da konstruktive Interferenz, abhängig vom Brechungsindex n und Schichtdicke d, nur für Licht geeigneter Wellenlänge auftritt. Hierbei ist α der Winkel der reflektierten Strahlen R1, R2, zur Oberflächennormalen. Die Lichtstrahlen R' veranschaulichen beispielhaft das reflektierte Licht außerhalb des Glanzwinkels, welche im strukturierten Bereichs 15 auftreten können, wenn die Rauigkeit der Grenzfläche zwischen Farbfilterschicht-Scheibe zu groß ist. Um die Interferenzbedingung zu erfüllen, ist es erforderlich, dass die Streuzentren jeweils kleiner als Wellenlänge und Schichtdicke sind. Dies kann durch die erfindungsgemäß beanspruchte Minimalfläche der Segmente und deren maximale Rauigkeit erreicht werden. Farbgebung ist jedoch auch möglich, wenn die Schichtdicke deutlich kleiner ist als die Wellenlänge, zum Beispiel durch die Dispersion des Brechungsindex (Abhängigkeit des Brechungsindex von der Wellenlänge) und durch partielle Absoprtion der erfindungsmäßig verwendeten hochbrechenden Materialien in einem Teil des sichtbaren Spektrums. Auch bei diesen sehr dünnen Schichten sollte die Rauigkeitsbedingungen erfüllt sein.

Falls die Vorderfläche 4 der farbgebenden Deckplatte 2 mit einer Farbfilterschicht 9, bestehend aus einer anorganischen, chemisch inerten und harten Schicht wie zum Beispiel mit Si₃N₄, beschichtet ist, ergibt sich eine hohe Kratzfestigkeit, chemische Beständigkeit und schmutzabweisende Wirkung für das plattenförmige Bauteil 1. Durch die Verwendung von fotokatalytischen Schichten wie TiO₂ kann sich zudem ein selbstreinigender Effekt ergeben. Klimatests haben auch ergeben, dass Farbfilterschichten aus Materialen wie Si₃N₄ oder TiO₂ auch die Korrosion einer gläsernen Deckplatte 2 durch feuchte Hitze unterbinden.

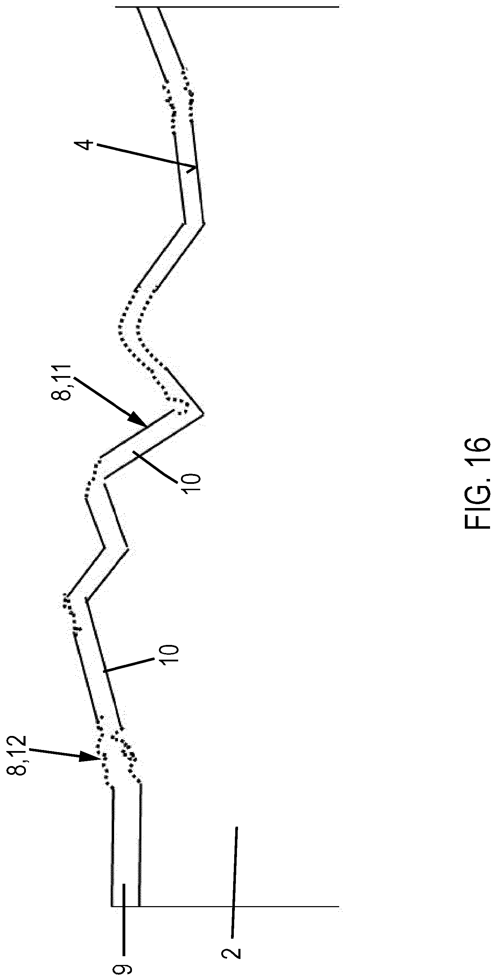

Es wird nun Bezug auf Figur 16 genommen, worin eine weitere Ausgestaltung des erfindungsgemäßen plattenförmigen Bauteils 1 veranschaulicht ist, wobei wiederum lediglich die farbgebende Deckplatte 2 gezeigt ist. Um unnötige Wiederholungen zu vermeiden, werden nur die Unterschiede zu Figur 9 beschrieben und ansonsten wird auf obige Ausführungen Bezug genommen. Bei dieser Ausgestaltung weist der strukturierte Bereich 8 der Vorderfläche 4 erste Zonen 11 und zweite Zonen 12 auf. Hierbei sind die ersten Zonen 11 so ausgebildet, dass die Segmente 10 eine mittlere Rauigkeit haben, die weniger als 15% der Schichtdicke d der Farbfilterschicht 9 auf der Vorderfläche 4 beträgt. In der Ausgestaltung von Figur 9 gilt dies für den gesamten strukturierten Bereich 8. Im Unterschied hierzu ist die mittlere Rauigkeit in den zweiten Zonen 12 so groß, dass eine Interferenz in der Farbfilterschicht 9 unterbunden wird. Beispielsweise beträgt die mittlere Rauigkeit der Segmente 10 in den zweiten Zonen 12 mehr als 50% der Schichtdicke der Farbfilterschicht 9. Das plattenförmige Bauteil 1 hat deshalb in den ersten Zonen 11 eine homogene Farbe, welche sich aus der Farbfilterwirkung der Farbfilterschicht 9 ergibt. In den zweiten Zonen 12 hat die Farbfilterschicht 9 durch fehlende konstruktive Interferenz keinen Farbfiltereffekt und es somit liegt im Wesentlichen eine Oberfläche vor, die dem plattenförmigen Bauteil ohne Farbfilterschicht 9 entspricht. Das plattenförmige Bauteil 1 kann somit wahlfrei in den vorgebbaren ersten Zonen 11 mit einer homogenen Farbe versehen werden. In Figur 16 sind die zweiten Zonen 12 durch eine größere Rauigkeit schematisch veranschaulicht.

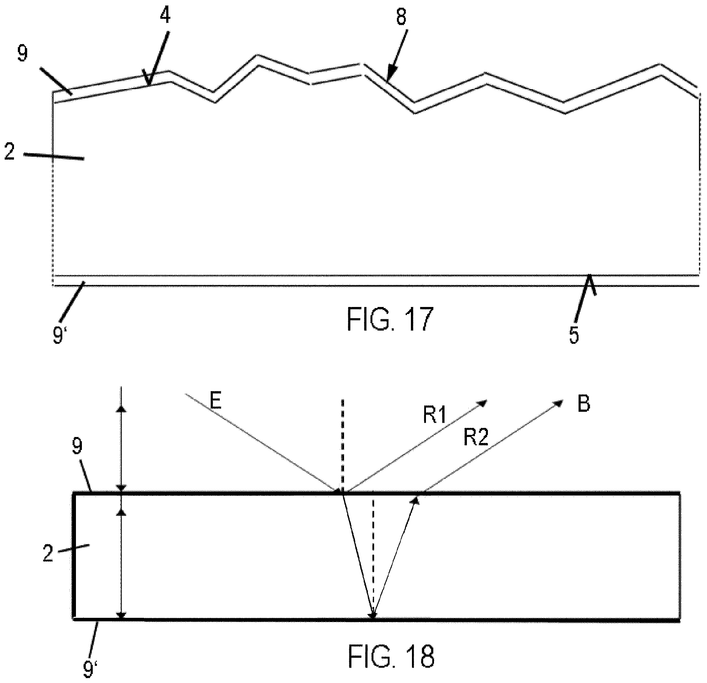

In Figur 17 ist eine weitere Ausgestaltung des erfindungsgemäßen plattenförmigen Bauteils 1 veranschaulicht, wobei lediglich die farbgebende Deckplatte 2 gezeigt ist. Um unnötige Wiederholungen zu vermeiden, werden lediglich die Unterschiede zur Ausgestaltung von Figur 9 beschrieben und ansonsten wird auf obige Ausführungen Bezug genommen. Demnach weist das plattenförmige Bauteil 1 auf der Vorderfläche 4 der farbgebenden Deckplatte 2 auf dem strukturierten Bereich 8 eine erste Farbfilterschicht 9 sowie auf der Rückfläche 5 der farbgebende Deckplatte 2 eine zweite Farbfilterschicht 9' auf. Die Rückfläche 5 der farbgebenden Deckplatte 2 ist nicht strukturiert, d.h. weist keinen strukturierten Bereich 8 analog zur Vorderfläche 4 auf. Die Rückfläche 5 ist glatt im Rahmen der Produktionsungenauigkeiten. Die zweite Farbfilterschicht 9' hat eine Schichtdicke d' und einen optischen Brechungsindex n', die gleich zu jenen der ersten Farbfilterschicht 9 sein können, jedoch nicht notwendigerweise gleich sein müssen. Durch die zweite Farbfilterschicht 9' wird die Farbwirkung noch verstärkt. In Bezug auf die Ausgestaltung von Figur 9 gibt es hierdurch eine zweite Reflexionsquelle mit Farbfilterwirkung, da der Brechungsindex der zweiten Farbfilterschicht 9' zwischen der farbgebenden Deckplatte 2 (z.B. Glas) und der Klebeschicht 6 größer ist als jener von farbgebender erster Scheibe 2 (z.B. Glas) und Klebeschicht 6. Durch die Lichtbrechung ist der Eintrittswinkel bei der zweiten Reflexion geringer. Da das Licht in Summe dreimal eine Farbfilterschicht passiert, ist das Licht, das den Beobachter erreicht, stärker gefiltert. Insbesondere können die Schichtdicken d, d' und die Brechungsindizes n, n' der beiden Farbfilterschichten 9, 9' auch voneinander deutlich verschieden sein. Bei Beschichtung mit deutlich unterschiedlichen optischen Dicken n*d bzw. n'* d' können Mischfarben generiert werden, da die erste Farbfilterschicht 9 dann ein anderes Reflexionsspektrum erzeugt als die zweite Farbfilterschicht 9' und sich das von der zweiten Farbfilterschicht 9' reflektierte Licht bei erneutem Passieren der erste Farbfilterschicht 9 überlagert. So können auf sehr einfache und kostengünstige Weise farbige plattenförmige Bauteile 1 mit einer Vielfalt von Farben und hoher Winkelstabilität für farbige Solarmodule und farbige aktive und passive Fassadenelemente erzeugt werden.

In Figur 18 ist der Strahlengang des einfallenden Lichts E und reflektierten Lichts R1, R2 stark vereinfacht veranschaulicht. In Figur 18 ist die Strukturierung der farbgebenden Deckplatte 2 nicht gezeigt. Dargestellt ist nur ein einziger Strahlengang, hier im Glanzwinkel bezogen auf die Ebene der farbgebenden Deckplatte 2. Man erkennt, dass das Licht, das die erste Farbfilterschicht 9 passiert hat, in der farbgebenden Deckplatte 9 (z.B. Glas) gebrochen wird, ein zweites Mal an der zweiten Farbfilterschicht 9' reflektiert wird und dabei durch Interferenz gefiltert wird. Beim Austritt aus der farbgebenden Deckplatte 2 passiert es die Farbfilterschicht 9, so dass die Farbfilterschichten dreimal passiert werden.

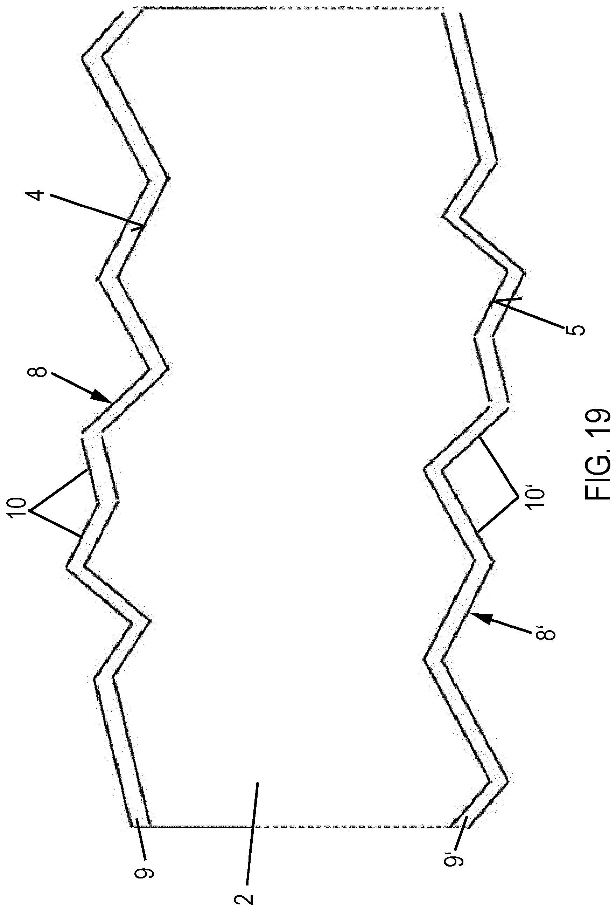

In Figur 19 ist eine weitere Ausgestaltung des erfindungsgemäßen plattenförmigen Bauteils 1 veranschaulicht, wobei lediglich die farbgebende Deckplatte 2 gezeigt ist. Um unnötige Wiederholungen zu vermeiden, werden lediglich die Unterschiede beschrieben und ansonsten wird auf obige Ausführungen Bezug genommen. Demnach weist das plattenförmige Bauteil 1 auf der Vorderfläche 4 der farbgebenden Deckplatte 2 einen ersten strukturierten Bereich 8 und auf der Rückfläche 5 der farbgebenden Deckplatte 2 einen zweiten strukturierten Bereich 8' auf, wobei auf dem ersten strukturierten Bereich 8 eine erste Farbfilterschicht 9 und auf dem zweiten strukturierten Bereich 8' eine zweite Farbfilterschicht 9' angeordnet ist. Die beiden strukturierten Bereiche 8, 8' können gleich oder verschieden ausgebildet sein. Ebenso können die beiden Farbfilterschichten 9, 9' gleich oder verschieden ausgebildet sein, wobei insbesondere die Schichtdicken d, d' und die Brechungsindizes n, n' der beiden Farbfilterschichten 9, 9' voneinander verschieden sein können. Wenn eine gleiche optische Dicke n*d für die beiden Farbfilterschichten 9, 9' gewählt wird, kann die Farbe des plattenförmiges Bauteils 1 verstärkt werden. Bei Beschichtung mit deutlich unterschiedlichen optischen Dicken können Mischfarben generiert werden.

Diesen Ausgestaltungen ist gemeinsam, dass bereits beim Auftreffen des Lichts auf die strukturierte Vorderfläche mit Farbfilterschicht durch Reflexion und Interferenz eine Farbe mit hohen Intensität und geringer Winkelabhängigkeit auch außerhalb des Glanzwinkels entsteht. Die zusätzlichen Farbfilterschichten und/oder Strukturierungen auf der Rückfläche können diese Wirkung noch verstärken.

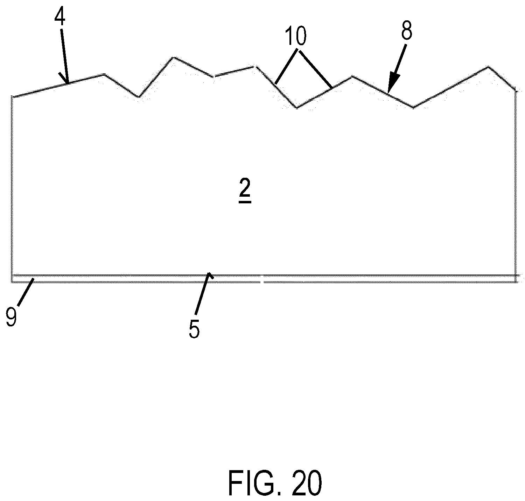

In Figur 20 ist anhand eines vergrößerten Ausschnitts der farbgebenden Deckplatte 2 des plattenförmigen Bauteils 1 eine weitere Ausgestaltung des erfindungsgemäßen plattenförmigen Bauteils 1 veranschaulicht. Um unnötige Wiederholungen zu vermeiden, werden lediglich die Unterschiede beschrieben und ansonsten wird auf obige Ausführungen Bezug genommen. Demnach ist die Vorderfläche 4 der farbgebende Deckplatte 2 in einem Bereich 8 strukturiert, welcher sich im vorliegenden Beispiel über die komplette Vorderfläche 4 erstreckt, d.h. Vorderfläche 4 und strukturierter Bereich 8 sind identisch. Unmittelbar auf der Rückfläche 5 der farbgebenden Deckplatte 2 ist eine Farbfilterschicht 9 angeordnet. Die Rückfläche 5 weist keine Strukturierung auf und ist im Rahmen der Produktionsungenauigkeiten glatt. Auf der Vorderfläche 4 befindet sich keine Farbfilterschicht. Für die Segmente 10 des strukturierten Bereichs 8 der Vorderfläche 4 des plattenförmiges Bauteils 1 von Figur 20 gibt es keine Bedingung für die Rauigkeit.

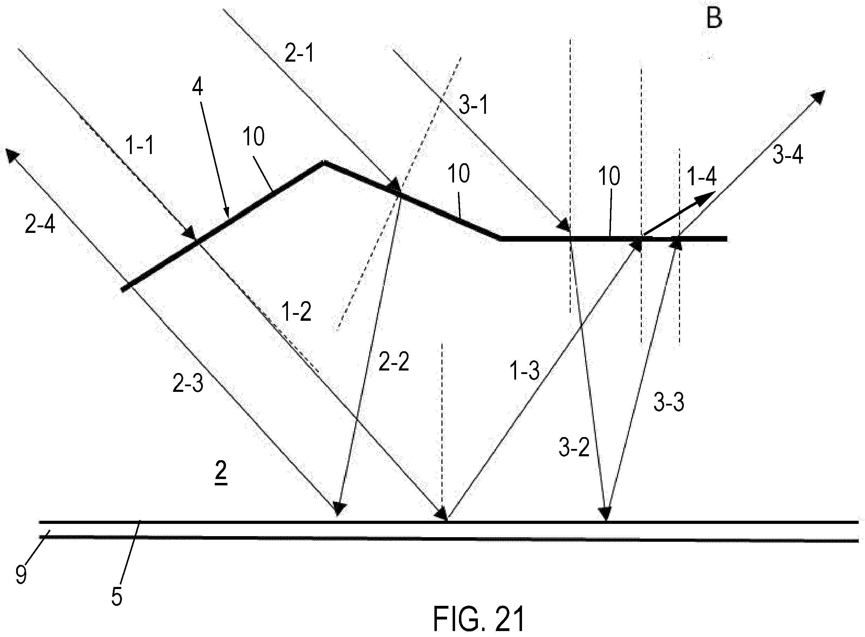

Anhand von Figur 21 wird die Funktion der strukturierten Vorderfläche 4 in Kombination mit der innenseitigen Farbfilterschicht 9 gemäß der Ausgestaltung von Figur 20 näher erläutert. Darin gezeigt sind beispielhaft verschiedene Lichtwege für verschieden geneigte Segmente 10 der farbgebenden Deckplatte 2. Beispielhaft sind drei Segmente 10 gezeigt, wobei das rechte Segment 10 parallel zur Ebene der farbgebenden Deckplatte 2 liegt und die beiden anderen Segmente 10 einen von Null verschiedenen Winkel zur Ebene der farbgebenden Deckplatte 2 haben. Die Reflexion der Lichtstrahlen an der Farbfilterschicht 9 ist vereinfacht dargestellt. Die Reflexion an der Farbfilterschicht 9 wurde bereits erläutert. In Figur 21 sind die Lichtwege für drei Lichtstrahlen gezeigt, die jeweils in einem selben Winkel zur Normalen der Ebene der farbgebenden Deckplatte 2 auf die verschieden geneigten Segmente 10 der Vorderfläche 4 der farbgebenden Deckplatte 2 treffen. Das jeweilige Lot auf die Segmente 10 ist gestrichelt eingezeichnet.

Aufgrund der verschieden geneigten Segmente 10 werden die Lichtstrahlen in verschiedener Weise reflektiert. Ein erster Lichtstrahl 1-1 trifft auf ein Segment 10, quert als gebrochener Lichtstrahl 1-2 die farbgebende Deckplatte 2, wird als Lichtstrahl 1-3 von der Farbfilterschicht 9 (im Glanzwinkel) reflektiert, und tritt als gebrochener Lichtstrahl 1-4 von der farbgebenden Deckplatte 2 zur äußeren Umgebung hin aus. Der letztlich von der farbgebenden Deckplatte 2 reflektierte Lichtstrahl 1-4 weist einen anderen Winkel zur Normalen auf die Ebene der farbgebenden Deckplatte 2 auf als der einfallende Lichtstrahl 1-1, so dass keine Reflexion im Glanzwinkel sondern Streuung vorliegt. In entsprechender Weise trifft ein zweiter Lichtstrahl 2-1 auf ein anderes Segment 10, quert als gebrochener Lichtstrahl 2-2 die farbgebende Deckplatte 2, wird als Lichtstrahl 2-3 von der Farbfilterschicht 9 reflektiert, und tritt als gebrochener Lichtstrahl 2-4 von der farbgebenden Deckplatte 2 zur äußeren Umgebung hin aus. Der reflektierte Lichtstrahl 2-4 tritt annähernd entgegen der Einfallsrichtung des Lichtstrahls 2-1 von der farbgebenden Deckplatte 2 aus, was ebenfalls ein Streuvorgang und keine Reflexion im Glanzwinkel ist. Ein dritter Lichtstrahl 3-1 trifft auf ein weiteres Segment 10, quert als gebrochener Lichtstrahl 3-2 die farbgebende Deckplatte 2, wird als Lichtstrahl 3-3 von der Farbfilterschicht 9 reflektiert, und tritt als gebrochener Lichtstrahl 3-4 von der farbgebenden Deckplatte 2 zur äußeren Umgebung hin aus. Dieses Segment 10 liegt parallel zur Ebene der farbgebenden Deckplatte 2, so dass der Lichtstrahl 2-4 im Glanzwinkel reflektiert wird. Wesentlich hierbei ist, dass durch jene Segmente 10, die zur Ebene der farbgebenden Deckplatte 2 geneigt sind, aufgrund der Brechung am jeweiligen Segment 10 und anschließende Reflexion an der Grenzfläche mit Farbfilterschicht 9 und weiterer Brechung an der strukturierten Oberfläche insgesamt eine starke Reflexion auch außerhalb des Glanzwinkels (bezogen auf die Ebene der farbgebenden Deckplatte 2) auftritt, so dass in Kombination mit der Farbfilterschicht 9 eine homogene Farbwirkung des reflektierten Lichts erreicht wird. In Figur 21 ist beispielhaft die Position eines Betrachters B dargestellt, der sich außerhalb des Glanzwinkels befindet. Aufgrund der relativ stark (diffus) streuenden farbgebenden Deckplatte 2 mit äußerer Strukturierung und innen liegender Farbfilterschicht finden sich für verschiedene Betrachtungswinkel außerhalb des Glanzwinkels meist passende Lichtwege, die die Farbfilterschicht passiert haben. Hierdurch ergibt sich ein Farbeindruck, der weitaus weniger richtungsabhängig ist als bei herkömmlichen Modulen ohne strukturierten Bereich 8.

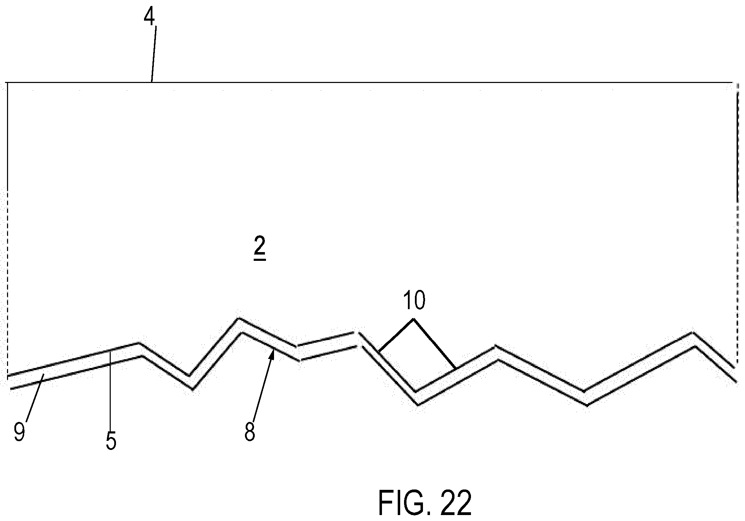

Es wird nun Bezug auf Figur 22 genommen, worin eine weitere Ausgestaltung des erfindungsgemäßen plattenförmigen Bauteils 1 veranschaulicht ist, wobei lediglich die farbgebende Deckplatte 2 gezeigt ist. Um unnötige Wiederholungen zu vermeiden, werden nur die Unterschiede beschrieben und ansonsten wird auf obige Ausführungen Bezug genommen. Demnach weist das plattenförmige Bauteil 1 auf der Rückfläche 5 der farbgebenden Deckplatte 2 einen strukturierten Bereich 8 auf, wobei auf dem strukturierten Bereich 8 eine Farbfilterschicht 9 angeordnet ist. Die Farbfilterschicht 9 ist dünn und folgt der Oberfläche des strukturierten Bereichs 8. Der strukturierte Bereich 8 und die Farbfilterschicht 9 können jeweils analog zu den bisherigen Ausgestaltungen ausgebildet sein. Die Vorderfläche 4 der farbgebenden Deckplatte 2 weist keinen strukturierten Bereich 8 auf und ist im Rahmen der Produktionsungenauigkeiten glatt. Ferner ist keine Farbfilterschicht auf der Vorderfläche 4 angeordnet. Im Unterschied zu den Segmenten 10 des strukturierten Bereichs 8 der Vorderfläche 4 befindet sich auf dem strukturierten Bereich 8 der Rückfläche 5 die Farbfilterschicht 9, so dass die Segmente 10 die Bedingung zu erfüllen haben, wonach die Segmente 10 des strukturierten Bereichs 8 der Rückfläche 5 jeweils eben sind, eine Segmentfläche von mindestens 1 µm² haben und eine mittlere Rauigkeit von weniger als 15% einer Schichtdicke der Farbfilterschicht 9 auf der Rückfläche 5 aufweisen.

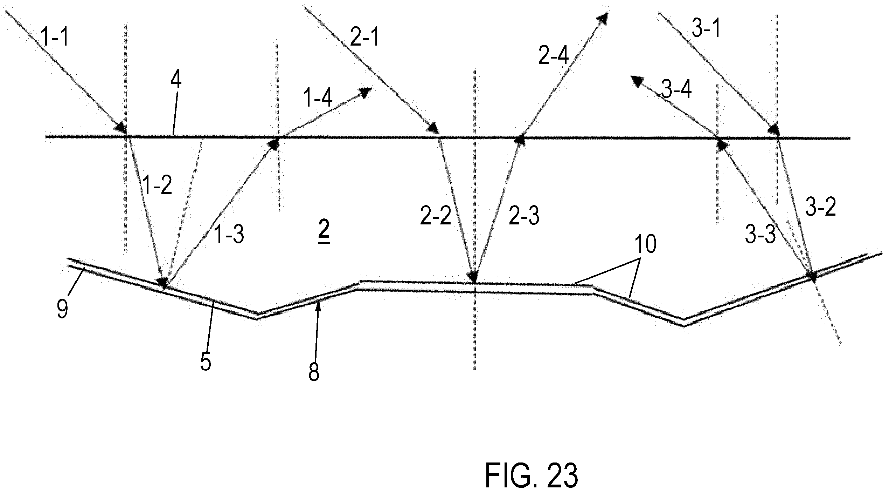

In Figur 23 sind beispielhaft drei verschiedene Lichtwege gezeigt. Die Reflexion der Lichtstrahlen an der Farbfilterschicht 9 ist wiederum vereinfacht dargestellt. Aufgrund der verschieden geneigten Segmente 10 werden die Lichtstrahlen verschieden von der farbgebenden Deckplatte 2 reflektiert. Ein erster Lichtstrahl 1-1 trifft auf die Vorderfläche 4 der farbgebenden Deckplatte 2, quert als gebrochener Lichtstrahl 1-2 die farbgebende Deckplatte 2, wird als Lichtstrahl 1-3 von einem zur Ebene der farbgebenden Deckplatte 2 geneigten Segment 10 reflektiert, und tritt als gebrochener Lichtstrahl 1-4 von der farbgebenden Deckplatte 2 zur äußeren Umgebung hin aus. In entsprechender Weise trifft ein zweiter Lichtstrahl 2-1 auf die Vorderfläche 4 der farbgebenden Deckplatte 2, quert als gebrochener Lichtstrahl 2-2 die farbgebende Deckplatte 2, wird als Lichtstrahl 2-3 von einem zur Ebene der farbgebenden Deckplatte 2 parallelen Segment 10 reflektiert und tritt als gebrochener Lichtstrahl 2-4 von der farbgebenden Deckplatte 2 zur äußeren Umgebung hin aus. In entsprechender Weise trifft ein dritter Lichtstrahl 3-1 auf die Vorderfläche 4 der farbgebenden Deckplatte 2, quert als gebrochener Lichtstrahl 3-2 die farbgebende Deckplatte 2, wird als Lichtstrahl 3-3 von einem zur Ebene der farbgebenden Deckplatte 2 geneigten Segment 10 reflektiert, und tritt als gebrochener Lichtstrahl 3-4 von der farbgebenden Deckplatte 2 zur äußeren Umgebung hin aus. Lediglich für das mittlere Segment 10 ist für den einfallenden Lichtstrahl 2-1 und ausfallenden Lichtstrahl 2-4 die Bedingung Einfallswinkel = Ausfallswinkel, d.h. Reflexion im Glanzwinkel, erfüllt. Die anderen Lichtstrahlen werden von den Segmenten 10 jeweils im lokalen Glanzwinkel reflektiert, welcher jedoch nicht dem Glanzwinkel der Ebene der farbgebenden Deckplatte 2 entspricht, so dass eine relativ starke Streuung auftritt. In Verbindung mit der Farbfilterschicht 9 kann eine wenig richtungsabhängige, homogene Farbwirkung für das plattenförmige Bauteil 1 erzielt werden.

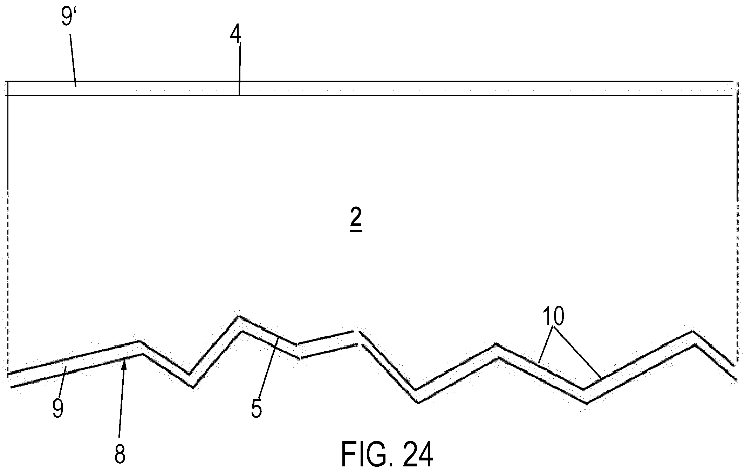

In Figur 24 ist eine weitere Ausgestaltung des erfindungsgemäßen plattenförmigen Bauteils 1 veranschaulicht, wobei nur die farbgebende Deckplatte 2 gezeigt ist. Um unnötige Wiederholungen zu vermeiden, werden lediglich die Unterschiede beschrieben und ansonsten wird auf obige Ausführungen Bezug genommen. Demnach weist das plattenförmige Bauteil 1, neben der Farbfilterschicht 9 auf dem strukturierten Bereich 8 der Rückfläche 5 der farbgebenden Deckplatte 2, eine weitere Farbfilterschicht 9' unmittelbar auf der Vorderfläche 4 der farbgebenden Deckplatte 2 auf. Die Vorderfläche 4 ist nicht strukturiert, d.h. weist keinen strukturierten Bereich 8 analog zur Rückfläche 5 auf. Vielmehr ist die Vorderfläche 4 glatt im Rahmen der Produktionsungenauigkeiten. Die beiden Farbfilterschichten 9, 9' können einen gleichen oder verschiedenen optischen Brechungsindex sowie eine gleiche oder verschiedene Schichtdicke haben. Wenn eine gleiche optische Dicke n*d für die beiden Farbfilterschichten 9, 9' gewählt wird, kann die Farbe des platttenförmigen Bauteils 1 verstärkt werden, da das den Beobachter erreichende Licht in Summe dreimal eine Farbfilterschicht passiert und deshalb stärker gefiltert ist. Bei Beschichtung mit deutlich unterschiedlichen optischen Dicken können Mischfarben generiert werden.

Falls die Vorderfläche 4 der farbgebenden Deckplatte 2 mit einer Farbfilterschicht 9' beschichtet wird, die aus einer anorganischen, chemisch inerten und harten Schicht wie zum Beispiel Si₃N₄ besteht, ergibt sich eine hohe Kratzfestigkeit, chemische Beständigkeit und schmutzabweisende Wirkung für das Plattenförmiges Bauteil 1. Durch die Verwendung von fotokatalytischen Schichten wie TiO₂ kann sich zudem ein selbstreinigender Effekt ergeben.

Eine solche auf der Vorderfläche 4 angeordnete zusätzliche Schicht kann auch eine dünne Antireflexschicht sein, welche einen optischen Brechungsindex aufweist, der kleiner ist als jener der farbgebenden Deckplatte 2. Dadurch wird die im Wesentlichen weiße Reflexion der farbgebenden Deckplatte 2 (z.B. Glas) unterdrückt und der Sättigungsgrad der Farben steigt.

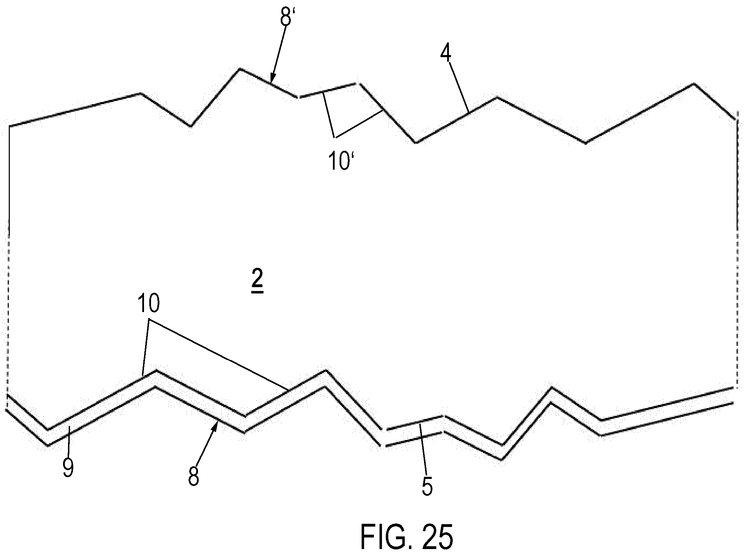

In Figur 25 ist eine weitere Ausgestaltung des erfindungsgemäßen plattenförmigen Bauteils 1 veranschaulicht, wobei nur die farbgebende Deckplatte 2 gezeigt ist. Um unnötige Wiederholungen zu vermeiden, werden lediglich die Unterschiede beschrieben und ansonsten wird auf obige Ausführungen Bezug genommen. Demnach weist die Rückfläche 5 der farbgebenden Deckplatte 2 des plattenförmigen Bauteils 1 einen strukturierten Bereich 8 auf, auf dem eine Farbfilterschicht 9 angeordnet ist. Weiterhin weist auch die Vorderfläche 4 der farbgebenden Deckplatte 2 einen strukturierten Bereich 8' auf. Auf der Vorderfläche 4 ist keine Farbfilterschicht angeordnet. Die beiden strukturierten Bereiche 8, 8' können gleich oder voneinander verschieden sein. Im Ausführungsbeispiel von Figur 25 haben alle Segmente 10 einen Neigungswinkel von maximal 45°. Im Unterschied zu den Segmenten 10 des strukturierten Bereichs 8 der Rückfläche 5, gibt es für die Segmente 10' des strukturierten Bereichs 8' der Vorderfläche 4 des plattenförmigen Bauteils 1 von Figur 25 keine Bedingung für die Rauigkeit.

Eine solche auf der Vorderfläche 4 angeordnete zusätzliche Schicht kann auch eine dünne, farbneutrale Antireflexschicht sein, welche einen optischen Brechungsindex aufweist, der kleiner ist als jener der farbgebenden Deckplatte 2. Dadurch wird die im Wesentlichen weiße Reflexion der farbgebenden Deckplatte 2 (z.B. Glas) unterdrückt und der Sättigungsgrad der Farben steigt. Eine zusätzliche, auf der Vorderfläche 4 angeordnete Schicht kann aber auch den gleichen optischen Brechungsindex wie die farbgebende Deckplatte 2 aufweisen. In diesem Fall dient die Schicht nur dem Schutz der farbgebenden Deckplatte 2 vor Feuchte und andern korrosiven Bestandteilen der Luft. Es hat sich gezeigt, dass durch Ätzen hergestellte satinierte Gläser empfindlicher gegenüber feuchter Hitze sind als plane oder gewalzte Gläser. Im Falle von geätztem Kalknatronglas kann die zusätzliche Schicht zum Beispiel eine dünne gesputterte SiO₂-Schicht sein.

Bei diesen Ausgestaltungen muss das Licht mindestens einmal die farbgebende Deckplatte passieren und muss an der innenliegenden Farbfilterschicht reflektiert werden, um nach Austritt aus der Vorderfläche die gewünschte Farbigkeit mit der verbesserten Winkelstabilität zu erreichen.

Grundsätzlich kann das plattenförmige Bauteil 1 durch eine beliebige geeignete Befestigungstechnik, beispielsweise Rückseitenschienen, gebohrte Punkthalter, Klemmleisten usw. an einer Fassade montiert werden. Häufig kommen in vorgehängt-hinterlüfteten Fassaden Einhängesysteme zum Einsatz, bei denen die Fügeverbindung über einen Formschluss realisiert wird.

In Figur 26 ist die Messanordnung zur Bestimmung der diffusen Streuung des erfindungsgemäßen plattenförmigen Bauteils 1 mit einem kommerziell verfügbaren Mehrwinkel-Farbmessgerät 17 veranschaulicht (Mehrwinkel-Farbmessung). Der nicht näher dargestellte strukturierte Bereich 8 erstreckt sich über die komplette farbgebende Deckplatte 2 (z.B. Glas). Hierbei wird ein Lichtstrahl auf die Vorderfläche 4 des zu charakterisierenden plattenförmigen Bauteils 1 unter verschiedenen Einfallswinkeln gerichtet und das gestreute bzw. reflektierte Licht aus verschiedenen Beobachtungswinkeln, beispielsweise 15° oder 45° zur Oberflächennormalen der Ebene der farbgebenden Deckplatte 2, spektral vermessen. Unter der farbgebenden Deckplatte 2 befindet sich ein opakes Rückseitenelement 14, das hier beispielsweise als eine schwarze, nicht glänzende Schicht (z.B. angebunden mit einer Flüssigkeit mit Brechungsindex bei etwa 1.5) ausgebildet ist. Mit dem Mehrwinkel-Farbmessgerät 17 kann man die Helligkeit im L-a-b System bei D65 Norm Beleuchtung und 10° Öffnungswinkel bestimmen. Es hat sich gezeigt, dass eine gute Winkelstabilität (d.h. geringe Winkelabhängigkeit des gestreuten Lichts) gegeben ist, wenn sowohl bei 45° als auch bei 15° Beobachtungswinkel und bei einem Einfallswinkel von 45°, jeweils gemessen vom Glanzwinkel, noch mindestens eine Helligkeit von L = 10, bevorzugt L = 15 und noch besser L= 20 vorliegt. Durch den mindestens einen strukturierten Bereich 8 von Vorderfläche 4 und/oder Rückfläche 5 der farbgebenden Deckplatte 2 kann sowohl bei 45° als auch bei 15° Beobachtungswinkel und bei einem Einfallswinkel von 45°, jeweils gemessen vom Glanzwinkel (in beiden Richtungen), mindestens eine Helligkeit von L = 10 erreicht werden. Die Gradangaben sind folgendermaßen zu verstehen: Reflexionswinkel (bezogen auf Oberflächennormale/Einfallswinkel (bezogen auf Glanzwinkel). Beispielsweise fällt bei einem Beobachtungswinkel von 45° (gemessen relativ zur Oberflächennormalen) und einem Einfallswinkel von 45° (gemessen vom Glanzwinkel) der einfallende Stahl genau senkrecht zur Oberfläche ein (45/45). Bei einem Beobachtungswinkel von 15° und einem Einfallswinkel von 45° liegt die Einfallsrichtung 30° von der Oberflächennormalen auf der gleichen Seite wie die Beobachtungsrichtung (15/45). Das Mehrwinkel-Farb-Messgerät 20 ist bei einem Beobachtungswinkel von 45° bzw. 15° relativ zur Oberflächennormalen positioniert.

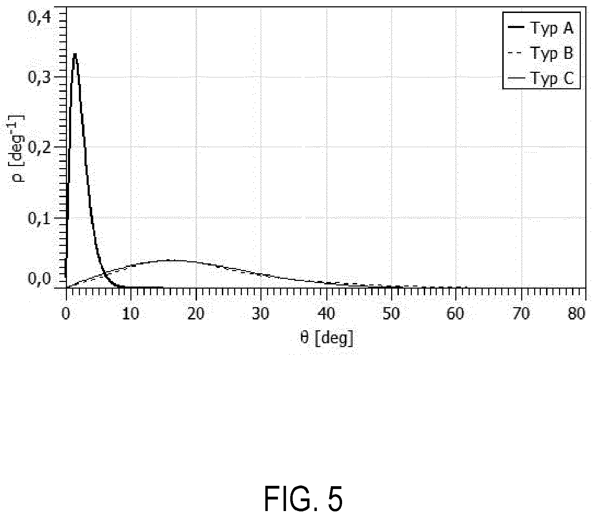

Figur 5 zeigt das Höhenprofil (Winkelverteilung) aus einer konfokalmikroskopischen Messung einer nur leicht strukturierten Glasscheibe (Typ A), einer stärker strukturierten Scheibe (speziell geätztes Glas, Typ B), sowie eines weiteren geeignet strukturierten Glases (Typ C) . Während bei der leicht strukturierten Scheibe (Typ A) die Strukturen sehr groß sind und Neigungswinkel von nur 5 - 10° auftreten, liegt die Struktur der geätzten Scheibe vom Typ B im Bereich 80 -100 µm (Abstand Berg zu Berg in der Glasebene) mit mittleren Winkeln von ca. 17°. Mit einem Profilometer gemessen, erhält man mittlere Strukturtiefen von 14 µm (Höhe Berg zu Tal). Wie in Figur 5 erkennbar, findet sich bei dem leicht texturierten Glas (Typ A) bei Winkeln von größer 20-30° vom Glanzwinkel nur geringe Intensität der Reflexion (gemessen als L-Wert). Beim strukturierten Glas vom Typ B sieht man noch deutliche Helligkeit bei 45as45 oder 15as45. Misst man Höhenprofile auf dem Glas vom Typ B aus, findet man charakteristische Struktureigenschaften: das Aspektverhältnis von Breite (B) zu Höhe (H) der Strukturen beträgt zwischen B:H > 3:1 und B:H < 10:1, Strukturen mit Neigungswinkel von 45° hätten eine Aspektverhältnis von 2:1. Ein weiteres geeignetes strukturiertes Glas (Typ C) hat eine ähnliche Verteilung der Winkel der Oberflächensegmente und auch eine gute Winkelstabilität von L gemessen im Mehrwinkelfarbmessgerät. Jedoch sind die Strukturgrößen weitaus kleiner: der Abstand Berg zu Berg beträgt 30 µm und die Höhe Berg zu Tal 4 µm. Daraus ergibt sich wiederum ein ähnlicher mittlerer Neigungswinkel von 16° wie bei Typ B. Wesentlich für die Winkelverteilung der Helligkeit ist die sehr ähnliche Verteilung der Neigungswinkel, nicht die absolute Strukturgröße, zumindest in einem sehr weiten Größenbereich von wenigen Mikrometern bis wenige hundert Mikrometer. Auch andere Verteilungen mit mittleren Neigungswinkel von 20° - 30° können vorteilhaft sein. Bei zu steilen Neigungswinkeln erhöht sich deutlich die Wahrscheinlichkeit einer Vielfach-Reflexion.

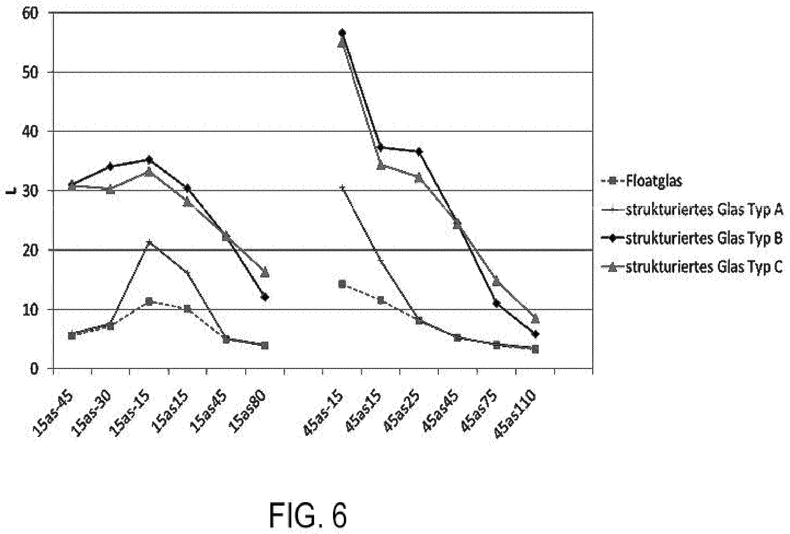

Figur 6 ist ein Diagramm, welches die Helligkeit von unbeschichteten strukturierten Gläsern zeigt, gemessen mit einem Mehrwinkelfarbmessgerät (x-rite MA-T12). Auf der Rückseite der Frontgläser wurde mit Hilfe einer dünnen Schicht Glyzerin (Brechungsindex n= 1,47) ein beidseitig geschwärztes mattiertes Glas optisch angebunden, so dass im Wesentlichen die Reflexion der texturierten Oberfläche gemessen wurde. Das erfindungsgemäß geeignete strukturierte Frontglas (z.B. Typ B oder C, Haze 92%-94%) zeigt insgesamt eine deutliche höhere Intensität des diffus reflektierten Licht als ein leicht texturiertes Solarglas (Typ A, Walzglas, Haze =2%) oder ein unstrukturiertes Floatglas (Haze <0,5%). Das plane Floatglas hat nur Reflexion im Glanzwinkel, der bei dieser Methode nicht gemessen wird. Insbesondere bei Winkeln weit abseits vom Glanzwinkel ist bei dem erfindungsgemäß strukturiertem Glas noch eine deutliche Helligkeit zu erkennen. Dieser Effekt kann vorteilhaft bei Kombination mit einer Farbfilterschicht genutzt werden.

Bei dem erfindungsgemäßen plattenförmigen Bauteil gibt es gemäß einer Ausgestaltung mindestens eine strukturierte Seite außen und mindestens eine Farbfilterschicht außen. Da mindestens eine Farbfilterschicht auf einem diffus streuenden Glaselement aufgebracht ist, finden sich für verschiedene Betrachtungswinkel mikroskopische Flächenelemente, deren Neigung die Reflexionsbedingung Einfallswinkel=Ausfallwinkel erfüllen. Hierdurch ergibt sich ein mittlerer Farbeindruck, der weniger richtungsabhängig ist. Gemäß einer weiteren Ausgestaltung gibt es mindestens eine Farbfilterschicht innen und mindestens eine strukturierte Seite (außen oder innen) oder beide Seiten sind strukturiert. Durch die diffuse Wirkung der mindestens einen strukturierten Schicht gibt es viele verschiedene Lichtwege, die zu Reflexion an der innen liegenden Farbfilterschicht führen und in verschiedenen Richtungen wieder austreten, so dass eine deutlich größere Winkelstabilität der Helligkeit erreicht wird als bei beidseitig glattem Glas. In diesen Fällen muss das Licht mindestens einmal durch das Glas und wieder nach außen zurück gewandert sein, um den gewünschten Farbeffekt in verschiedenen Winkeln auch abseits des Glanzwinkels zu erzeugen.

Wenn die strukturierte Seite und die mindestens eine Farbfilterschicht außen liegen, gibt es durch die diffuse Wirkung der mindestens einen strukturierten Oberfläche viele verschiedene Lichtwege, die zu Reflexion in verschiedenen Richtungen an der außen liegenden Farbfilterschicht führen, so dass eine deutlich größere Winkelstabilität der Helligkeit erreicht wird als bei beidseitig glattem Glas. Die Struktur muss in jedem Fall Facetten und Strukturgrößen in Ausdehnungen größer als die Wellenlänge des sichtbaren Lichtes haben. Um Interferenz in der Farbfilterschicht für ein auftreffenden Wellenfront erzeugen zu können, müssen die Oberflächensegmente hinreichend eben sein, z.B. eine Rauigkeit weniger als 15% oder weniger als 10% der Schichtdicke der Farbfilterschicht aufweisen. Um auch bei schrägen Einfall auf einer Schicht von maximal mehreren Hundert Nanometern Dicke Interferenzbedingung für konstruktive oder destruktive Interferenz zu ermöglichen, müssen die Oberflächensegmente eine minimale Größe haben: eine Größe von 1µm Kantenlänge oder Durchmesser ist erforderlich, da sonst das direkt an der oberen Grenzfläche reflektiertes Wellenpaket nicht mit dem Wellenpaket interferieren kann, das an der unteren Grenzfläche reflektiert wird und seitlich versetzt wieder austritt. Mit zunehmendem Einfallswinkel und zunehmender Schichtdicke liegt der Austrittpunkt des an der unteren Grenzfläche reflektierten Strahls zunehmend seitlich verschoben auf dem Segment. Geeignete Gläser können beispielweise durch Ätzen hergestellt werden mit Strukturen zwischen wenigen Mikrometer bis mehrere 10 µm Größe. Die Strukturgrößen können aber auch im Submillimeter-Bereich sein, zum Beispiel wie bei gewalzten Gläsern. Die Strukturen sollen möglichst verschiedene Flächenneigungen mit breiten Verteilungen der Neigungswinkel haben. Die Strukturen können auch durch Laser hergestellt werden oder durch Aufbringen und Strukturieren einer transparenten Deckschicht mittels Drucktechniken o.ä.

Die mindestens eine Farbfilterschicht 9, 9' des plattenförmigen Bauteils 1 enthält mindestens eine hochbrechende Brechungsschicht aus einem Material mit einem Brechungsindex n von größer als 2,5 im Wellenlängenbereich von 400 nm bis mindestens 700 nm und einen Extinktionskoeffizienten von mindestens 0,2 unterhalb von 450 nm und kleiner als 0,2, vorzugsweise kleiner als 0,1, oberhalb von 700 nm. Optional kann die mindestens eine Farbfilterschicht 9, 9' mindestens eine Brechungsschicht aus einem aus einem transparenten dielektrischen Material mit einem Brechungsindex von kleiner als 2,5 aufweisen. Eingangs wurde bereits dargelegt, dass es vorteilhaft sein kann, wenn die mindestens eine Farbfilterschicht 9, 9' eine Doppelschicht aus einer hochbrechenden Brechungsschicht (HTM) und einer niedrigbrechenden Brechungsschicht (TD), eine Dreifachschicht auf, bei welche r eine hochbrechende Brechungsschicht (HTM) zwischen zwei niedrigbrechenden Brechungsschichten (TD) angeordnet ist, oder eine niedrigbrechende Brechungsschicht (TD) zwischen zwei hochbrechenden Brechungsschichten (HTM) angeordnet ist, oder eine Vierfachschicht, bei welcher zwei hochbrechende Brechungsschichten (HTM) und zwei niedrigbrechende Brechungsschichten (TD) in alternierender Abfolge angeordnet sind, wobei eine hochbrechende Brechungsschicht (HTM) zwischen zwei niedrigbrechenden Brechungsschichten (TDS) angeordnet ist und eine niedrigbrechende Brechungsschicht (TD) zwischen zwei hochbrechenden Brechungsschichten (HTM) angeordnet ist, aufweist.

Bei Verwendung von nichtabsorbierenden Materialien wie Si₃N₄, SiO₂, SiON, ZrO₂ oder TiO₂ (typische Dielektrika) für die Farbfilterschicht ist die Auswahl der verfügbaren Brechungsindizes auf Werte unter n=3 im Sichtbaren (380 nm - 780 nm) beschränkt. Simulationen (Transfer-Matrix-Methode) zeigen, dass man mit einer dünnen Si₃N₄-Schicht (z.B. 50 -70 nm) auf Glas eine achromatische Reflexion (Chromazität c < 3) mit einer Luminanz von L=55 herstellen kann. Mit ZrO₂ kommt man auf L=60 und mit TiOₓ kommt man bis auf L=70 (siehe auch unten eingeblendete Tabelle 1).

**Tabelle 1 (Schichtpakete für Weißtöne)**

| Schichtpaket | L | a | b | C | ΔE20°-50° | jscloss | R | G | B |
|---|---|---|---|---|---|---|---|---|---|
| 60nm Si3N4 / Glas | 55 | -2,2 | -2,3 | 3,2 | 1,4 | -14,9 | 125 | 133 | 135 |
| 50nm TiOx /Glas | 69 | -2,8 | -1,7 | 3,3 | 1,3 | -29,1 | 162 | 170 | 172 |
| 24 nm a-Si / Glas | 85 | -3,1 | 1,1 | 3,3 | 1,3 | -48,8 | 206 | 213 | 209 |
| 24nm c-Si / Glas | 84 | -2,7 | -7 | 7,5 | 1,5 | -48,4 | 198 | 212 | 223 |
| 20nm SiO2 / 20nm a-Si /Glas | 83 | -3,4 | 0 | 3,4 | 2,3 | -44,3 | 199 | 207 | 205 |
| 10nm Si3N4/ 20nm aSi / Glas | 83 | -3,3 | 0,5 | 3,3 | 1,6 | -45,7 | 201 | 209 | 206 |
| 14nm a-Si/ 100nm SiO2 / 22 nm a-Si / Glas | 90 | -3 | 0,7 | 3,1 | 4,6 | -36,3 | 220 | 227 | 224 |
| 16nm a-Si/ 85nm SiO2 / 26 nm a-Si / Glas | 90 | -2,9 | 1,8 | 3,4 | 4,7 | -37,3 | 222 | 228 | 223 |
| 10 SiO2/ 10nm-a-Si/110nm SiO2/20 nm-a-Si | 90 | -2,8 | 0,5 | 2,9 | 4 | -39 | 222 | 229 | 226 |
| 130 SiO2/ 10nm-a-Si/60nm SiO2/35 nm-a-Si | 87 | -2,8 | -0,6 | 2,9 | 4 | -38 | 211 | 219 | 218 |
| 10 SiN/ 20nm-a-Si/120nm SiO2/20 nm-a-Si | 90 | -2,8 | 0,8 | 2,9 | 4,3 | -37,8 | 219 | 226 | 223 |

Für einen weißen Farbeindruck muss man jedoch an Werte von L=85 und darüber kommen. Mit komplexeren Mehrfachschichten aus diesen Materialen in Kombination mit SiO₂ kommt man noch um ΔL =5-10 höher. Jedoch werden die erforderlichen Schichtdicken sehr hoch und die Winkelabhängigkeit nimmt deutlich zu. TiOₓ hat sich zudem wegen seiner katalytischen Wirkung und Aktivierung durch UV als kritisch erwiesen. Solarmodule mit TiOₓ Schichten innen zeigten deutliche Reaktionen zwischen Farbbeschichtung und Randversiegelung. Selbst bei Außenbeschichtung waren durch das Umsputtern zur Innenseite noch Degradationen und optische Fehler erkennbar.

Um Weißtöne zu erhalten (L>80, c<3,5), muss die Reflexion im Sichtbaren im Mittel bei R= 65 % liegen. Der relevante Wellenlängenbereich liegt zwischen 400nm und 700nm. Wenn dies mit einfachen Schichtsystemen aus wenigen Lagen erreicht werden soll, muss der Brechungsindex der Materialien größer als 3,0 bevorzugt größer 3,5 sein. Oberhalb 700 nm sollte die Transmission über 80%, bevorzugt über 90% liegen, um einen möglichst hohen Wirkungsgrad zu erreichen. Absorption und Reflexion müssen entsprechend klein sein. Solarzellen aus Silizium oder aus CIGS haben zwischen 700 nm und 1250 nm immer noch eine hohe spektrale Empfindlichkeit. Um den Wirkungsgradverlust gegenüber Solarmodulen mit normal transparenten Frontgläsern zu reduzieren, sollten die Farbfilter im nahen Infrarot möglichst transparent sein.

Aus Veröffentlichungen und Lehrbüchern der Halbleiterphysik sind der Verlauf des Brechungsindex und des Extinktionskoeffizienten von kristallinem, mikrokristallinem und wasserstoff-passiviertem amorphem Silizium (a-Si:H) und anderen Halbeitern wie GaP, GaAs, oder Ge bekannt (z.B. Seyed Sadreddin Mirshafieyan and Junpeng Guo, Opt. Express 22, 31545-31554 (2014)). Charakteristisch für diese Materialien sind ein sehr hoher Brechungsindex über n=3 im gesamten sichtbaren Wellenlängenbereich von 380 nm bis 780 nm mit Maxima im Bereich 300-400nm mit Werten von n=4 bis hoch zu n=7. Der Extinktionskoeffizient ist für diese Materialien im Bereich 250-250 nm sehr hoch mit Werten k=2 bis über k=6. Oberhalb von 400-500 nm jedoch fällt der Extinktionskoeffizient deutlich ab auf Werte unter 0,2 und letztlich unter 0,01 im nahen Infrarot (NIR) oberhalb 800nm.

Ebenfalls geeignet sind Mischsysteme aus amorphem Silizium, Wasserstoff sowie den Elementen C, Ge, oder O. Über die Zulegierung von O, C, und Ge lassen sich die optischen Eigenschaften jeweils noch weiter modifizieren, um hohe Reflexion, eine geringe Chromazität und hohe Transmission im NIR zu erhalten. Materialien mit den oben genannten Bedingungen für den Brechungsindex und den Extinktionskoeffizienten sind Materialien für die erfindungsgemäße hochbrechende Brechungsschicht. Transparenten, isolierende Dielektrika mit Brechungsindex <2.2 und k=0 wie SiO₂, S₃N₄, SiON sind Materialien für die erfindungsgemäße niedrigbrechende Brechungsschicht.

Auch Mischsysteme aus Silizium mit Stickstoff sind geeignet: ausgehend von stöchiometrischen Si₃N₄ wird durch Erhöhung des Verhältnis Silizium zu Stickstoff der Brechungsindex höher und es entsteht im Blauen eine Absorptionskante. Mit Beimischungen von Sauerstoff lassen sich die optischen Eigenschaften noch variieren, so dass allgemeinen Silizium-reiche SION Schichten geeignet sind. Bevorzugt sollte der Stickstoffanteil größer sein sollte als der Sauerstoffanteil.

Alle Silizium-basierten Materialen können auch Anteile von Aluminium enthalten. Zur Verbesserung des Sputter-Prozesses verwendet man Sputtertargets mit Anteilen von bis zu 10% Aluminium im Silizium.

Weiterhin gibt es auch verschiedene Übergangsmetalloxide (z.B. Cu₂O oder Fe₂O₃) mit den oben genannten geeigneten optischen Eigenschaften. Sogar einige Metallsulfide oder Metallselenide (wie z.B. Mo₂S₃ oder Mo₂Se₃) haben ebenso geeignete optische Eigenschaften. Bei den Metallsufloseleniden können aber unter Umständen Haftungs- und Stabilitätsprobleme auftreten auf Grund der geringen Härte und Haftung.

Um Probleme bzgl. elektrischer Isolation oder PID (Potential Induced Degradation) zu vermeiden, sollten die Schichten undotiert und hochisolierend sein. Der Widerstand R der Schichten/Schichtstapel sollte bei einer Spannung von 1000 V und einem Messelektrodenabstand von 2 cm bei Tageslicht nicht unter 10 GOhm, besser nicht unter 10² GOhm, betragen. Der spezifische Dunkel-Widerstand sollte über 10¹⁰ Ωcm, besser über 10¹¹ Ωcm, liegen.

Durch Verwendung von Mehrfachschichten mit typischen Dielektrika wie SiO₂, S₃N₄, SiON mit Brechungsindex <2.2 lassen sich die Stromverluste noch weiter reduzieren. Beispiele zu Dreifachschichten finden sich in obiger Tabelle 1.

Zusammenfassend sind für Weißtöne (L>80, c<3,5) folgende Farbfilterschichten auf texturiertem Glas in einer der genannten Konfigurationen (Textur innen, außen oder beidseitig und Beschichtung innen, außen oder beidseitig) geeignet:
Hochbrechende und teiltransparente Materialien (HTM) mit einem Brechungsindex größer als 3,0 bevorzugt größer als 3,5, im Wellenlängenbereich 400 nm bis 700 nm und einem Extinktionskoeffizenten kleiner als 0,2 bevorzugt kleiner als 0,1, oberhalb von 700nm, bevorzugt oberhalb von 500nm. Beispiele für besonders geeignete HTM sind: kristallines oder mikrokristallines Si, amorphes a-Si:H, a-SiC:H, a-SiO:H, a-SiGe:H, silziumreiches SixNy, siliziumreiches SixNyOz (y>z). Die Schichtdicken der HTM sollten kleiner als 30 nm und größer als 5nm sein. Der Widerstand R der Schichten/Schichtstapel soll bei einer Spannung von 1000 V und einem Messelektrodenabstand von 2 cm bei Tageslicht nicht unter 10 GOhm, besser nicht unter 10² GOhm, betragen. Der spezifische Dunkel-Widerstand sollte über 10¹⁰ Ωcm, besser über 10¹¹ Ωcm, liegen.

Die Farbfilterschicht weist beispielsweise genau eine hochbrechende Brechungsschicht (HTM) auf (Einfachschicht).

Die Farbfilterschicht weist beispielsweise genau eine hochbrechende Brechungsschicht (HTM) und genau eine niedrigbrechende Brechungsschicht (TD) auf (Zweifachschicht). D.h. eine Doppelschicht Glas/HTM/TD oder TD/HTM/Glas. Bei Außenbeschichtung sollte die Deckschicht aus DT zuoberst also ganz außen in Kontakt mit der Luft liegen, bei Innenbeschichtung ganz innen in Kontakt mit der Laminationsfolie.

Die Farbfilterschicht weist beispielsweise genau eine hochbrechende Brechungsschicht (HTM) und genau zwei niedrigbrechende Brechungsschichten (TD) oder alternativ genau eine niedrigbrechende Brechungsschicht (TD) und genau zwei hochbrechende Brechungsschichten (HTM) auf (Dreifachschicht). D.h. eine Dreifachschicht HTM/DT/HTM /Glas oder Glas/DT/HTM/DT oder Glas/DT/HTM/DT oder DT/HTM/DT/Glas.

Die Farbfilterschicht weist beispielsweise genau zwei hochbrechende Brechungsschichten (HTM) und genau zwei niedrigbrechende Brechungsschichten (TD) auf, welche alternierend angeordnet sind (Vierfachschicht). D.h. eine Vierfachschicht Glas/HTM/ DT/HTM/DT oder DT/HTM/ DT/HTM/Glas.

Rote plattenförmige Bauteile, insbesondere Solarmodule, lassen sich mit Einfach- oder Zweifach-Schichten aus den üblichen dielektrischen transparenten Materialien (TD) wie Si₃N₄, ZrO₂ oder TiOₓ nicht auf Interferenzbasis herstellen. Bei einer Einfachschicht aus Si₃N₄ oder TiOₓ kann das Maximum erster Ordnung zwar durch Erhöhung der Schichtdicke in den roten Wellenlängenbereich (>600nm) geschoben werden, jedoch erscheint im Blauen dann bereits das Maximum der zweiten Ordnung. Der Abstand der Maxima nimmt zwar mit abnehmendem Brechungsindex zu, jedoch ist der Abstand auch für niedrige Brechungsindizes (zwischen 1 und 1,5) bereits zu klein. Weiterhin sind die Interferenz-Maxima bei Einfach- oder Doppelschichten zu breit: Im menschlichen Auge überlappen sich die spektralen Absorptionskurven der Sehpigmente der Fotorezeptoren für Rot (L-Zapfen) und Grün (M-Zapfen) sehr stark. Für einen starken Rotton ist die Differenz der Signale der L-Zapfen und der M-Zapfen maßgebend. Für einen möglichst gesättigten Rotton braucht man einen relativ steilen Anstieg des Farbspektrums zwischen 580 nm und 620 nm. Ein zu flacher Anstieg führt dann zu Gelbtönen aus der Mischung von Rot und Grün. Die Verschiebung durch zunehmende Schichtdicke führt von Goldfarbig dann immer gleich zu Violett oder Purpurfarben.

Mit den Farbfiltern auf Basis von HTM können weitaus besser blau-arme und winkelstabile Rottöne erzeugt werden. Dazu tragen zwei verschiedene Eigenschaften bei: zum einen ist der Brechungsindex sehr hoch. Dadurch reduziert sich die notwendige Schichtdicke für passende Farbfilterschichten. Daraus ergibt sich eine deutlich verbesserte Winkelstabilität. Zum anderen führt die höhere Absorption im Blauen zu einer Reduzierung des Blauanteils im Reflexionsspektrum.

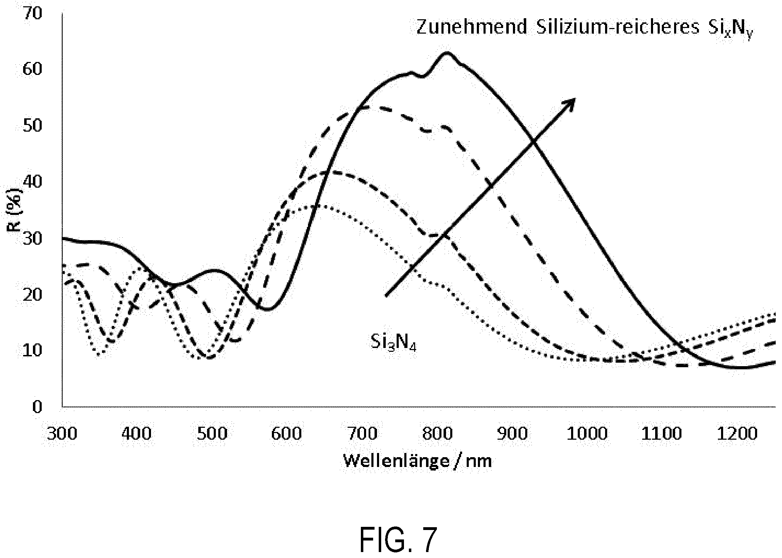

Figur 6 zeigt Reflexionsspektren von SiₓN_{y} auf Glas mit zunehmendem Siliziumgehalt und Figur 7 zeigt Absorptionsspektren (A=1-T-R) von zunehmend Silizium-reicheren SiₓN_{y} -Schichten auf planem Floatglas. Die Schichtdicke beträgt etwa 260 nm. Mit zunehmendem Siliziumgehalt nimmt die Reflexion im roten Spektralbereich deutlich zu, während der Blauanteil abnimmt. Mit zunehmendem Siliziumgehalt nimmt die Absorption im Blauen zu.

Mit solchen Einfachschichten aus Silizium-reichen SiₓN_{y} konnte auf strukturiertem Glas als Innenbeschichtung ein rot-violettes Solarmodul mit L=41, h=5 und c= 31 und als Außenbeschichtung ein Solarmodul in Alt-rosa mit L=60, h=29 und c=31 hergestellt werden (gemessen in Di:8°, D65). Durch Kombination mit einer dünnen Schicht SiO₂ (oder eine andere TD) kann der Blauton noch weiter unterdrückt werden und die Schicht wird geschützt gegenüber Feuchte. Weiterhin führt die Deckschicht wie bei den weißen Modulen zu einer besseren elektrischen Isolation.

Mit Vielfachschichtstapeln und dicken Schichten lassen sich rote Farbtöne aus den transparenten dielektrischen Materialien (1,5 < n < 2,8) wie TiOₓ, SiO₂, Si₃N₄ oder ZrO₂ auch ohne HTM erzeugen. Jedoch ist durch die relativ hohe Gesamtschichtdicke und den langen optischen Weglängen die Winkelstabilität zu gering: der Farbton ändert sich zu stark unter verschiedenen Beobachtungs- und Beleuchtungswinkeln. Bei größeren Winkeln verschiebt sich das Maximum aus dem roten in den gelb-orangen Bereich: z.B. ein Schichtpaket aus 110 nm-SiN-90nm SiO₂-90SiN TiO₂ auf Glas ergibt ein Terrakotta-Rot mit L=47,2 a=38,9 und b=20,8. Zwischen 20° und 50° ändert sich die Farbe jedoch um ΔE=42 zu einem Goldton.

Mit den HTM lassen sich mit Dreifach- oder Vierfachschichten Rottöne mit deutlich geringeren Schichtdicken erzeugen. Man kann z.B. in der Simulation mit amorphem Silizium einen Rotton erzeugen, der dem oben gezeigten Terrakotta-Rot entspricht: 4nm aSi-45nm SiN-18nm aSi-Glas mit L=47, a= 36, b=19. Das ΔE=13 zwischen 20° und 50° zeigt die im Vergleich zum oben gezeigten ΔE=42 eine deutlich größere Winkelstabilität durch die deutlich geringere optische Weglänge. Der abgeschätzte Stromverlust liegt hier bei 30%.

Es lassen sich auch mit den n und k Dispersionsdaten von kristallinem Si mit Dreifach- oder Vierfachschichten starke Rottöne simulieren. Weitere Beispiele finden sich in Tabelle 2 unten.

**Tabelle 2: Schichtpakete für Rottöne**

| Schichtpaket / Glas | L | a | b | C | h | ΔE20 °50° | Jscloss | R | G | B |
|---|---|---|---|---|---|---|---|---|---|---|
| 50nm SiN /40 nm a-Si | 37,5 | 46,7 | 17 | 49,7 | 20 | 9,9 | -37 | 158,9 | 47,9 | 63,4 |
| 4nm a-Si / 45 nm SiN / 18 nm a-Si | 47,2 | 36,3 | 19,1 | 41 | 27,7 | 12,8 | -28,5 | 175 | 85 | 82 |
| 8nm a-Si / 25 nm SiO2 / 30 nm a-Si | 50,7 | 43 | 16,2 | 46 | 20,6 | 14,8 | -36,6 | 193 | 87 | 95 |
| 10 nm a-Si / 20 nm SiO2 / 28 nm a-Si | 53,5 | 43,5 | 1 | 43,5 | 1,3 | 12 | -40,3 | 196 | 95 | 128 |
| 40nm SiN /45nm c-SI/ 40nmSiN | 41,1 | 37,5 | 15,5 | 40,6 | 22,4 | 11,5 | -33,6 | 157,6 | 68,6 | 73,5 |
| 50nm SiN / 30nm c-Si /10nm SiN / 10nm c-Si | 41 | 33,1 | 27,2 | 42,9 | 39,4 | 10,2 | -31,5 | 154,9 | 72,1 | 53,8 |
| 50nm SiN / 40nm a-Si /90nm SiN / 50 nm a-Si | 43,3 | 62,1 | 59,8 | 86,2 | 43,9 | 13,7 | -51,1 | 200,4 | 32,5 | 0 |
| 60nm SiN / 10nm a-Si / 110nmSiN /50nm a-Si | 45,8 | 59,4 | 42,7 | 73,1 | 35,7 | 23,3 | -41,6 | 203,7 | 48,8 | 40 |

Für die Herstellung von winkelstabileren, gesättigten und blauarmen Rottönen sind also Farbfilter auf den strukturierten Glaselementen (innen, außen oder beidseitig) mit den gleichen Merkmalen geeignet wie oben, mit folgenden Änderungen:
Die Farbfilter enthalten mindestens eine oder mehrere Schichten aus einem hochbrechenden und teiltransparenten Material (HTM) mit einem Brechungsindex größer als 2,5 bevorzugt größer als 3.0, im Wellenlängenbereich 400nm bis mindestens 700nm und einem Extinktionskoeffizienten von mindestens 0,2 unterhalb von 450nm und kleiner als 0,2, bevorzugt 0,1, oberhalb von 700nm, bevorzugt oberhalb von 500nm. Die Schichtdicken der HTM können im Bereich von 5nm bis 300nm liegen.

Weiße und rote plattenförmige Bauteile sind die Hauptanwendungen der oben beschriebenen Farbfilter auf strukturiertem Frontglas mit HTM. Es ist jedoch auch möglich, dass die interessanten Eigenschaften (hoher Brechungsindex im VIS, geringe Absorption oberhalb 700nm oder oberhalb 500nm) auch für andere Farben genutzt werden können.

Mit einer Doppelschicht TD/HTM/Glas können mit einer dünnen Schicht HTM und Schichtdicken des TD im Bereich von 50-150nm eine Reihe von hellen, starkgesättigten Farben mit guter Winkelstabilität und moderatem Wirkungsgradverlust hergestellt werden, wie z.B. Blau aus 110nm SiN/10nm/Glas mit L=50, c=46, h=245, E20°50°=11 und Jsc-loss=-15%. Die Kombinationsmöglichkeiten sind vielzählig. Das wesentliche sind die 1 oder 2 Schichten von HTM im Wechsel mit einem transparentem Dielektrikum TD.

Die HTM können mit verschiedenen bekannten Beschichtungsverfahren auf Glas abgeschieden werden: reaktives Sputtern, CVD, ALD, Verdampfen (thermisch oder mit Elektronenstrahl) u.a. Da die Schichtdicken relativ gering sind, würde sich ALD empfehlen. ALD und CVD führen auch zu einer guten konformen Bedeckung der strukturierten Oberfläche.

Wie sich aus vorstehender Erfindungsbeschreibung ergibt, stellt die Erfindung ein verbessertes plattenförmiges Bauteil zur Verfügung, das eine sehr homogene, intensive Farbe, bei geringer oder fehlender Richtungsabhängigkeit hat. Insbesondere kann das plattenförmige Bauteil in besonders vorteilhafter Weise mit einer weißen oder roten Farbe versehen werden. Das plattenförmige Bauteil kann kosteneffizient in verschiedenen Formen und Größen hergestellt werden und beispielsweise in einfacher Weise in eine Fassade integriert werden. Die Erfindung stellt somit eine Neuerung zur Verfügung, die in der Praxis des Fassadenbaus und in den Anwendungsmöglichkeiten von Solarmodulen als farbige Module für Dachmontage oder Freiflächen erhebliche Vorteile mit sich bringt.

### Bezugszeichenliste

1 plattenförmiges Bauteil
2 Deckplatte
3 mechanisch unterstützende Scheibe
4, 4' Vorderfläche
5, 5' Rückfläche
6 Klebeschicht
7 Kontaktfläche
8, 8' strukturierter Bereich
9, 9' Farbfilterschicht
10, 10' Segment
11 erste Zone
12 zweite Zone
13, 13' Zwischenschicht
14 Rückseitenelement
15, 15' Verbundscheibe
16 Trägersubstrat
17 Mehrwinkelfarbmessgerät
18 Solarzellen
19 Maskierungsschicht
20 Solarmodul
Vorderseite V
Rückseite R
Äußere Umgebung U

## Patentansprüche

1. Plattenförmiges Bauteil (1) mit Farbwirkung, umfassend eine transparente Deckplatte (2) und mindestens ein an der Deckplatte (2) angebrachtes flächiges Rückseitenelement (14), wobei die Deckplatte (2) eine der äußeren Umgebung zugewandte Vorderfläche (4) und eine dem Rückseitenelement (3) zugewandte Rückfläche (5) hat, wobei mindestens eine Fläche (4, 5), gewählt aus Vorder- und Rückfläche, mindestens einen strukturierten Bereich (8, 8') aufweist, und wobei auf mindestens einer Fläche (4, 5), gewählt aus Vorder- und Rückfläche, mindestens eine Farbfilterschicht (9, 9') zur Reflexion von Licht innerhalb eines vorgegebenen Wellenlängenbereichs angeordnet ist,
- **dadurch gekennzeichnet, dass** der mindestens eine strukturierte Bereich (8, 8') folgende Merkmale i) bis iii) aufweist:
i) senkrecht zur Ebene der Deckplatte (2) ein Berge und Täler aufweisendes Höhenprofil, wobei ein mittlerer Höhenunterschied zwischen den Bergen und Tälern mindestens 2 µm beträgt,
ii) mindestens 50% des strukturierten Bereichs setzt sich aus Segmenten zusammen, die zur Ebene der Deckplatte (2) geneigt sind, wobei, bezogen auf die Ebene der Deckplatte (2) mindestens 20% der Segmente einen Neigungswinkel im Bereich von größer als 0° bis maximal 15° und mindestens 30% der Segmente einen Neigungswinkel im Bereich von größer als 15° bis maximal 45° haben, wobei
iii) die Segmente jeweils eben sind und eine Segmentfläche von mindestens 1 µm² haben, wobei die Segmente jeweils eine mittlere Rauigkeit von weniger als 15% einer Schichtdicke der mindestens einen Farbfilterschicht (9, 9') haben, und
- dass die mindestens eine Farbfilterschicht (9, 9') mindestens eine hochbrechende Brechungsschicht enthält, wobei die mindestens eine Brechungsschicht einen Brechungsindex von größer als 2,5 im Wellenlängenbereich von 400 nm bis mindestens 700 nm und einen Extinktionskoeffizienten von mindestens 0,2 unterhalb von 450 nm und kleiner als 0,2, insbesondere kleiner als 0,1, oberhalb von 700 nm hat.

2. Plattenförmiges Bauteil (1) nach Anspruch 1, bei welchem die mindestens eine hochbrechende Brechungsschicht einen Extinktionskoeffizienten von kleiner als 0,2, insbesondere kleiner als 0,1 oberhalb von 500 nm hat.

3. Plattenförmiges Bauteil (1) nach Anspruch 1 oder 2, bei welchem die mindestens eine hochbrechende Brechungsschicht einen Brechungsindex von größer als 3,0, insbesondere größer als 3,5, im Wellenlängenbereich von 400 nm bis mindestens 700 nm hat.

4. Plattenförmiges Bauteil (1) nach einem der Ansprüche 1 bis 3, bei welchem die mindestens eine hochbrechende Brechungsschicht eine Schichtdicke im Bereich von 5 nm bis 300 nm, insbesondere im Bereich von 5 nm bis 40 nm hat.

5. Plattenförmiges Bauteil (1) nach einem der Ansprüche 1 bis 4, bei welchem die mindestens eine hochbrechende Brechungsschicht einen Brechungsindex von größer als 3,0, insbesondere größer als 3,5, im Wellenlängenbereich von 400 nm bis mindestens 700 nm und eine Schichtdicke im Bereich von 5 nm bis 40 nm hat.

6. Plattenförmiges Bauteil (1) nach einem der Ansprüche 1 bis 5, bei welchem die mindestens eine Farbfilterschicht (9, 9') mindestens eine niedrigbrechende Brechungsschicht aus einem transparenten dielektrischen Material aufweist, wobei die mindestens eine niedrigbrechende Brechungsschicht einen Brechungsindex von kleiner als 2,5 hat.

7. Plattenförmiges Bauteil (1) nach Anspruch 6, bei welchem die mindestens eine niedrigbrechende Brechungsschicht eine Schichtdicke von größer als 10 nm und kleiner als 250 nm hat.

8. Plattenförmiges Bauteil (1) nach einem der Ansprüche 1 bis 7, bei welchem die mindestens eine Farbfilterschicht (9, 9') aufweist:
- eine Doppelschicht aus einer hochbrechenden Brechungsschicht und einer niedrigbrechenden Brechungsschicht, oder
- eine Dreifachschicht, bei welcher eine hochbrechende Brechungsschicht zwischen zwei niedrigbrechenden Brechungsschichten angeordnet ist, oder eine niedrigbrechende Brechungsschicht zwischen zwei hochbrechenden Brechungsschichten angeordnet ist, oder
- eine Vierfachschicht , bei welcher zwei hochbrechende Brechungsschichten und zwei niedrigbrechende Brechungsschichten in alternierender Abfolge angeordnet sind, wobei eine hochbrechende Brechungsschicht zwischen zwei niedrigbrechenden Brechungsschichten angeordnet ist und eine niedrigbrechende Brechungsschicht zwischen zwei hochbrechenden Brechungsschichten angeordnet ist.

9. Plattenförmiges Bauteil (1) nach einem der Ansprüche 1 bis 8, bei welchem das Rückseitenelement (14) ein Trägersubstrat (16) mit Solarzellen (18) zur fotovoltaischen Energieerzeugung umfasst.

10. Plattenförmiges Bauteil (1) nach einem der Ansprüche 1 bis 8, bei welchem das Rückseitenelement ausgebildet ist als:
- eine Beschichtung, insbesondere opake Beschichtung, der Deckplatte (2),
- eine Folie, insbesondere opake Folie, die durch ein transparentes Klebemittel, insbesondere eine transparente Klebefolie, welche mit der Deckplatte (2) fest verbunden ist, oder
- ein starrer Körper, insbesondere opaker starrer Körper, der durch ein transparentes Klebemittel, insbesondere eine transparente Klebefolie, mit der Deckplatte (2) fest verbunden ist.

11. Plattenförmiges Bauteil (1) nach einem der Ansprüche 1 bis 10, bei welchem das Rückseitenelement (14) eine mechanisch unterstützende Scheibe (3) umfasst.

12. Plattenförmiges Bauteil (1) nach einem der Ansprüche 1 bis 11, bei welcher die Vorderfläche (4) der Deckplatte (2) mindestens einen strukturierten Bereich (8) aufweist, auf dem eine Farbfilterschicht (9) zur Reflexion von Licht innerhalb eines vorgegebenen Wellenlängenbereichs angeordnet ist.

13. Plattenförmiges Bauteil (1) nach Anspruch 12, bei welcher
i) die Rückfläche (5) der Deckplatte (2) keinen strukturierten Bereich und keine Farbfilterschicht aufweist, oder
ii) die Rückfläche (5) der Deckplatte (2) keinen strukturierten Bereich aufweist und auf der Rückfläche (5) der Deckplatte (2) eine weitere Farbfilterschicht (9') zur Reflexion von Licht innerhalb eines vorgegebenen Wellenlängenbereichs angeordnet ist, oder
iii) die Rückfläche (5) der Deckplatte (2) mindestens einen strukturierten Bereich aufweist (8'), auf dem eine Farbfilterschicht (9') zur Reflexion von Licht innerhalb eines vorgegebenen Wellenlängenbereichs angeordnet ist.

14. Plattenförmiges Bauteil (1) nach einem der Ansprüche 1 bis 11, bei welcher auf der Rückfläche (5) der Deckplatte (2) eine Farbfilterschicht (9) zur Reflexion von Licht innerhalb eines vorgegebenen Wellenlängenbereichs angeordnet ist, wobei die Rückfläche (5) und/oder die Vorderfläche (4) jeweils mindestens einen strukturierten Bereich (8, 8') aufweist, wobei entweder die Vorderfläche (4) mindestens einen strukturierten Bereich (8) aufweist oder auf der Vorderfläche (4) eine weitere Farbfilterschicht (9') zur Reflexion von Licht innerhalb eines vorgegebenen Wellenlängenbereichs angeordnet ist.

15. Plattenförmiges Bauteil (1) nach Anspruch 14, bei welcher
i) die Rückfläche (5) der Deckplatte (2) keinen strukturierten Bereich aufweist und die Vorderfläche (4) mindestens einen strukturierten Bereich (8) aufweist, wobei keine Farbfilterschicht auf der Vorderfläche (4) angeordnet ist, oder
ii) die Rückfläche (5) der Deckplatte (2) mindestens einen strukturierten Bereich (8) aufweist und die Vorderfläche (4) mindestens einen strukturierten Bereich (8') aufweist, wobei keine Farbfilterschicht auf der Vorderfläche (4) angeordnet ist, oder
iii) die Rückfläche (5) der Deckplatte (2) mindestens einen strukturierten Bereich (8) aufweist und die Vorderfläche (4) keinen strukturierten Bereich aufweist, wobei keine Farbfilterschicht auf der Vorderfläche (4) angeordnet ist, oder
iv) die Rückfläche (5) der Deckplatte (2) mindestens einen strukturierten Bereich (8) aufweist und die Vorderfläche (4) keinen strukturierten Bereich aufweist, wobei eine weitere Farbfilterschicht (9') auf der Vorderfläche (4) angeordnet ist.

## Claims

1. Plate-shaped component (1) with a colour effect, comprising a transparent cover plate (2) and at least one flat rear element (14) attached to the cover plate (2), wherein the cover plate (2) has a front surface (4) facing the outer environment and a rear surface (5) facing the rear element (3), wherein at least one surface (4, 5), selected from front and rear surfaces, has at least one structured region (8, 8'), and wherein on at least one surface (4, 5), selected from front and rear surfaces, at least one colour filter layer (9, 9') is arranged for reflecting light within a predefined wavelength range,
- **characterised in that**
the at least one structured region (8, 8') has the following features i) to iii):
i) a height profile having peaks and valleys perpendicular to the plane of the cover plate (2), wherein an average height difference between the peaks and valleys is at least 2 µm,
ii) at least 50% of the structured region is composed of segments inclined to the plane of the cover plate (2), wherein, in relation to the plane of the cover plate (2), at least 20% of the segments have an inclination angle in the range of greater than 0° to a maximum of 15° and at least 30% of the segments have an inclination angle in the range of greater than 15° to a maximum of 45°, wherein
iii) the segments are each flat and have a segment surface of at least 1 µm², wherein the segments each have an average roughness of less than 15% of a layer thickness of the at least one colour filter layer (9, 9'), and
- **in that** the at least one colour filter layer (9, 9') contains at least one highly-refractive refractive layer, wherein the at least one refractive layer has a refractive index of greater than 2.5 in the wavelength range from 400 nm to at least 700 nm and an extinction coefficient of at least 0.2 below 450 nm and less than 0.2, in particular less than 0.1, above 700 nm.

2. Plate-shaped component (1) according to claim 1, in which the at least one highly-refractive refractive layer has an extinction coefficient of less than 0.2, in particular less than 0.1, above 500 nm.

3. Plate-shaped component (1) according to claim 1 or 2, in which the at least one highly-refractive refractive layer has a refractive index of greater than 3.0, in particular greater than 3.5, in the wavelength range from 400 nm to at least 700 nm.

4. Plate-shaped component (1) according to any one of claims 1 to 3, in which the at least one highly-refractive refractive layer has a layer thickness in the range from 5 nm to 300 nm, in particular in the range from 5 nm to 40 nm.

5. Plate-shaped component (1) according to any one of claims 1 to 4, in which the at least one highly-refractive refractive layer has a refractive index of greater than 3.0, in particular greater than 3.5, in the wavelength range from 400 nm to at least 700 nm and a layer thickness in the range from 5 nm to 40 nm.

6. Plate-shaped component (1) according to any one of claims 1 to 5, in which the at least one colour filter layer (9, 9') has at least one low-refractive refractive layer consisting of a transparent dielectric material, wherein the at least one low-refractive refractive layer has a refractive index of less than 2.5.

7. Plate-shaped component (1) according to claim 6, in which the at least one low-refractive refractive layer has a layer thickness of greater than 10 nm and less than 250 nm.

8. Plate-shaped component (1) according to any one of claims 1 to 7, in which the at least one colour filter layer (9, 9') has:
- a double layer consisting of a highly-refractive refractive layer and a low-refractive refractive layer, or
- a triple layer in which a highly-refractive refractive layer is arranged between two low-refractive refractive layers, or a low-refractive refractive layer is arranged between two highly-refractive refractive layers, or
- a quadruple layer in which two highly-refractive refractive layers and two low-refractive refractive layers are arranged in alternating sequence, wherein a highly-refractive refractive layer is arranged between two low-refractive refractive layers and a low-refractive refractive layer is arranged between two highly-refractive refractive layers.

9. Plate-shaped component (1) according to any one of claims 1 to 8, in which the rear element (14) comprises a carrier substrate (16) with solar cells (18) for photovoltaic energy generation.

10. Plate-shaped component (1) according to any one of claims 1 to 8, in which the rear element is in the form of:
- a coating, in particular an opaque coating, of the cover plate (2),
- a film, in particular an opaque film, which is firmly connected to the cover plate (2) by a transparent adhesive, in particular a transparent adhesive film, or
- a rigid body, in particular an opaque rigid body, which is firmly connected to the cover plate (2) by a transparent adhesive, in particular a transparent adhesive film.

11. Plate-shaped component (1) according to any one of claims 1 to 10, in which the rear element (14) comprises a mechanically supporting disc (3).

12. Plate-shaped component (1) according to any one of claims 1 to 11, in which the front surface (4) of the cover plate (2) has at least one structured region (8) on which a colour filter layer (9) is arranged for reflecting light within a predefined wavelength range.

13. Plate-shaped component (1) according to claim 12, in which
i) the rear surface (5) of the cover plate (2) has no structured region and no colour filter layer, or
ii) the rear surface (5) of the cover plate (2) has no structured region and a further colour filter layer (9') for reflecting light within a predefined wavelength range is arranged on the rear surface (5) of the cover plate (2), or
iii) the rear surface (5) of the cover plate (2) has at least one structured region (8') on which a colour filter layer (9') is arranged for reflecting light within a predefined wavelength range.

14. Plate-shaped component (1) according to any one of claims 1 to 11, in which a colour filter layer (9) for reflecting light within a predefined wavelength range is arranged on the rear surface (5) of the cover plate (2), wherein the rear surface (5) and/or the front surface (4) each has at least one structured region (8, 8'), wherein either the front surface (4) has at least one structured region (8) or a further colour filter layer (9') for reflecting light within a predefined wavelength range is arranged on the front surface (4).

15. Plate-shaped component (1) according to claim 14, in which
i) the rear surface (5) of the cover plate (2) has no structured region and the front surface (4) has at least one structured region (8), wherein no colour filter layer is arranged on the front surface (4), or
ii) the rear surface (5) of the cover plate (2) has at least one structured region (8) and the front surface (4) has at least one structured region (8'), wherein no colour filter layer is arranged on the front surface (4), or
iii) the rear surface (5) of the cover plate (2) has at least one structured region (8) and the front surface (4) has no structured region, wherein no colour filter layer is arranged on the front surface (4), or
iv) the rear surface (5) of the cover plate (2) has at least one structured region (8) and the front surface (4) has no structured region, wherein a further colour filter layer (9') is arranged on the front surface (4).

## Revendications

1. Composant en forme de plaque (1) à effet de couleur comprenant une plaque de recouvrement (2) transparente et au moins un élément arrière plat (14) installé sur la plaque de recouvrement (2), dans lequel la plaque de recouvrement (2) présente une surface avant (4) tournée vers l'environnement extérieur et une surface arrière (5) tournée vers l'élément arrière (3), dans lequel au moins une surface (4, 5), choisi parmi la surface avant et la surface arrière, présente au moins une zone structurée (8, 8'), et dans lequel est disposée, sur au moins une surface (4, 5), choisie parmi la surface avant et la surface arrière, au moins une couche filtrante de couleur (9, 9') pour réfléchir de la lumière dans une plage de longueurs d'onde prédéfinie,
- **caractérisé en ce que**
l'au moins une zone structurée (8, 8') présente les caractéristiques i) à iii) suivantes :
i) perpendiculairement au plan de la plaque de couverture (2) un profil de hauteur présentant des crêtes et des creux, dans lequel une différence de hauteur moyenne entre les crêtes et les creux est d'au moins 2 µm,
ii) au moins 50 % de la zone structurée se compose de segments qui sont inclinés par rapport au plan de la plaque de recouvrement (2), dans lequel, par rapport au plan de la plaque de recouvrement (2), au moins 20 % des segments ont un angle d'inclinaison dans la plage allant de plus de 0° à 15° au maximum et au moins 30 % des segments ont un angle d'inclinaison dans la plage allant de plus de 15° à 45° au maximum, dans lequel
iii) les segments sont chacun plans et ont une surface de segment d'au moins 1 µm², dans lequel les segments ont chacun une rugosité moyenne inférieure à 15 % d'une épaisseur de couche de l'au moins une couche filtrante de couleur (9, 9'), et
- que l'au moins une couche de filtre couleur (9, 9') contient au moins une couche de réfraction à indice de réfraction élevé, dans lequel l'au moins une couche de réfraction a un indice de réfraction supérieur à 2,5 dans la plage de longueurs d'onde de 400 nm à au moins 700 nm et un coefficient d'extinction d'au moins 0,2 en dessous de 450 nm et inférieur à 0,2, en particulier inférieur à 0,1, au-dessus de 700 nm.

2. Composant en forme de plaque (1) selon la revendication 1, dans lequel l'au moins une couche de réfraction à indice de réfraction élevé a un coefficient d'extinction inférieur à 0,2, en particulier inférieur à 0,1, au-dessus de 500 nm.

3. Composant en forme de plaque (1) selon la revendication 1 ou 2, dans lequel l'au moins une couche de réfraction à indice de réfraction élevé présente un indice de réfraction supérieur à 3,0, en particulier supérieur à 3,5, dans la plage de longueurs d'onde de 400 nm à au moins 700 nm.

4. Composant en forme de plaque (1) selon l'une quelconque des revendications 1 à 3, dans lequel l'au moins une couche de réfraction à indice de réfraction élevé présente une épaisseur de couche dans la plage de 5 nm à 300 nm, en particulier dans la plage de 5 nm à 40 nm.

5. Composant en forme de plaque (1) selon l'une quelconque des revendications 1 à 4, dans lequel l'au moins une couche de réfraction à indice de réfraction élevé présente un indice de réfraction supérieur à 3,0, en particulier supérieur à 3,5, dans la plage de longueurs d'onde de 400 nm à au moins 700 nm et une épaisseur de couche dans la plage de 5 nm à 40 nm.

6. Composant en forme de plaque (1) selon l'une quelconque des revendications 1 à 5, dans lequel l'au moins une couche filtrante de couleur (9, 9') présente au moins une couche de réfraction à faible indice réfraction en un matériau diélectrique transparent, dans lequel l'au moins une couche de réfraction à faible indice de réfraction a un indice de réfraction inférieur à 2,5.

7. Composant en forme de plaque (1) selon la revendication 6, dans lequel l'au moins une couche de réfraction à faible indice de réfraction a une épaisseur de couche supérieure à 10 nm et inférieure à 250 nm.

8. Composant en forme de plaque (1) selon l'une quelconque des revendications 1 à 7, dans lequel l'au moins une couche filtrante de couleur (9, 9') présente :
- une double couche composée d'une couche de réfraction à indice de réfraction élevé et d'une couche de réfraction à faible indice de réfraction, ou
- une triple couche, dans laquelle une couche de réfraction à indice de réfraction élevé est disposée entre deux couches de réfraction à faible indice de réfraction, ou une couche de réfraction à faible indice de réfraction est disposée entre deux couches de réfraction à indice de réfraction élevé, ou
- une quadruple couche, dans laquelle deux couches de réfraction à indice de réfraction élevé et deux couches de réfraction à faible indice de réfraction sont disposées en alternance, dans lequel une couche de réfraction à indice de réfraction élevé est disposée entre deux couches de réfraction à faible indice de réfraction et une couche de réfraction à faible indice de réfraction est disposée entre deux couches de réfraction à indice de réfraction élevé.

9. Composant en forme de plaque (1) selon l'une quelconque des revendications 1 à 8, dans lequel l'élément arrière (14) comprend un substrat de support (16) avec des cellules solaires (18) pour la production d'énergie photovoltaïque.

10. Composant en forme de plaque (1) selon l'une quelconque des revendications 1 à 8, dans lequel l'élément arrière est réalisé comme :
- un revêtement, en particulier un revêtement opaque, de la plaque de recouvrement (2),
- un film, en particulier un film opaque, qui est relié de manière solidaire à la plaque de recouvrement (2) par un adhésif transparent, en particulier un film adhésif transparent, ou
- un corps rigide, en particulier un corps rigide opaque, qui est relié de manière solidaire à la plaque de recouvrement (2) par un adhésif transparent, en particulier un film adhésif transparent.

11. Composant en forme de plaque (1) selon l'une quelconque des revendications 1 à 10, dans lequel l'élément arrière (14) comprend une vitre (3) de support mécanique.

12. Composant en forme de plaque (1) selon l'une quelconque des revendications 1 à 11, dans lequel la surface avant (4) de la plaque de recouvrement (2) présente au moins une zone structurée (8) sur laquelle est disposée une couche filtrante de couleur (9) pour réfléchir la lumière à l'intérieur d'une plage de longueurs d'onde prédéfinie.

13. Composant en forme de plaque (1) selon la revendication 12, dans lequel
i) la surface arrière (5) de la plaque de recouvrement (2) ne présente aucune zone structurée et aucune couche filtrante de couleur, ou
ii) la surface arrière (5) de la plaque de recouvrement (2) ne présente aucune zone structurée et une autre couche filtrante de couleur (9') est disposée sur la surface arrière (5) de la plaque de recouvrement (2) pour réfléchir la lumière dans une plage de longueurs d'onde prédéfinie, ou
iii) la surface arrière (5) de la plaque de recouvrement (2) présente au moins une zone structurée (8') sur laquelle est disposée une couche filtrante de couleur (9') pour réfléchir la lumière dans une plage de longueurs d'onde prédéfinie.

14. Composant en forme de plaque (1) selon l'une quelconque des revendications 1 à 11, dans lequel une couche filtrante de couleur (9) est disposée sur la surface arrière (5) de la plaque de recouvrement (2) pour réfléchir la lumière dans une plage de longueurs d'onde prédéfinie, dans lequel la surface arrière (5) et/ou la surface avant (4) présentent respectivement au moins une zone structurée (8, 8'), dans lequel soit la surface avant (4) présente au moins une zone structurée (8), soit une autre couche filtrante de couleur (9') est disposée sur la surface avant (4) pour réfléchir la lumière dans une plage de longueurs d'onde prédéfinie.

15. Composant en forme de plaque (1) selon la revendication 14, dans lequel
i) la surface arrière (5) de la plaque de recouvrement (2) ne présente pas de zone structurée et la surface avant (4) présente au moins une zone structurée (8), dans lequel aucune couche filtrante de couleur n'est disposée sur la surface avant (4), ou
ii) la surface arrière (5) de la plaque de recouvrement (2) présente au moins une zone structurée (8) et la surface avant (4) présente au moins une zone structurée (8'), dans lequel aucune couche filtrante de couleur n'est disposée sur la surface avant (4), ou
iii) la surface arrière (5) de la plaque de recouvrement (2) présente au moins une zone structurée (8) et la surface avant (4) ne présente aucune zone structurée, dans lequel aucune couche filtrante de couleur n'est disposée sur la surface avant (4), ou
iv) la surface arrière (5) de la plaque de recouvrement (2) présente au moins une zone structurée (8) et la surface avant (4) ne présente aucune zone structurée, dans lequel une autre couche filtrante de couleur (9') est disposée sur la surface avant (4).
